# EUROPEAN PATENT APPLICATION

(11) **EP 4 391 770 A1**
(43) Date of publication of application: **26.06.2024**
(21) Application number: 23195873.7
(22) Date of filing: 07.09.2023
(51) Int. Cl.: H10K 59/122, H10K 59/131, H10K 59/12

(54) **DISPLAY DEVICE AND METHOD FOR MANUFACTURING THE SAME**

(30) Priority: 21.12.2022 KR 20220180274
(71) Applicant: Samsung Display Co., Ltd., Yongin-si, Gyeonggi-do 17113 (KR)
(72) Inventor: KIM, Jeehoon, 17113 Yongin-si, Gyeonggi-do (KR); KANG, Donghan, 17113 Yongin-si, Gyeonggi-do (KR); MOON, Sunggwon, 17113 Yongin-si, Gyeonggi-do (KR); SON, Seungsok, 17113 Yongin-si, Gyeonggi-do (KR); YANG, Shinhyuk, 17113 Yongin-si, Gyeonggi-do (KR)
(74) Representative: Gulde & Partner

(57) **Abstract**

A display device includes: an auxiliary power line in a display area on a substrate; a protective layer on the substrate, and having an opening exposing at least a part of an upper surface of the auxiliary power line; a via insulating layer in the display area on the protective layer, the via insulating layer having a via contact hole connected to the opening, and an end part of the via insulating layer including a protrusion protruding toward a center of the via contact hole; and a common electrode on the via insulating layer, and electrically connected to the auxiliary power line.

## Description

### BACKGROUND

### 1. Field

Aspects of embodiments of the present disclosure relate to a display device. More particularly, aspects of embodiments of the present disclosure relate to a display device that provides visual information, and a method for manufacturing the display device.

### 2. Description of the related art

With the development of information technology, the importance of a display device, which is a connection medium between a user and information, has been highlighted. For example, the use of a display device, such as a liquid crystal display device ("LCD"), an organic light emitting display device ("OLED"), a plasma display device ("PDP"), a quantum dot display device, and the like, is increasing.

The display device includes a plurality of light emitting elements, and the plurality of light emitting elements include a common electrode as a plate electrode. As the size of the display device increases, the quality of the display device may deteriorate due to a drop in voltage provided to the common electrode. Accordingly, a structure for preventing a drop in voltage provided to the common electrode may be desired.

The above information disclosed in this Background section is for enhancement of understanding of the background of the present disclosure, and therefore, it may contain information that does not constitute prior art.

### SUMMARY

One or more embodiments of the present disclosure are directed to a display device having improved display quality.

One or more embodiments of the present disclosure are directed to a method for manufacturing the display device.

According to one or more embodiments of the present disclosure, a display device includes: an auxiliary power line in a display area on a substrate; a protective layer on the substrate, and having an opening exposing at least a part of an upper surface of the auxiliary power line; a via insulating layer in the display area on the protective layer, the via insulating layer having a via contact hole connected to the opening, and an end part of the via insulating layer including a protrusion protruding toward a center of the via contact hole; and a common electrode on the via insulating layer, and electrically connected to the auxiliary power line.

In an embodiment, the protrusion of the via insulating layer may define an undercut shape together with a first side surface of the opening of the protective layer.

In an embodiment, the display device may further include: a pixel defining layer on the via insulating layer, the pixel defining layer extending into the opening of the protective layer, and covering a second side surface of the opening facing the first side surface.

In an embodiment, the protective layer may include an inorganic material, and the via insulating layer may include an organic material.

In an embodiment, the common electrode may be disconnected by the protrusion.

In an embodiment, the protective layer may include: a bank part covering an edge of the auxiliary power line, and having a second thickness; and a flat part except for the bank part of the protective layer, and having a first thickness less than the second thickness.

In an embodiment, the display device may further include: a light emitting layer on the via insulating layer and the auxiliary power line, and the light emitting layer may be disconnected by the protrusion.

In an embodiment, the common electrode may cover a side surface of the light emitting layer.

In an embodiment, the common electrode may directly contact a part of the upper surface of the auxiliary power line.

In an embodiment, the display device may further include: an organic layer filling an empty space between the auxiliary power line and the protrusion.

In an embodiment, a lower surface of the protrusion that does not contact the protective layer may have a curved shape.

In an embodiment, the display device may further include: a lower metal layer in the display area on the substrate; an active pattern on the lower metal layer; a gate electrode on the active pattern; a first electrode connected to the active pattern; a second electrode in the same layer as that of the first electrode, and connected to the active pattern and the lower metal layer; and a pixel electrode connected to the second electrode.

In an embodiment, the auxiliary power line may include the same material as that of the first electrode and the second electrode.

In an embodiment, the display device may further include: an interlayer insulating layer between the substrate and the protective layer, the interlayer insulating layer covering an edge of the auxiliary power line, and having an opening exposing at least a part of the upper surface of the auxiliary power line.

In an embodiment, the opening of the interlayer insulating layer and the opening of the protective layer may be connected to each other, and the protrusion of the via insulating layer may define an undercut shape together with a first side surface of the opening of the interlayer insulating layer and a first side surface of the opening of the protective layer.

In an embodiment, the auxiliary power line may include the same material as that of the gate electrode.

In an embodiment, the protrusion of the via insulating layer may define an undercut shape together with a first side surface of the opening of the interlayer insulating layer and a first side surface of the opening of the protective layer.

In an embodiment, the display device may further include: a cover pattern on the auxiliary power line, the cover pattern being disconnected by the protrusion of the protective layer, and including the same material as that of the pixel electrode.

In an embodiment, the common electrode may be electrically connected to the auxiliary power line through the cover pattern.

According to one or more embodiments of the present disclosure, a display device includes: an auxiliary power line in a display area on a substrate; a first protective layer on the substrate, and having an opening exposing at least a part of an upper surface of the auxiliary power line; a second protective layer on the first protective layer, the second protective layer having a contact hole connected to the opening, and an end part of the second protective layer including a protrusion protruding toward a center of the contact hole; a via insulating layer in the display area on the second protective layer; and a common electrode on the via insulating layer, and electrically connected to the auxiliary power line.

In an embodiment, the protrusion of the second protective layer may define an undercut shape together with a first side surface of the opening of the first protective layer.

In an embodiment, the display device may further include: a pixel defining layer on the via insulating layer, the pixel defining layer extending into the opening of the first protective layer, and covering a second side surface of the opening facing the first side surface.

In an embodiment, the second side surface of the opening may have a step.

In an embodiment, the first and second protective layers may include an inorganic material, and the via insulating layer may include an organic material.

In an embodiment, the common electrode may be disconnected by the protrusion, and may directly contact a part of the upper surface of the auxiliary power line.

In an embodiment, the display device may further include: an organic layer filling an empty space between the auxiliary power line and the protrusion of the second protective layer.

In an embodiment, a lower surface of the protrusion that does not contact the first protective layer may have a curved shape.

In an embodiment, the display device may further include: a transistor in the display area on the substrate; a pixel electrode electrically connected to the transistor; and a cover pattern on the auxiliary power line, the cover pattern being disconnected by the protrusion of the second protective layer, and including the same material as that of the pixel electrode.

In an embodiment, the common electrode may be electrically connected to the auxiliary power line through the cover pattern.

According to one or more embodiments of the present disclosure, a method for manufacturing a display device, includes: forming an auxiliary power line in a display area on a substrate; forming a protective layer having an opening exposing at least a part of an upper surface of the auxiliary power line on the substrate; forming a sacrificial layer filing the opening; forming a via insulating layer having a via contact hole exposing at least a part of an upper surface of the sacrificial layer in the display area on the protective layer and the sacrificial layer, the via contact hole of the via insulating layer being connected to the opening; removing the sacrificial layer to form a protrusion from a part of the via insulating layer that protrudes toward a center of the via contact hole; and forming a common electrode electrically connected to the auxiliary power line on the via insulating layer.

In an embodiment, the forming of the protective layer may include: forming a preliminary protective layer on the substrate; forming a photosensitive organic layer on the preliminary protective layer by exposing and developing a photoresist through a halftone mask; and forming the opening of the protective layer by removing a part of the preliminary protective layer that does not overlap with the photosensitive organic layer through a dry etching process.

In an embodiment, the protective layer may be formed using an inorganic material, and the via insulating layer may be formed using an organic material.

In an embodiment, the sacrificial layer may be formed using an organic material.

In an embodiment, in the removing of the sacrificial layer, the sacrificial layer may be removed through an ashing process, and an ashing rate of the sacrificial layer relative to a plasma gas used in the ashing process may be greater than an ashing rate of the via insulating layer.

In an embodiment, the upper surface of the sacrificial layer may have a curved shape.

In an embodiment, the method may further include: forming a light emitting layer on the auxiliary power line to be disconnected by the protrusion before the forming of the common electrode, and a first angle at which the light emitting layer is deposited may be greater than a second angle at which the common electrode is deposited.

In an embodiment, the method may further include: forming a transistor in the display area on the substrate before the forming of the protective layer; forming a pixel electrode electrically connected to the transistor after the forming of the via insulating layer; and forming a cover pattern on the auxiliary power line to be disconnected by the protrusion. The cover pattern may be formed through the same process as that of the pixel electrode.

According to one or more embodiments of the present disclosure, a display device may include an auxiliary power line disposed in a display area on a substrate, an inorganic layer (e.g., a protective layer) disposed on the substrate and defining an opening exposing at least a part of an upper surface of the auxiliary power line, an insulating layer disposed in the display area on the inorganic layer, the insulating layer defining a contact hole connected to the opening, and an end part of the insulating layer including a protrusion protruding toward a center of the contact hole, and a common electrode disposed on the insulating layer and electrically connected to the auxiliary power line. The insulating layer may include an inorganic material or an organic material. The protrusion of the insulating layer may define an undercut shape with one side of the opening. The common electrode may be disconnected by the undercut shape, and electrically connected to the auxiliary power line. Accordingly, a voltage drop of the common voltage provided to the common electrode may be prevented or substantially prevented.

However, the present disclosure is not limited to the aspects and features described above. Additional aspects and features will be set forth, in part, in the detailed description that follows with reference to the drawings, and in part, may be apparent from the detailed description with reference to the drawings, or may be learned by practicing one or more of the presented embodiments of the present disclosure.

### BRIEF DESCRIPTION OF THE DRAWINGS

The above and other aspects and features of the present disclosure will be more clearly understood from the following detailed description of the illustrative, non-limiting embodiments with reference to the accompanying drawings.
FIG. 1 is a plan view illustrating a display device according to an embodiment of the present disclosure.
FIG. 2 is a block diagram schematically illustrating the display device of FIG. 1.
FIG. 3 is a circuit diagram illustrating a pixel included in the display device of FIG. 1.
FIG. 4 is a cross-sectional view taken along the line I-I' of FIG. 1.
FIG. 5 is an enlarged cross-sectional view of the area A of FIG. 4.
FIGS. 6-21 are cross-sectional views illustrating an example of a method for manufacturing the display device of FIG. 4.
FIGS. 22-24 are cross-sectional views illustrating another example of a method for manufacturing the display device of FIG. 4.
FIG. 25 is a cross-sectional view illustrating a display device according to another embodiment of the present disclosure.
FIG. 26 is an enlarged cross-sectional view of the area A' of FIG. 25.
FIGS. 27-31 are cross-sectional views illustrating a method for manufacturing the display device of FIG. 25.
FIG. 32 is a cross-sectional view illustrating a display device according to another embodiment of the present disclosure.
FIG. 33 is an enlarged cross-sectional view of the area A" of FIG. 32.
FIGS. 34-47 are cross-sectional views illustrating a method for manufacturing the display device of FIG. 32.
FIG. 48 is a cross-sectional view illustrating a display device according to another embodiment of the present disclosure.
FIG. 49 is an enlarged cross-sectional view of the area A‴ of FIG. 48.
FIGS. 50-52 are cross-sectional views illustrating a method for manufacturing the display device of FIG. 49.
FIG. 53 is a cross-sectional view illustrating a display device according to another embodiment of the present disclosure.
FIG. 54 is an enlarged cross-sectional view of the area Aʺʺ of FIG. 53.
FIGS. 55-65 are cross-sectional views illustrating a method for manufacturing the display device of FIG. 53.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

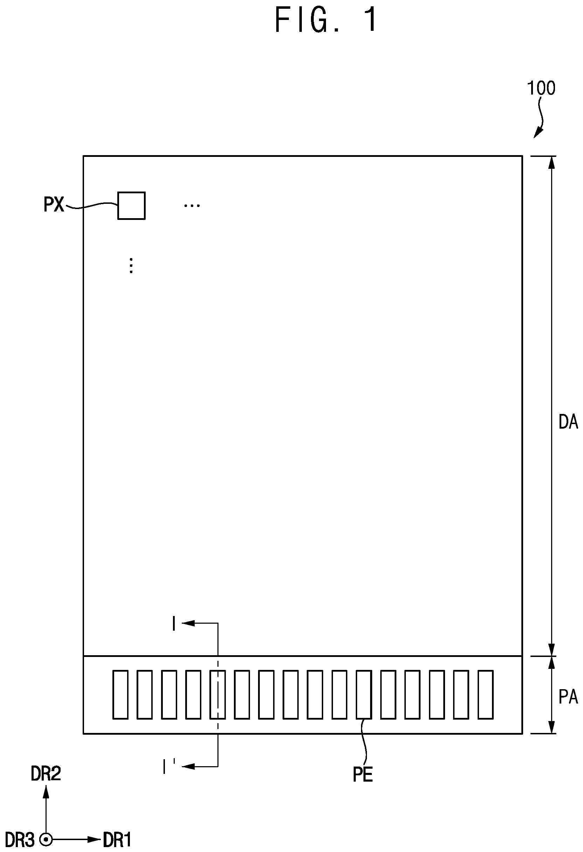

FIG. 1 is a plan view illustrating a display device according to an embodiment of the present disclosure.

Referring to FIG. 1, a display device 100 according to an embodiment may include a display area DA and a pad area PA. The display area DA may be an area capable of displaying an image by generating light or adjusting a transmittance of light provided from an external light source.

A plurality of pixels PX may be disposed in the display area DA. For example, the plurality of pixels PX may be arranged in a matrix form along a first direction DR1 and a second direction DR2 crossing the first direction DR1.

Each of the plurality of pixels PX may include a light emitting element that generates light, and a transistor that drives the light emitting element. For example, the light emitting element may include an organic light emitting diode. As another example, the light emitting element may include a nano light emitting diode. The transistor may include a thin film transistor (TFT). An image may be displayed on the display area DA of the display device 100 through the plurality of pixels PX including the light emitting elements and the transistors.

The pad area PA may be positioned at (e.g., in or on) at least one side of the display area DA. For example, the pad area PA may be positioned under (e.g., below) the display area DA. A plurality of pad electrodes PE may be disposed in the pad area PA. The plurality of pad electrodes PE may be spaced apart from each other along the first direction DR1. The plurality of pad electrodes PE may be electrically connected to an external device. In other words, the plurality of pad electrodes PE may electrically connect the external device and the plurality of pixels PX to each other. For example, each of the plurality of pad electrodes PE may include a metal, an alloy, a metal nitride, a conductive metal oxide, a transparent conductive material, and/or the like. These materials may be used alone or in any suitable combination with each other.

The external device may be electrically connected to the display device 100 through a circuit board. For example, the circuit board may include a printed circuit board (PCB) or a flexible printed circuit board (FPCB). One side of the circuit board may directly contact the plurality of pad electrodes PE, and another side of the circuit board may directly contact the external device.

The external device may provide a data signal, a gate signal, an emission control signal, an initialization voltage, a power supply voltage, and/or the like to the display device 100. In addition, a driving integrated circuit (IC) may be mounted on the circuit board. As another example, the driving integrated circuit may be mounted on a substrate of the display device 100.

FIG. 1 illustrates that a width of the pad area PA in the first direction DR1 is the same as a width of the display area DA in the first direction DR1, but the present disclosure is not limited thereto. For example, the width of the pad area PA in the first direction DR1 may be smaller than the width of the display area DA in the first direction DR1.

The display device 100 may have a rectangular planar shape. However, the present disclosure is not limited thereto, and the display device 100 may have various suitable planar shapes (e.g., a rectangular planar shape with rounded corners).

As used in this specification, a plane may be defined along the first direction DR1 and the second direction DR2 crossing the first direction DR1. For example, the first direction DR1 may be perpendicular to or substantially perpendicular to the second direction DR2. In addition, a third direction DR3 (e.g., a thickness direction) may be perpendicular to or substantially perpendicular to the plane.

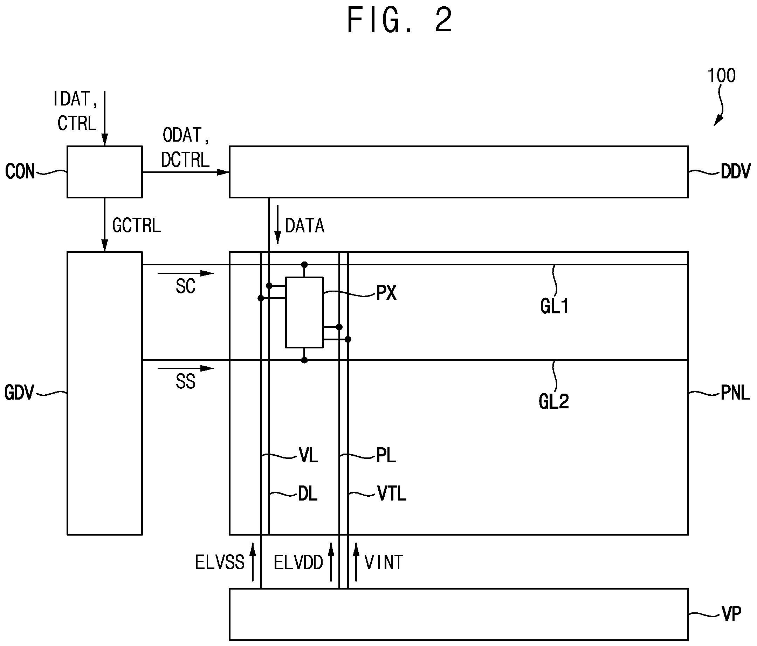

FIG. 2 is a block diagram schematically illustrating the display device of FIG. 1.

Referring to FIG. 2, the display device 100 according to an embodiment of the present disclosure includes a display panel PNL, a data driver DDV, a gate driver GDV, a controller CON, and a voltage supplier (e.g., a voltage supply) VP.

The display panel PNL may include the plurality of pixels PX.

The pixel PX may receive a first gate signal SC through a first gate line GL1, and may receive a second gate signal SS through a second gate line GL2. In addition, the pixel PX may receive a data voltage DATA through a data line DL, and may receive an initialization voltage VINT through an initialization voltage line VTL. The data voltage DATA may be written to the pixel PX in response to the first gate signal SC, and the initialization voltage VINT may be written to the pixel PX in response to the second gate signal SS.

The data driver DDV may generate the data voltage DATA based on output image data ODAT and a data control signal DCTRL. For example, the data driver DDV may generate the data voltage DATA corresponding to the output image data ODAT, and may output the data voltage DATA in response to the data control signal DCTRL. For example, the data control signal DCTRL may include an output data enable signal, a horizontal start signal, a load signal, and the like.

The gate driver GDV may generate the first and second gate signals SC and SS based on a gate control signal GCTRL. For example, each of the first and second gate signals SC and SS may include a gate-on voltage for turning on the transistor, and a gate-off voltage for turning off the transistor. For example, the gate control signal GCTRL may include a vertical start signal, a clock signal, and the like.

The controller CON may receive the input image data IDAT and a control signal CTRL from an external host processor (e.g., a graphics processing unit (GPU)). For example, the input image data IDAT may be RGB data including red image data, green image data, and blue image data. The control signal CTRL may include a vertical synchronization signal, a horizontal synchronization signal, an input data enable signal, a master clock signal, and the like. The controller CON may generate the gate control signal GCTRL, the data control signal DCTRL, and the output image data ODAT, based on the input image data IDAT and the control signal CTRL.

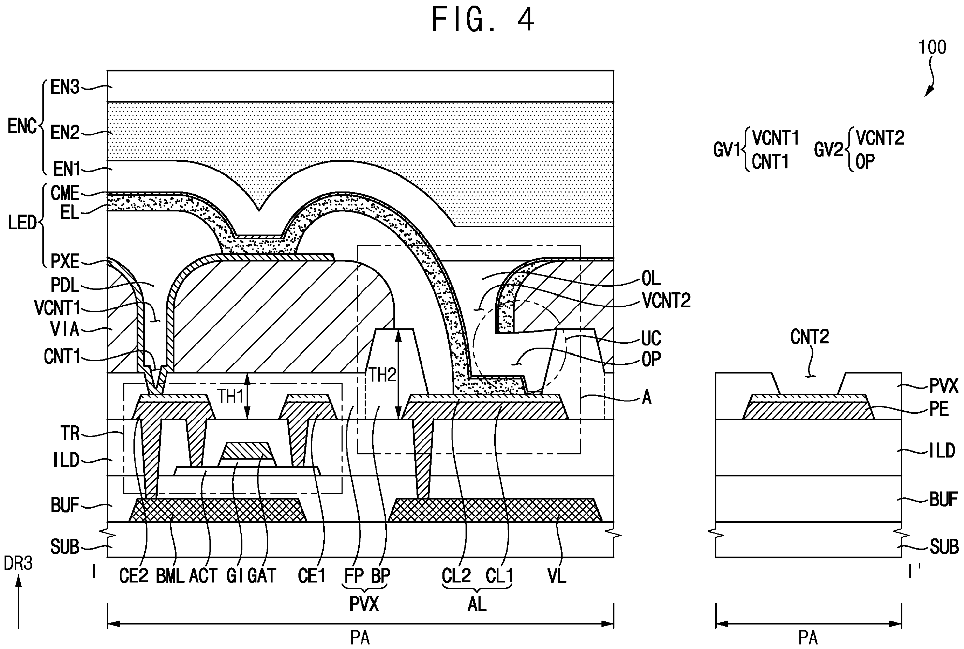

The voltage supplier VP may provide a driving voltage ELVDD, a common voltage ELVSS, and an initialization voltage VINT to the pixel PX. The driving voltage ELVDD may be provided to the pixel PX through a driving line PL. The common voltage ELVSS may be provided to the pixel PX through a power line VL and a common electrode (e.g., a common electrode CME of FIG. 4). In other words, the power line VL may transmit the common voltage ELVSS to the common electrode.

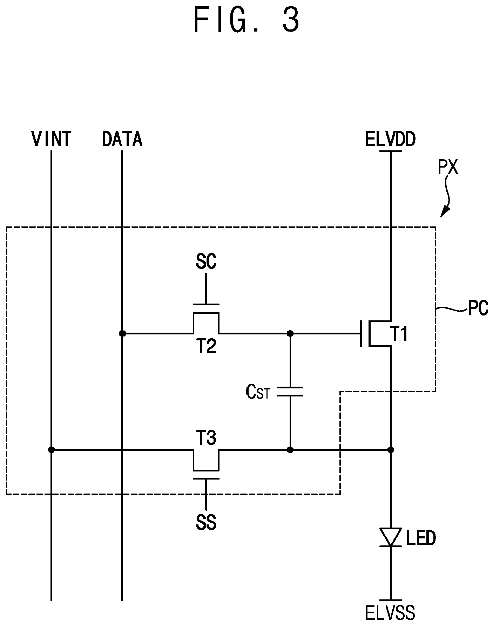

FIG. 3 is a circuit diagram illustrating a pixel included in the display device of FIG. 1.

Referring to FIG. 3, the pixel PX may include a pixel circuit PC and a light emitting element LED. The pixel circuit PC may include a first transistor T1, a second transistor T2, a third transistor T3, and a storage capacitor CST. The pixel circuit PC may be electrically connected to the light emitting element LED.

The first transistor T1 may include a first terminal, a second terminal, and a gate terminal. The first terminal of the first transistor T1 may receive the driving voltage ELVDD. The second terminal of the first transistor T1 may be connected to the light emitting element LED. The gate terminal of the first transistor T1 may be connected to the second transistor T2. The first transistor T1 may generate a driving current based on the driving voltage ELVDD and the data voltage DATA.

The second transistor T2 may include a first terminal, a second terminal, and a gate terminal. The first terminal of the second transistor T2 may receive the data voltage DATA. The second terminal of the second transistor T2 may be connected to the first transistor T1. The gate terminal of the second transistor T2 may receive the first gate signal SC. The second transistor T2 may transmit the data voltage DATA in response to the first gate signal SC.

The third transistor T3 may include a first terminal, a second terminal, and a gate terminal. The first terminal of the third transistor T3 may be connected to the first transistor T1. The second terminal of the third transistor T3 may receive the initialization voltage VINT. The gate terminal of the third transistor T3 may receive the second gate signal SS. The third transistor T3 may transmit the initialization voltage VINT in response to the second gate signal SS.

The storage capacitor CST may include a first terminal and a second terminal. The first terminal of the storage capacitor CST may be connected to the gate terminal of the first transistor T1. The second terminal of the storage capacitor CST may be connected to the first terminal of the third transistor T3. The storage capacitor CST may maintain or substantially maintain a voltage level of the gate terminal of the first transistor T1 during an inactive period of the first gate signal SC.

The light emitting element LED may include a first terminal and a second terminal. The first terminal of the light emitting element LED may be connected to the second terminal of the first transistor T1. The second terminal of the light emitting element LED may receive the common voltage ELVSS. The light emitting element LED may emit light having a luminance corresponding to the driving current. The light emitting element LED may include an organic light emitting element using an organic material as a light emitting layer, an inorganic light emitting element using an inorganic material as a light emitting layer, or the like.

While FIG. 3 illustrates an embodiment in which the pixel circuit PC includes three transistors and one storage capacitor, the present disclosure is not limited thereto. For example, the pixel circuit PC may include various suitable numbers of transistors and various suitable numbers of storage capacitors.

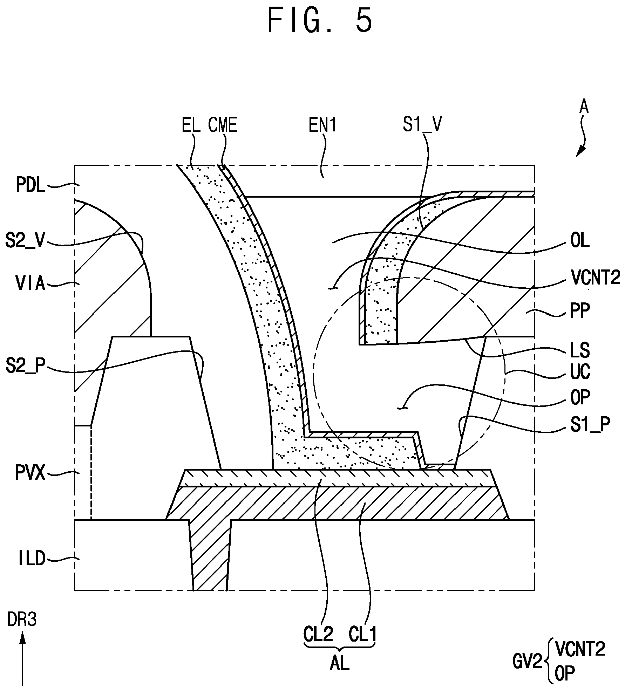

FIG. 4 is a cross-sectional view taken along the line I-I' of FIG. 1. FIG. 5 is an enlarged cross-sectional view of the area A of FIG. 4.

Referring to FIGS. 4 and 5, the display device 100 according to an embodiment may include a substrate SUB, a lower metal layer BML, the power line VL, a buffer layer BUF, a gate insulating layer GI, an interlayer insulating layer ILD, a transistor TR, the pad electrode PE, an auxiliary power line AL, a protective layer PVX, a via insulating layer VIA, the light emitting element LED, a pixel defining film PDL, an organic layer OL, and an encapsulation layer ENC.

The transistor TR may include an active pattern ACT, a gate electrode GAT, a first electrode CE1, and a second electrode CE2. The light emitting element LED may include a pixel electrode PXE, a light emitting layer EL, and a common electrode CME. The encapsulation layer ENC may include a first inorganic encapsulation layer EN1, an organic encapsulation layer EN2, and a second inorganic encapsulation layer EN3.

The substrate SUB may include a transparent material or an opaque material. The substrate SUB may be (e.g., may include or may be made of) a transparent resin substrate. Examples of the transparent resin substrate include a polyimide substrate and the like. In this case, the substrate SUB may include a first organic layer, a first barrier layer, and a second organic layer. As another example, the substrate SUB may include (e.g., may be) a quartz substrate, a synthetic quartz substrate, a calcium fluoride substrate, an F-doped quartz substrate, a soda-lime glass substrate, a non-alkali glass substrate, and/or the like. The substrate SUB may include one or a suitable combination of two or more of the above substrates.

The lower metal layer BML of the display area DA may be disposed on the substrate SUB. The lower metal layer BML may block external light incident on the transistor TR. For example, the lower metal layer BML may include a metal, an alloy, a metal nitride, a conductive metal oxide, a transparent conductive material, and/or the like. These materials may be used alone or in a suitable combination with each other.

The power line VL may be disposed in the display area DA on the substrate SUB. The power line VL may include the same material as that of the lower metal layer BML, and may be disposed in the same layer as that of the lower metal layer BML. A common voltage (e.g., the common voltage ELVSS of FIGS. 2 and 3) may be applied to the power line VL.

The buffer layer BUF may be disposed on the substrate SUB. The buffer layer BUF may cover the lower metal layer BML and the power line VL. The buffer layer BUF may prevent or substantially prevent diffusion of metal atoms and/or impurities from the substrate SUB into the transistor TR. In addition, the buffer layer BUF may improve a flatness of the surface of the substrate SUB when the surface of the substrate SUB is not uniform. For example, the buffer layer BUF may include an inorganic insulating material, such as silicon oxide (SiOₓ), silicon nitride (SiNₓ), silicon oxynitride (SiOₓN_{y}), and/or the like. These materials may be used alone or in any suitable combination with each other. In another embodiment, the buffer layer BUF may be omitted as needed or desired.

The active pattern ACT may be disposed in the display area DA on the buffer layer BUF. For example, the active pattern ACT may include an inorganic semiconductor (e.g., amorphous silicon, polycrystalline silicon, and/or the like), an organic semiconductor, or a metal oxide semiconductor.

The metal oxide semiconductor may include a two-component compound (ABₓ), a ternary compound (ABₓC_{y}), a four-component compound (ABₓC_{y}D_{z}), and/or the like, which may include (e.g., may contain) indium (In), zinc (Zn), gallium (Ga), tin (Sn), titanium (Ti), aluminum (Al), hafnium (Hf), zirconium (Zr), magnesium (Mg), and/or the like. For example, the metal oxide semiconductor may include zinc oxide (ZnOₓ), gallium oxide (GaOₓ), tin oxide (SnOₓ), indium oxide (InOₓ), indium gallium oxide (IGO), indium zinc oxide (IZO), indium tin oxide. (ITO), indium zinc tin oxide (IZTO), indium gallium zinc oxide (IGZO), and/or the like. These materials may be used alone or in any suitable combination with each other.

The gate insulating layer GI may be disposed on the active pattern ACT. The gate insulating layer GI may include an inorganic material. For example, the gate insulating layer GI may include an inorganic material, such as silicon oxide, silicon nitride, silicon oxynitride, and/or the like. These inorganic materials may be used alone or in any suitable combination with each other. In an embodiment, the gate insulating layer GI may be patterned to overlap with a part (e.g., only a part) of the active pattern ACT, without entirely covering the active pattern ACT. In another embodiment, the gate insulating layer GI may be entirely disposed on the buffer layer BUF to cover the active pattern ACT.

The gate electrode GAT may be disposed on the gate insulating layer GI. The gate electrode GAT may overlap with the gate insulating layer GI. For example, the gate electrode GAT may include a metal, an alloy, a metal nitride, a conductive metal oxide, a transparent conductive material, and/or the like. These materials may be used alone or in any suitable combination with each other.

The interlayer insulating layer ILD may be disposed on the buffer layer BUF, the gate insulating layer GI, and the gate electrode GAT. The interlayer insulating layer ILD may sufficiently cover the gate electrode GAT. The interlayer insulating layer ILD may be entirely disposed on the display area DA and the pad area PA. The interlayer insulating layer ILD may include an inorganic material. For example, the interlayer insulating layer ILD may include an inorganic material, such as silicon oxide, silicon nitride, silicon oxynitride, and/or the like. These inorganic materials may be used alone or in any suitable combination with each other. The interlayer insulating layer ILD may have a single-layer structure or a multi-layered structure including a plurality of insulating layers.

The first electrode CE1 and the second electrode CE2 may be disposed in the display area DA on the interlayer insulating layer ILD. Each of the first and second electrodes CE1 and CE2 may be connected to the active pattern ACT through a contact hole penetrating the interlayer insulating layer ILD. In addition, the second electrode CE2 may be connected to the lower metal layer BML through a contact hole penetrating the interlayer insulating layer ILD and the buffer layer BUF. For example, each of the first and second electrodes CE1 and CE2 may include a metal, an alloy, a metal nitride, a conductive metal oxide, a transparent conductive material, and/or the like. These materials may be used alone or in any suitable combination with each other. In an embodiment, each of the first and second electrodes CE1 and CE2 may include a plurality of conductive layers. For example, each of the first and second electrodes CE1 and CE2 may include a first conductive layer including copper (Cu), and a second conductive layer including indium tin oxide (ITO).

As such, the transistor TR including the active pattern ACT, the gate electrode GAT, the first electrode CE1, and the second electrode CE2 may be disposed in the display area DA on the substrate SUB. For example, the transistor TR may correspond to the first transistor T1 illustrated in FIG. 3.

The auxiliary power line AL may be disposed in the display area DA on the interlayer insulating layer ILD. The auxiliary power line AL may be connected to the power line VL through a contact hole penetrating the interlayer insulating layer ILD and the buffer layer BUF. The common voltage (e.g., the common voltage ELVSS of FIGS. 2 and 3) may be applied to the auxiliary power line AL through the power line VL. The auxiliary power line AL may include the same material as that of the first and second electrodes CE1 and CE2, and may be disposed in the same layer as that of the first and second electrodes CE1 and CE2.

In an embodiment, the auxiliary power line AL may have a two-layered structure including a first conductive layer CL1 and a second conductive layer CL2 disposed on the first conductive layer CL1. However, the present disclosure is not limited thereto, and the auxiliary power line AL may have a multilayered structure including three conductive layers.

The first and second conductive layers CL1 and CL2 may include different materials from each other. For example, the first conductive layer CL1 may include a metal, and the second conductive layer CL2 may include a metal or a transparent conductive material. The first conductive layer CL1 may include a metal, such as copper (Cu), aluminum (Al), and/or the like.

In an embodiment, the first conductive layer CL1 may include copper (Cu). The second conductive layer CL2 may include a metal, such as titanium (Ti), molybdenum (Mo), and/or the like. The second conductive layer CL2 may include a transparent conductive material, such as indium tin oxide (ITO), indium zinc oxide (IZO), zinc oxide (ZnO), indium oxide (In2O3), indium gallium oxide (IGO), aluminum zinc oxide (AZO), and/or the like. In an embodiment, the second conductive layer CL2 may include indium tin oxide (ITO).

The pad electrode PE may be disposed in the pad area PA on the interlayer insulating layer ILD. The pad electrode PE may include the same material as that of the first electrode CE1, the second electrode CE2, and the auxiliary power line AL, and may be disposed in the same layer as that of the first electrode CE1, the second electrode CE2, and the auxiliary power line AL.

The protective layer PVX may be disposed on the interlayer insulating layer ILD. The protective layer PVX may be entirely disposed on the display area DA and the pad area PA. The protective layer PVX may prevent or substantially prevent the first and second electrodes CE1 and CE2 from being damaged by impurities and the like from the outside. The protective layer PVX may include an inorganic material. For example, the protective layer PVX may include an inorganic material, such as silicon oxide, silicon nitride, silicon oxynitride, and/or the like. These inorganic materials may be used alone or in any suitable combination with each other. The protective layer PVX may have a single-layer structure or a multi-layered structure including a plurality of insulating layers.

In an embodiment, in the display area DA, a first contact hole CNT1 exposing at least a part of an upper surface of the second electrode CE2, and an opening OP exposing at least a part of an upper surface of the auxiliary power line AL may be defined in the protective layer PVX. In more detail, the opening OP may expose at least a part of the upper surface of the second conductive layer CL2 of the auxiliary power line AL. In addition, in the pad area PA, a second contact hole CNT2 exposing at least a part of an upper surface of the pad electrode PE may be defined in the protective layer PVX. The external device may be electrically connected to the pad electrode PE through the second contact hole CNT2.

In an embodiment, the protective layer PVX may include a flat part FP and a bank part BP. The bank part BP may cover an edge of the auxiliary power line AL, and the flat part FP may be a remaining part of the protective layer PVX other than (e.g., except for) the bank part BP.

A first thickness TH1 of the flat part FP may be different from a second thickness TH2 of the bank part BP. In an embodiment, the second thickness TH2 of the bank part BP may be thicker than the first thickness TH1 of the flat part FP. In other words, the bank part BP may protrude more in a thickness direction (e.g., in the third direction DR3) than the flat part FP (e.g., the minimum distance from the upper surface of the interlayer insulating layer ILD to the upper surface of the flat part FP may be less than the minimum distance from the upper surface of the interlayer insulating layer ILD to the upper surface of the bank part BP). The first thickness TH1 may be defined as the height from a lower surface of the flat part FP to the upper surface of the flat part FP, and the second thickness TH2 may be defined as the height from a lower surface of the bank part BP to the upper surface of the bank part BP.

The opening OP of the protective layer PVX may have a first side surface S1_P and a second side surface S2_P. The first side surface S1_P and the second side surface S2_P may face each other. Each of the first side surface S1_P and the second side surface S2_P may extend from the upper surface of the auxiliary power line AL in the third direction DR3 at a suitable inclination angle (e.g., a predetermined inclination angle).

The via insulating layer VIA may be disposed in the display area DA on the protective layer PVX. The via insulating layer VIA may include an organic material. For example, the via insulating layer VIA may include an organic material, such as a polyimide resin, a polyamide resin, a siloxane resin, an epoxy resin, and/or the like. These organic materials may be used alone or in any suitable combination with each other.

In an embodiment, in the display area DA, a first via contact hole VCNT1 connected to the first contact hole CNT1, and a second via contact hole VCNT2 connected to the opening OP may be defined in the via insulating layer VIA. As such, the first contact hole CNT1 and the first via contact hole VCNT1 may constitute a first groove GV1, and the opening OP and the second via contact hole VCNT2 may constitute a the second groove GV2. The first groove GV1 may expose at least a part of the upper surface of the second electrode CE2. The second groove GV2 may expose at least a part of the upper surface of the auxiliary power line AL.

The second via contact hole VCNT2 of the via insulating layer VIA may have a first side surface S1_V and a second side surface S2_V. The first side surface S1_V and the second side surface S2_V may face each other. In an embodiment, the first side surface S1_V of the second via contact hole VCNT2 may protrude more toward a center of the second groove GV2 than the first side surface S1_P of the opening OP. A part of the via insulating layer VIA that is adjacent to the first side surface S1_V of the second via contact hole VCNT2 may be defined as a protrusion PP. In other words, an end part of the via insulating layer VIA may include the protrusion PP protruding toward the center of the second via contact hole VCNT2.

The first side surfaces S1_P and S1_V may all face the same direction, and the second side surfaces S2_P and S2_V may all face the same direction.

In an embodiment, the protrusion PP of the via insulating layer VIA may constitute an undercut shape UC together with the first side surface S1_P of the opening OP of the protective layer PVX. The undercut shape may mean a shape formed by cutting away material from the underside of (an object) so as to leave an overhanging portion in relief. In other words, the undercut shape UC may be defined by the protrusion PP of the via insulating layer VIA and the first side surface S1_P of the opening OP of the protective layer PVX. The undercut shape UC may partially overlap with the auxiliary power line AL.

In an embodiment, a lower surface LS of the protrusion PP of the via insulating layer VIA that does not contact the protective layer PVX may have a curved shape. For example, the lower surface LS of the protrusion PP may have a convex curved shape toward the auxiliary power line AL. As another example, the lower surface LS of the protrusion PP may have a concave curved shape toward the auxiliary power line AL.

The pixel electrode PXE may be disposed in the display area DA on the via insulating layer VIA. The pixel electrode PXE may be connected to the second electrode CE2 through the first groove GV1. Accordingly, the pixel electrode PXE may be electrically connected to the transistor TR. The pixel electrode PXE may include a metal, an alloy, a metal nitride, a conductive metal oxide, a transparent conductive material, and/or the like. These materials may be used alone or in any suitable combination with each other. The pixel electrode PXE may operate as an anode.

The pixel defining layer PDL may be disposed in the display area DA on the via insulating layer VIA. The pixel defining layer PDL may cover at least a part of the pixel electrode PXE. In addition, a pixel opening exposing at least a part of an upper surface of the pixel electrode PXE may be defined in the pixel defining layer PDL. In an embodiment, the pixel defining layer PDL may be disposed on the via insulating layer VIA, and may extend into the second groove GV2. In more detail, the pixel defining layer PDL may be extended to a part of the upper surface of the auxiliary power line AL to cover the second side surface S2_P of the opening OP and the second side surface S2_V of the second via contact hole VCNT2.

The pixel defining layer PDL may include an inorganic material and/or an organic material. In an embodiment, the pixel defining layer PDL may include an organic material, such as an epoxy resin, a siloxane resin, and/or the like. These organic materials may be used alone or in any suitable combination with each other. In another embodiment, the pixel defining layer PDL may further include a light blocking material containing a black pigment, a black dye, and/or the like.

The light emitting layer EL may be disposed in the display area DA on the pixel electrode PXE, the protrusion PP of the via insulating layer VIA, the pixel defining layer PDL, and the auxiliary power line AL. In other words, the light emitting layer EL may be disposed on a whole surface of the display area DA. The light emitting layer EL may be disposed on the auxiliary power line AL to expose at least a part of an upper surface of the auxiliary power line AL. For example, the light emitting layer EL may have a multilayered structure including a hole injection layer, a hole transport layer, an organic light emitting layer, an electron transport layer, and an electron injection layer. In an embodiment, the light emitting layer EL may be disconnected by the protrusion PP of the via insulating layer VIA. In other words, the light emitting layer EL may be disconnected by the undercut shape UC.

The common electrode CME may be disposed in the display area DA on the light emitting layer EL. In other words, the common electrode CME may be disposed on the entire surface of the display area DA. The common electrode CME may receive the common voltage (e.g., the common voltage ELVSS of FIGS. 2 and 3) from the auxiliary power line AL. For example, the common electrode CME may include a metal, an alloy, a metal nitride, a conductive metal oxide, a transparent conductive material, and/or the like. These materials may be used alone or in any suitable combination with each other. The common electrode CME may operate as a cathode.

In an embodiment, the common electrode CME may be disconnected by the undercut shape UC. As such, the common electrode CME may be electrically connected to the auxiliary power line AL. In more detail, the common electrode CME may directly contact the auxiliary power line AL exposed by the light emitting layer EL. For example, the common electrode CME may contact a part of the upper surface of the auxiliary power line AL. In addition, the common electrode CME may cover a side surface of the light emitting layer EL that is adjacent to the auxiliary power line AL. As the common electrode CME is electrically connected to the auxiliary power line AL, a voltage drop of the common voltage applied to the common electrode CME may be prevented or substantially prevented.

Accordingly, the light emitting element LED including the pixel electrode PXE, the light emitting layer EL, and the common electrode CME may be disposed in the display area DA on the substrate SUB. The light emitting element LED may be electrically connected to the transistor TR.

In an embodiment, an organic layer OL may fill the inside of the undercut shape UC. In more detail, the organic layer OL may fill an empty space of the second groove GV2. In other words, the organic layer OL may fill the empty space between the auxiliary power line AL and the protrusion PP. Accordingly, the formation of voids inside the undercut shape UC may be prevented or substantially prevented.

The encapsulation layer ENC may be disposed in the display area DA on the common electrode CME and the organic layer OL. The encapsulation layer ENC may cover the light emitting element LED. The encapsulation layer ENC may seal the display area DA to protect the light emitting element LED from external impurities.

The encapsulation layer ENC may include at least one inorganic encapsulation layer and at least one organic encapsulation layer. For example, as described above, the encapsulation layer ENC may include the first inorganic encapsulation layer EN1, the organic encapsulation layer EN2 disposed on the first inorganic encapsulation layer EN1, and the second inorganic encapsulation layer EN3 disposed on the organic encapsulation layer EN2.

The first inorganic encapsulation layer EN1 may be disposed on the common electrode CME. For example, the first inorganic encapsulation layer EN1 may be disposed along the profile of the common electrode to have a uniform or substantially uniform thickness.

The organic encapsulation layer EN2 may be disposed on the first inorganic encapsulation layer EN 1. The organic encapsulation layer EN2 may have a flat or substantially flat upper surface, without creating a step around the first inorganic encapsulation layer EN1.

The second inorganic encapsulation layer EN3 may be disposed on the organic encapsulation layer EN2. The second inorganic encapsulation layer EN3 may have a uniform or substantially uniform thickness, and a flat or substantially flat upper surface.

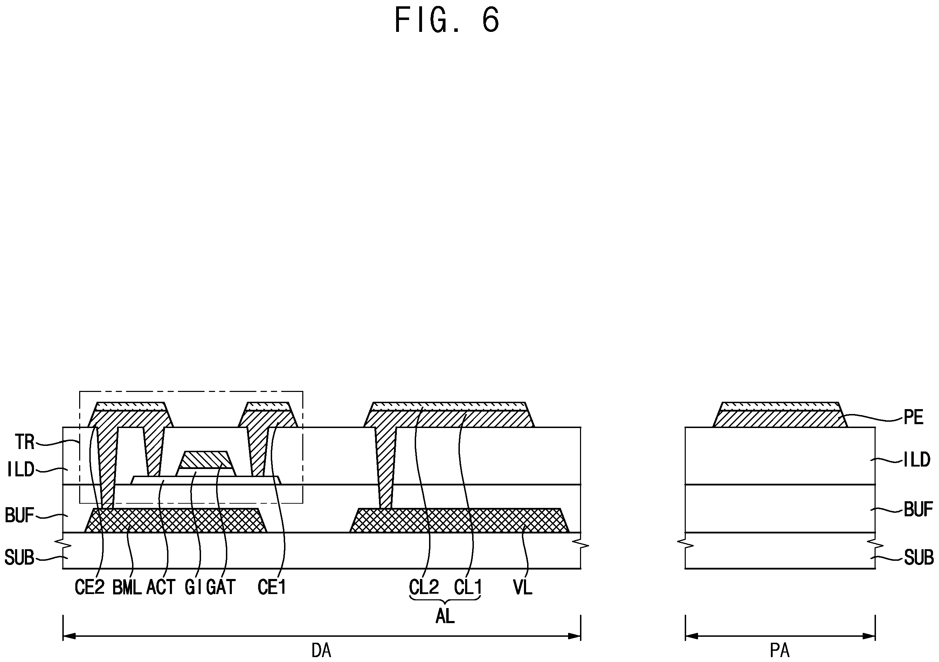

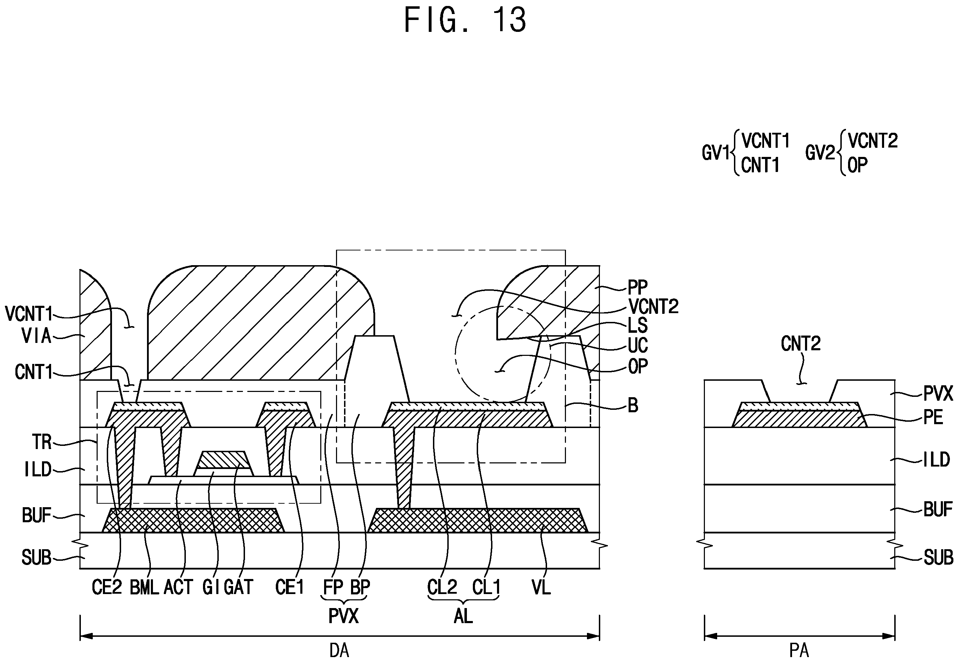

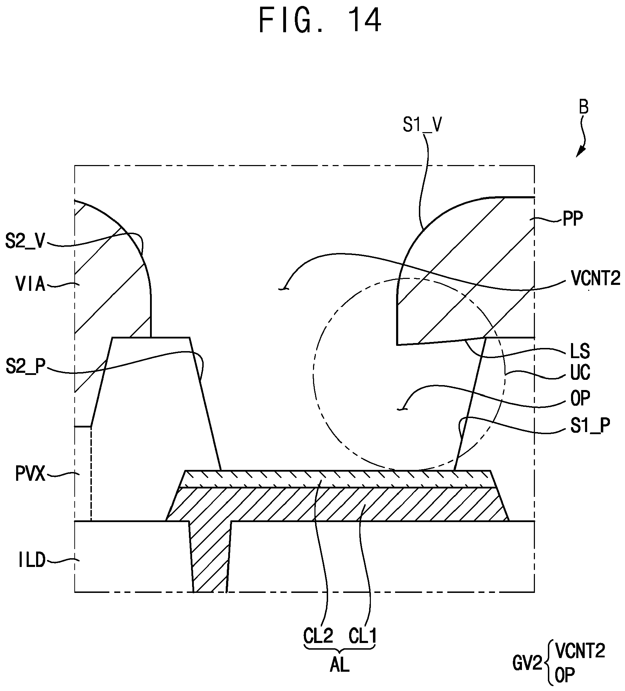

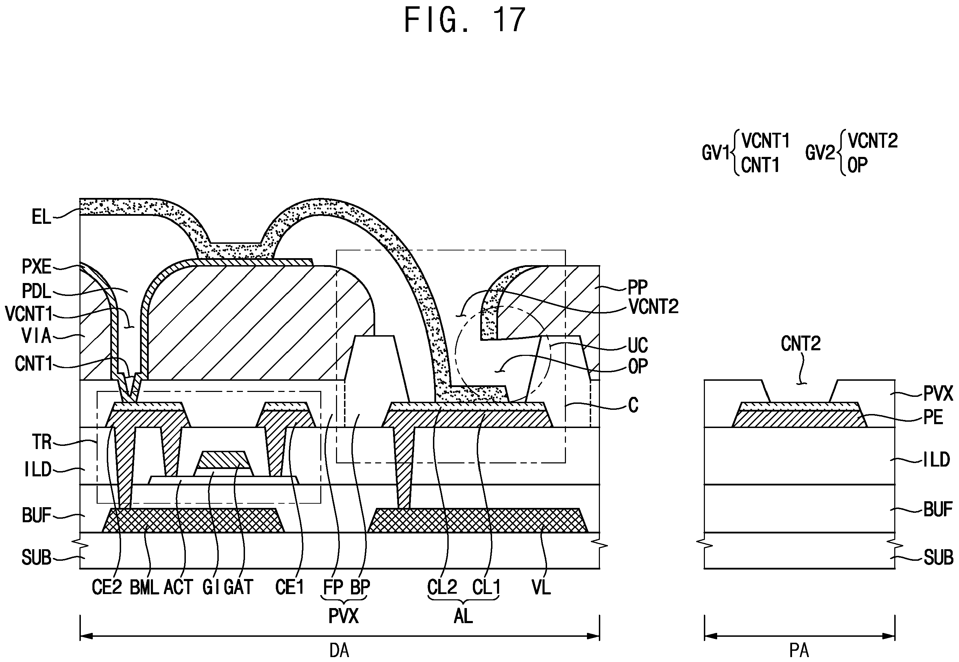

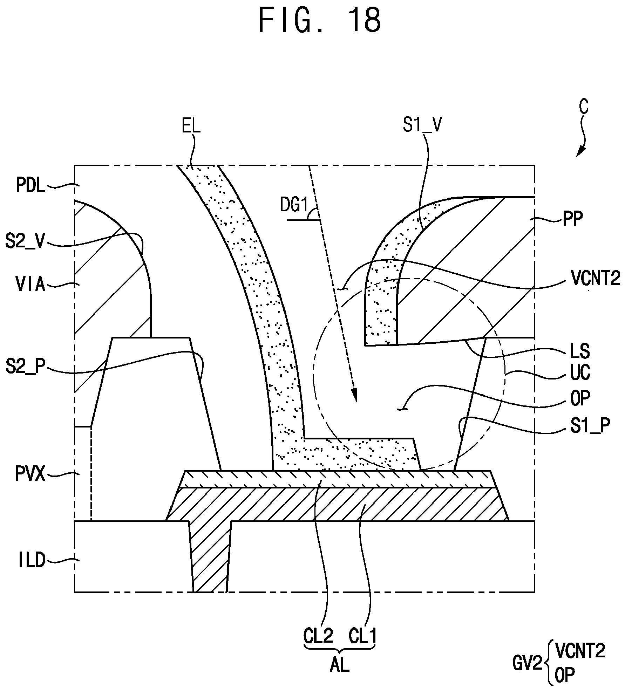

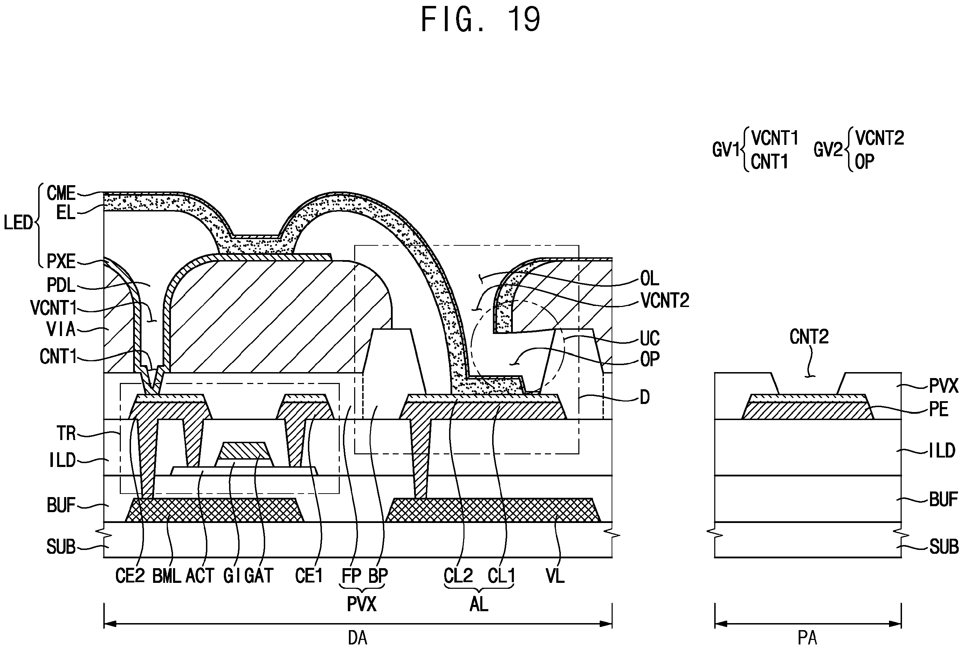

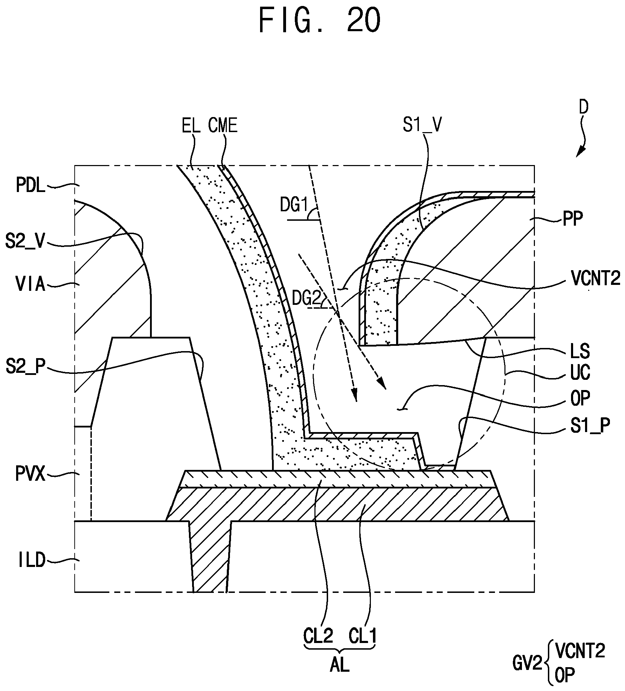

FIGS. 6 through 21 are cross-sectional views illustrating an example of a method for manufacturing the display device of FIG. 4. For example, FIG. 14 is an enlarged cross-sectional view of the area B of FIG. 13, FIG. 18 is an enlarged cross-sectional view of the area C of FIG. 17, and FIG. 20 is an enlarged cross-sectional view of the area D of FIG. 19.

Referring to FIG. 6, the lower metal layer BML, the power line VL, the buffer layer BUF, the active pattern ACT, the gate insulating layer GI, the gate electrode GAT, the interlayer insulating layer ILD, and the first electrode CE1, the second electrode CE2, the auxiliary power line AL, and the pad electrode PE may be sequentially formed on the substrate SUB.

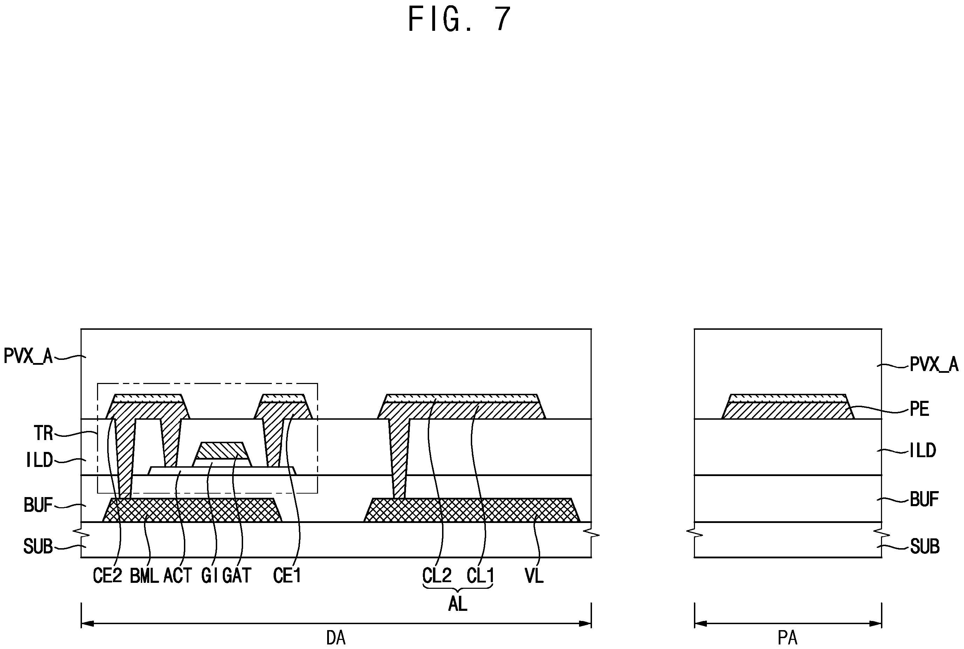

Referring to FIG. 7, a preliminary protective layer PVX_A may be formed on the interlayer insulating layer ILD. The preliminary protective layer PVX_A may be formed on the entirety of the display area DA and the pad area PA, and may cover the first electrode CE1, the second electrode CE2, the auxiliary power line AL, and the pad electrode PE. For example, the preliminary protective layer PVX_A may be formed using silicon oxide, silicon nitride, silicon oxynitride, and/or the like.

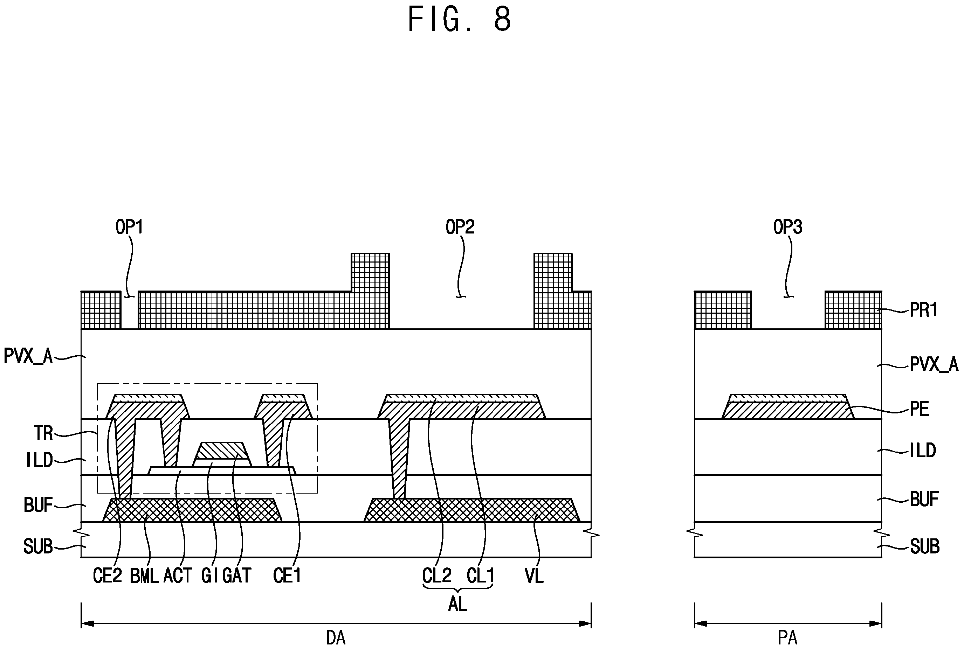

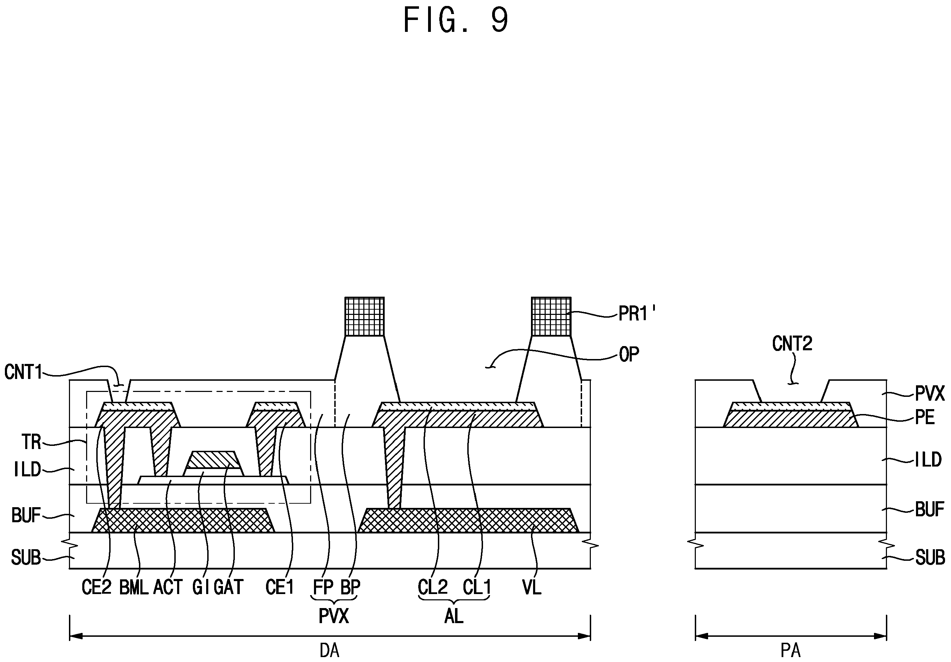

Referring to FIGS. 8 and 9, a first photosensitive organic layer PR1 may be formed on the preliminary protective layer PVX_A. For example, the first photosensitive organic layer PR1 may be formed using a photoresist. In an embodiment, the first photosensitive organic layer PR1 may be formed by exposing and developing the photoresist through a halftone mask. Accordingly, in the display area DA, a first opening OP1 and a second opening OP2 exposing a part of an upper surface of the preliminary protective layer PVX_A may be formed in the first photosensitive organic layer PR1. In addition, in the pad area PA, a third opening OP3 exposing a part of an upper surface of the preliminary protective layer PVX_A may be formed in the first photosensitive organic layer PR1.

Through an etching process, the first contact hole CNT1 may be formed by removing a part of the preliminary protective layer PVX_A overlapping with the first opening OP1, the opening OP may be formed by removing a part of the preliminary protective layer PVX_A overlapping with the second opening OP2, and the second contact hole CNT2 may be formed by removing a part of the preliminary protective layer PVX_A overlapping with the third opening OP3. In this case, a relatively thinner first part of the first photosensitive organic layer PR1 may be removed together, and a part of a relatively thicker second part may be removed. Accordingly, the first contact hole CNT1, the opening OP, and the second contact hole CNT2 may be formed, and the protective layer PVX including the flat part FP and the bank part BP may be formed. The flat part FP may be formed by removing a part of the preliminary protective layer PVX_A corresponding to the first part of the first photosensitive organic layer PR1, and the bank part BP may be formed with the preliminary protective layer PVX_A corresponding to the second part of the first photosensitive organic layer PR1 that is remaining. In an embodiment, the etching process may be a dry etching process.

After performing the etching process, a first photosensitive organic pattern PR1' may be formed by removing a part of the second part of the first photosensitive organic layer PR1. The first photosensitive organic pattern PR1' may be formed on the bank part BP of the protective layer PVX.

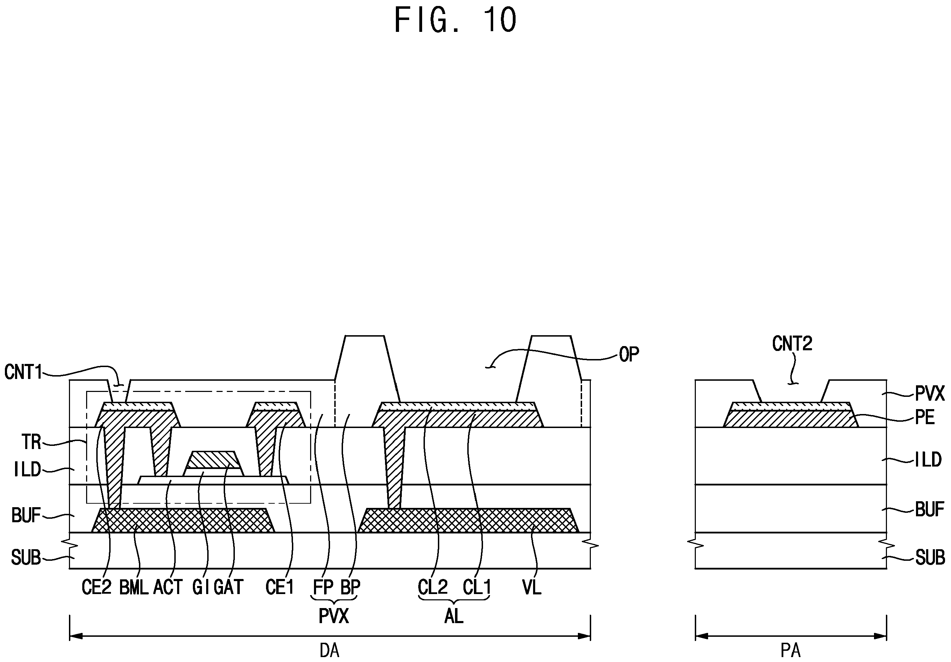

Referring to FIG. 10, the first photosensitive organic pattern PR1' may be removed. In an embodiment, the first photosensitive organic pattern PR1' may be removed through an ashing process. For example, the ashing process may use plasma containing oxygen (O₂) and nitrogen (N₂) gases.

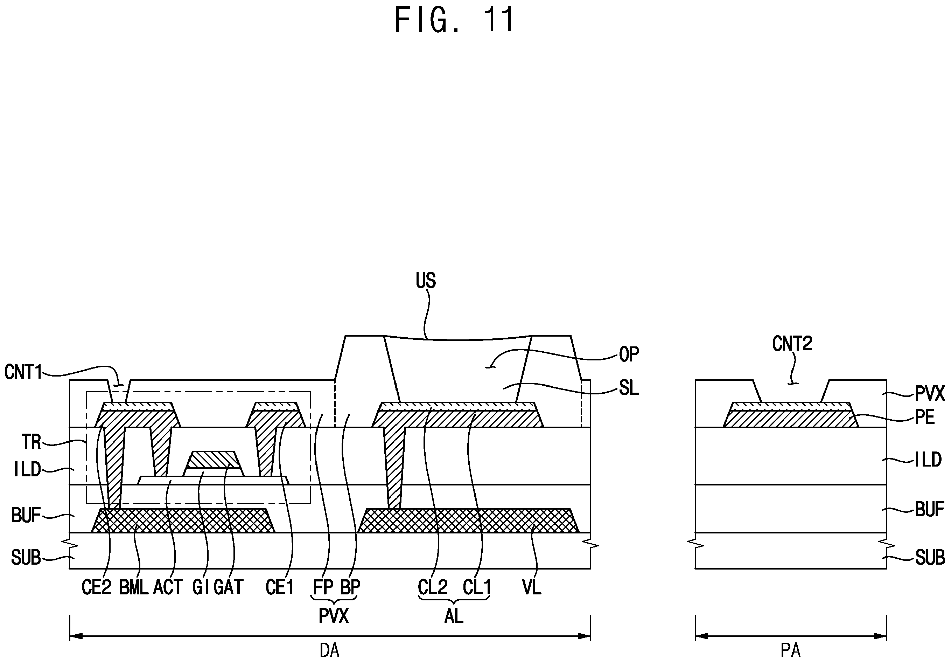

Referring to FIG. 11, in an embodiment, a sacrificial layer SL may be filled in the opening OP of the protective layer PVX. For example, the sacrificial layer SL may be formed using an organic material. In an embodiment, the sacrificial layer SL may be formed through an inkjet printing process.

In an embodiment, an ashing rate of the sacrificial layer SL relative to a plasma gas used in an ashing process for removing the sacrificial layer SL may be greater than an ashing rate of the via insulating layer VIA. In other words, the sacrificial layer SL may be formed using an organic material having a higher ashing rate than that of the via insulating layer VIA.

In an embodiment, an upper surface US of the sacrificial layer SL may have a curved shape due to a meniscus phenomenon. For example, the upper surface US of the sacrificial layer SL may have a concave curved shape.

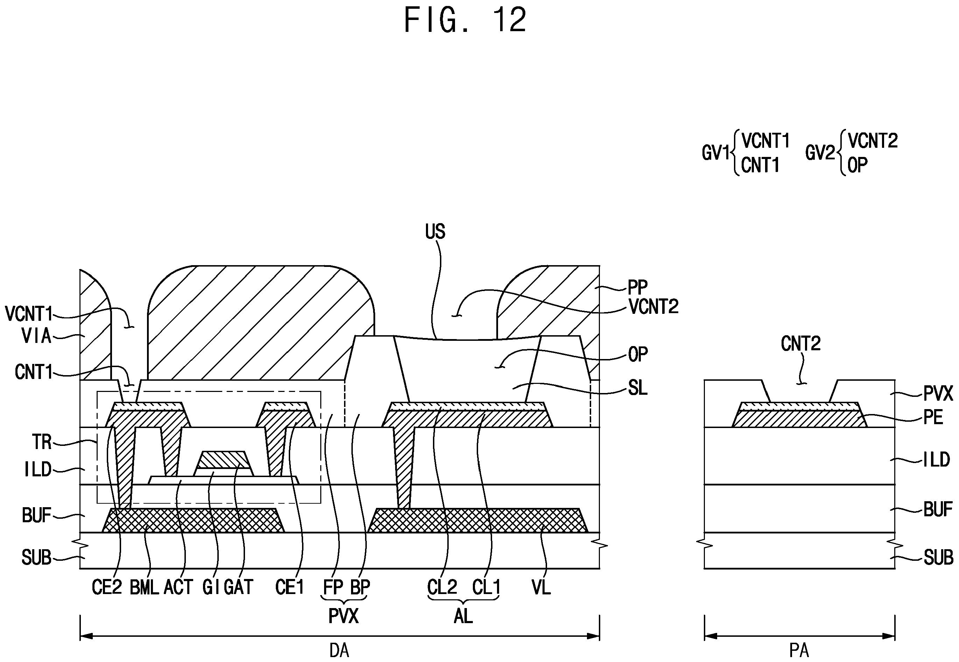

Referring to FIG. 12, the via insulating layer VIA may be formed in the display area DA on the protective layer PVX. The first via contact hole VCNT1 connected to the first contact hole CNT1 and the second via contact hole VCNT2 connected to the opening OP may be formed in the via insulating layer VIA. The second via contact hole VCNT2 may expose at least a part of the upper surface US of the sacrificial layer SL. For example, the via insulating layer VIA may be formed using an organic material.

Referring to FIGS. 13 and 14, the sacrificial layer SL may be removed. In an embodiment, the sacrificial layer SL may be removed through an ashing process. In this case, the via insulating layer VIA may not be removed.

The opening OP may have the first side surface S1_P and the second side surface S2_P, and the second via contact hole VCNT2 may have the first side surface S1_V and the second side surface S2_V. As the sacrificial layer SL is removed, a part of the via insulating layer VIA may protrude toward the center of the second via contact hole VCNT2. The end part of the via insulating layer VIA may include the protrusion PP protruding toward the center of the second via contact hole VCNT2. As the via insulating layer VIA includes the protrusion PP, the protrusion PP of the via insulating layer VIA may form the undercut shape UC together with the first side surface S1_P of the opening OP.

The first via contact hole VCNT1 may be connected to the first contact hole CNT1 to form the first groove GV1, and the second via contact hole VCNT2 may be connected to the opening OP to form the second groove GV2. The first groove GV1 may expose at least a part of the upper surface of the second electrode CE2, and the second groove GV2 may expose at least a part of the upper surface of the auxiliary power line AL.

In an embodiment, as the upper surface US of the sacrificial layer SL has a curved shape, the lower surface LS of the protrusion PP contacting the upper surface US of the sacrificial layer SL also may have a curved shape. For example, the lower surface LS of the protrusion PP may have a convex curved shape toward the auxiliary power line AL.

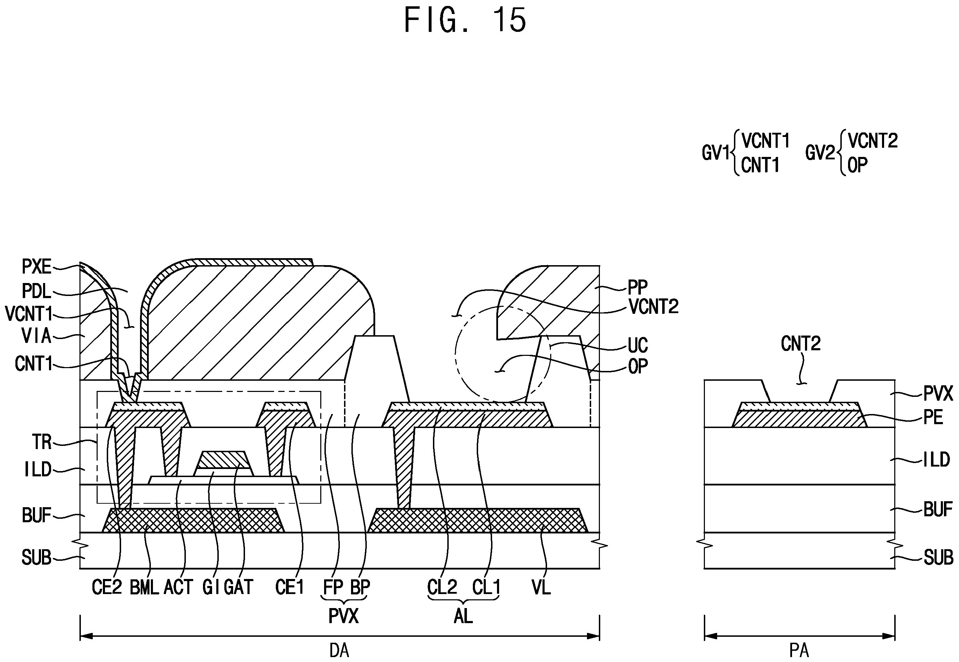

Referring to FIG. 15, the pixel electrode PXE may be formed on the via insulating layer VIA. The pixel electrode PXE may be connected to the second electrode CE2 through the first groove GV1.

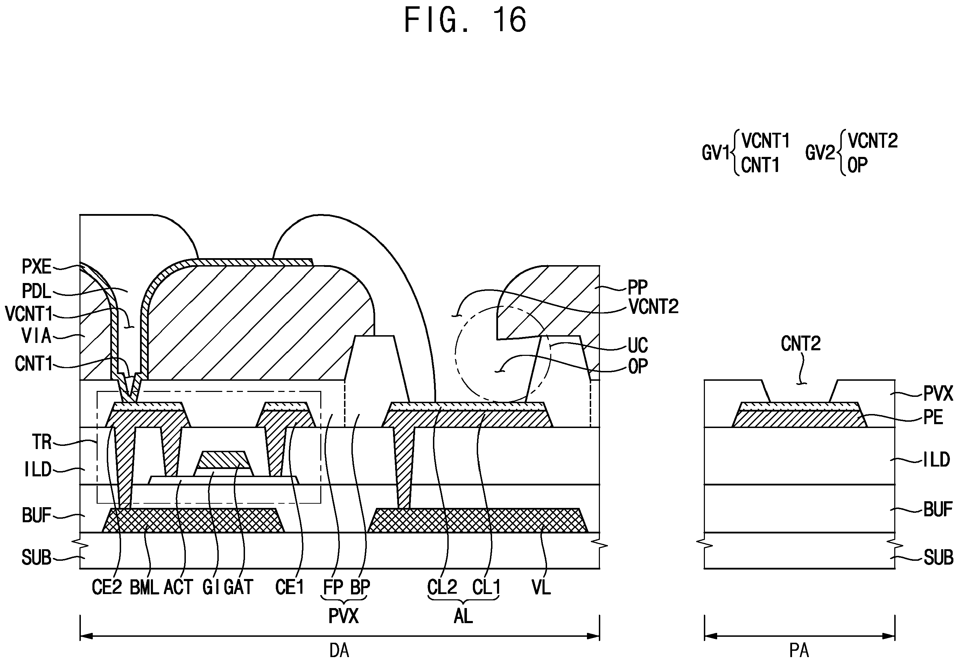

Referring to FIG. 16, the pixel defining layer PDL may be formed on the via insulating layer VIA. In more detail, the pixel defining layer PDL may cover at least a part of the pixel electrode PXE, and may extend into the second groove GV2. For example, the pixel defining layer PDL may be formed using an organic material.

Referring to FIGS. 17 and 18, the light emitting layer EL may be formed on the pixel defining layer PDL, the via insulating layer VIA, the pixel electrode PXE, and the auxiliary power line AL. The light emitting layer EL may be formed on the entire surface of the display area DA. The light emitting layer EL may be disconnected by the undercut shape UC. In an embodiment, the light emitting layer EL may be deposited at a first angle DG1.

Referring to FIGS. 19 and 20, the common electrode CME may be formed on the light emitting layer EL. The common electrode CME may be formed on the entire surface of the display area DA. The common electrode CME may be disconnected by the undercut shape UC. For example, the common electrode CME may directly contact a part of the upper surface of the auxiliary power line AL. In an embodiment, the common electrode CME may be deposited at a second angle DG2. For example, the first angle DG1 may be greater than the second angle DG2. In other words, the common electrode CME may be deposited at a lower deposition angle than that of the light emitting layer EL. Accordingly, the common electrode CME may cover a side surface of the light emitting layer EL.

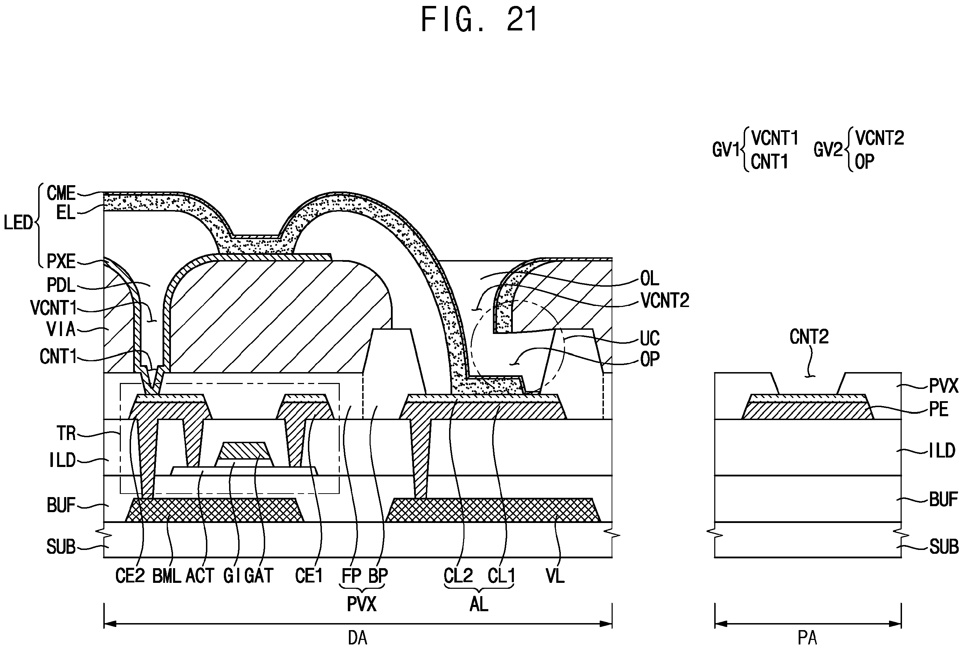

Referring to FIG. 21, the organic layer OL may fill the inside of the undercut shape UC. In more detail, the organic layer OL may fill the empty space of (e.g., defined by) the second groove GV2.

Referring back to FIG. 4, the encapsulation layer ENC may be formed in the display area DA on the common electrode CME and the organic layer OL. The encapsulation layer ENC may include the first inorganic encapsulation layer EN1 on the common electrode CME, the organic encapsulation layer EN2 formed on the first inorganic encapsulation layer EN1, and the second inorganic encapsulation layer EN3 formed on the organic encapsulation layer EN2.

Accordingly, the display device 100 illustrated in FIGS. 4 and 5 may be manufactured.

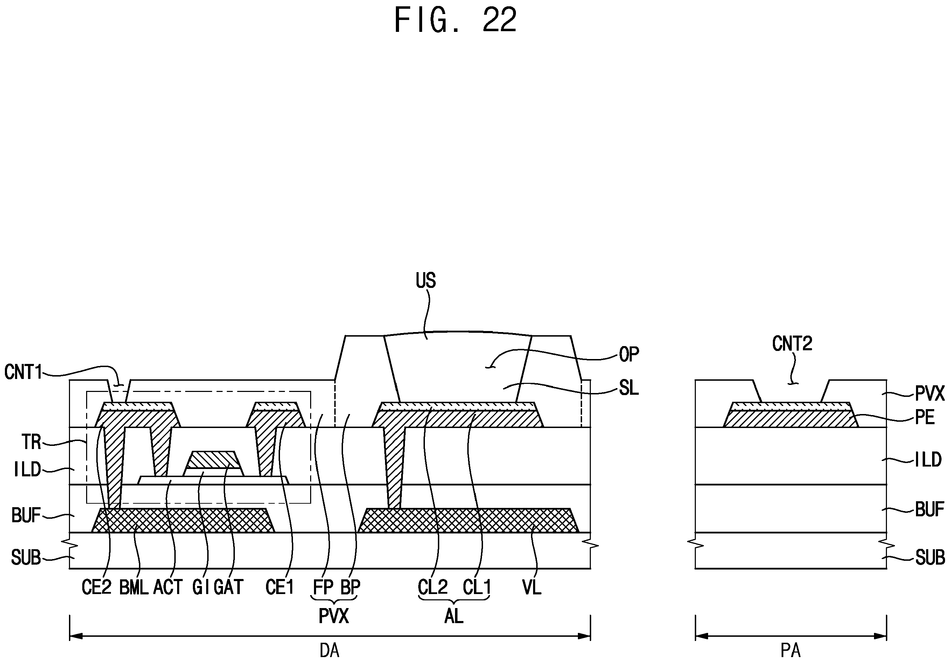

FIGS. 22, 23, and 24 are cross-sectional views illustrating another example of a method for manufacturing the display device of FIG. 4. For example, FIGS. 22, 23, and 24 illustrate other examples of the processes of the method for manufacturing the display device described above with reference to FIGS. 11, 12, and 13. Hereinafter, redundant description thereof may not be repeated, or may be simplified.

Referring to FIG. 22, in an embodiment, the sacrificial layer SL may be filled inside of the opening OP of the protective layer PVX. For example, the sacrificial layer SL may be formed using an organic material.

In an embodiment, the upper surface US of the sacrificial layer SL may have a curved shape due to a meniscus phenomenon. For example, the upper surface US of the sacrificial layer SL may have a convex curved shape.

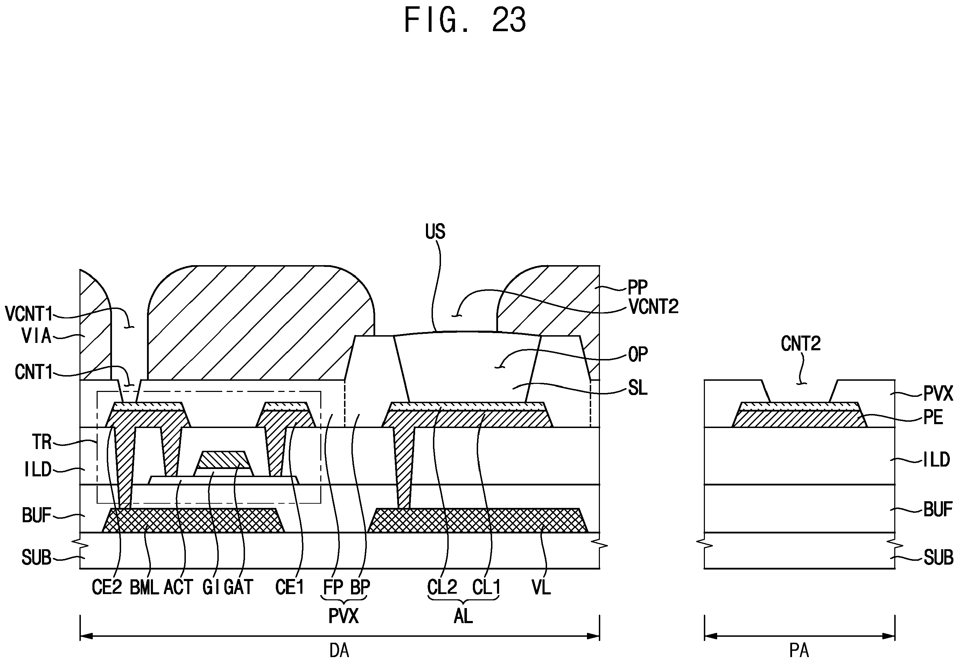

Referring to FIG. 23, the via insulating layer VIA may be formed in the display area DA on the protective layer PVX. The first via contact hole VCNT1 connected to the first contact hole CNT1 and the second via contact hole VCNT2 connected to the opening OP may be formed in the via insulating layer VIA. The second via contact hole VCNT2 may expose at least a part of the upper surface US of the sacrificial layer SL. For example, the via insulating layer VIA may be formed using an organic material.

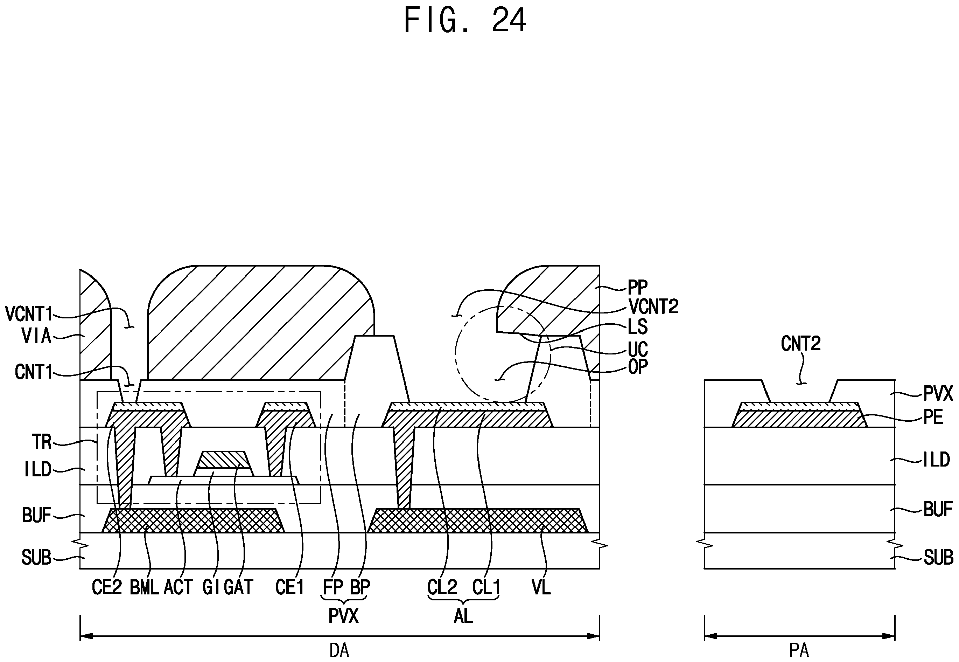

Referring to FIGS. 23 and 24, the sacrificial layer SL may be removed. In an embodiment, the sacrificial layer SL may be removed through an ashing process. In this case, the via insulating layer VIA may not be removed.

As the sacrificial layer SL is removed, a part of the via insulating layer VIA may protrude toward the center of the second via contact hole VCNT2. The end part of the via insulating layer VIA may include the protrusion PP protruding toward the center of the second via contact hole VCNT2. As the via insulating layer VIA includes the protrusion PP, the protrusion PP of the via insulating layer VIA may form the undercut shape UC together with a first side surface (e.g., the first side surface S1_P of FIG. 14) of the opening OP.

In an embodiment, as the upper surface US of the sacrificial layer SL has a curved shape, the lower surface LS of the protrusion PP contacting the upper surface US of the sacrificial layer SL also may have a curved shape. For example, the lower surface LS of the protrusion PP may have a concave curved shape toward the auxiliary power line AL.

Components of the display device 100 formed after the sacrificial layer SL is removed may be formed in the same or substantially the same processes as those of the method for manufacturing the display device described above with reference to FIGS. 14, 15, 16, 17, 18, 19, 20, and 21.

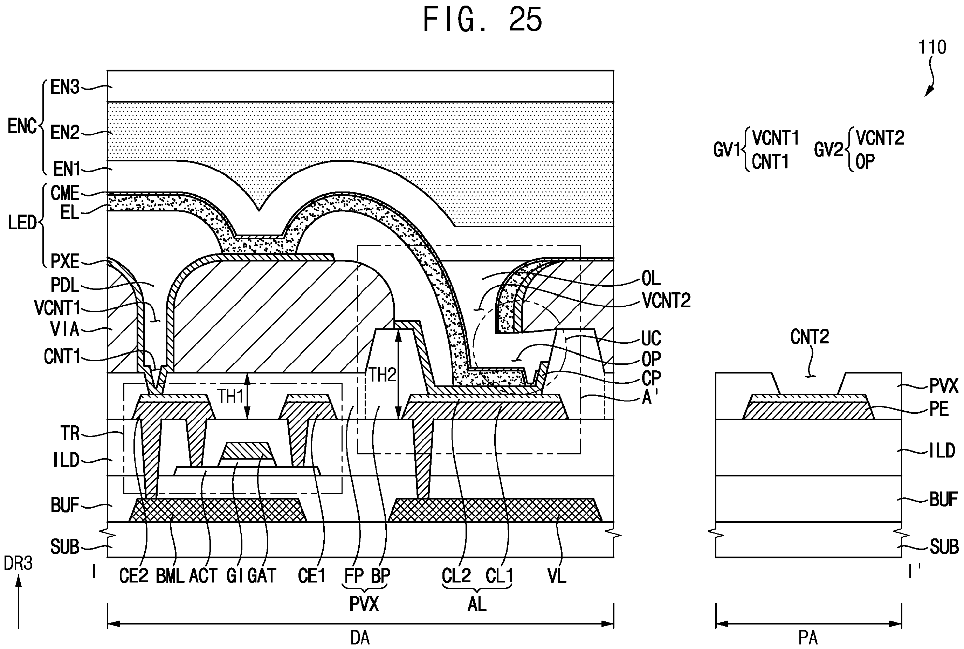

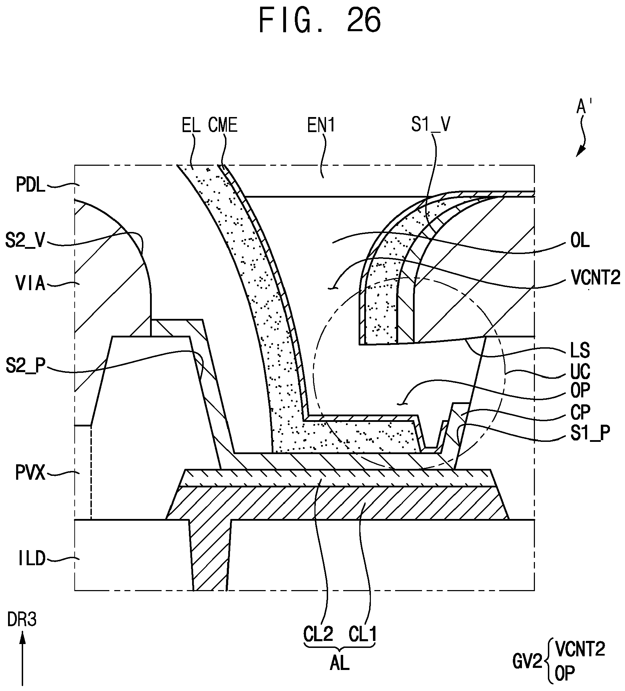

FIG. 25 is a cross-sectional view illustrating a display device according to another embodiment of the present disclosure. FIG. 26 is an enlarged cross-sectional view of the area A' of FIG. 25.

Referring to FIGS. 25 and 26, a display device 110 according to another embodiment of the present disclosure may include the substrate SUB, the lower metal layer BML, the power line VL, the buffer layer BUF, the gate insulating layer GI, the interlayer insulating layer ILD, the transistor TR, the pad electrode PE, the auxiliary power line AL, the protective layer PVX, the via insulating layer VIA, the light emitting element LED, a cover pattern CP, the pixel defining layer PDL, the organic layer OL, and the encapsulation layer ENC. The display device 110 described hereinafter with reference to FIGS. 25 and 26 may be the same or substantially the same as (or similar to) the display device 100 described above with reference to FIGS. 4 and 5, except that the display device 110 further includes the cover pattern CP. Accordingly, hereinafter redundant description thereof may not be repeated or may be simplified.

In an embodiment, the cover pattern CP may be disposed on the auxiliary power line AL and the via insulating layer VIA. In more detail, the cover pattern CP may directly contact a part of the upper surface of the auxiliary power line AL. The cover pattern CP may include the same material as that of the pixel electrode PXE. The cover pattern CP may be disconnected by the protrusion PP of the via insulating layer VIA. In other words, the cover pattern CP may be disconnected by the undercut shape UC.

In an embodiment, the cover pattern CP may extend to the second side surface S2_P of the opening OP of the protective layer PVX. In addition, the cover pattern CP may extend to at least a part of the first side surface S1_P of the opening OP of the protective layer PVX.

The common electrode CME may be electrically connected to the auxiliary power line AL through the cover pattern CP. In other words, the common electrode CME may not directly contact the auxiliary power line AL.

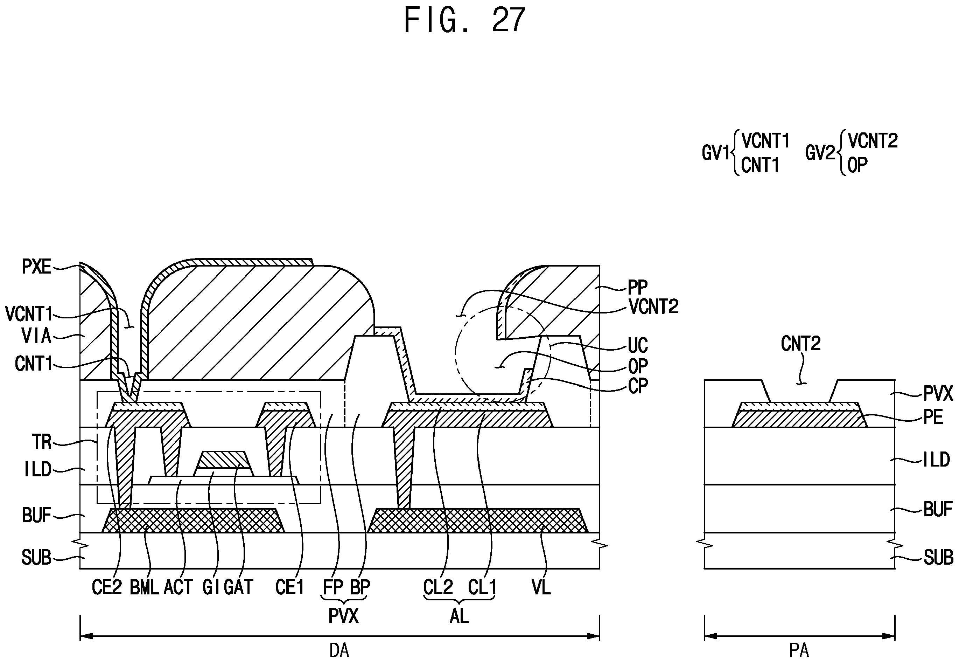

FIGS. 27 through 31 are cross-sectional views illustrating a method for manufacturing the display device of FIG. 25. Hereinafter, redundant description overlapping with the method for manufacturing display device 100 described above with reference to FIGS. 6 through 24 may not be repeated or may be simplified.

Referring to FIG. 27, the pixel electrode PXE may be formed on the via insulating layer VIA. The pixel electrode PXE may be connected to the second electrode CE2 through the first groove GV1.

The cover pattern CP may be formed on the auxiliary power line AL and the via insulating layer VIA. The cover pattern CP may be concurrently or simultaneously formed through the same process as that of the pixel electrode PXE. In other words, the cover pattern CP may be formed using the same material as that of the pixel electrode PXE. The cover pattern CP may be disconnected by the undercut shape UC. In addition, the cover pattern CP may directly contact the upper surface of the auxiliary power line AL.

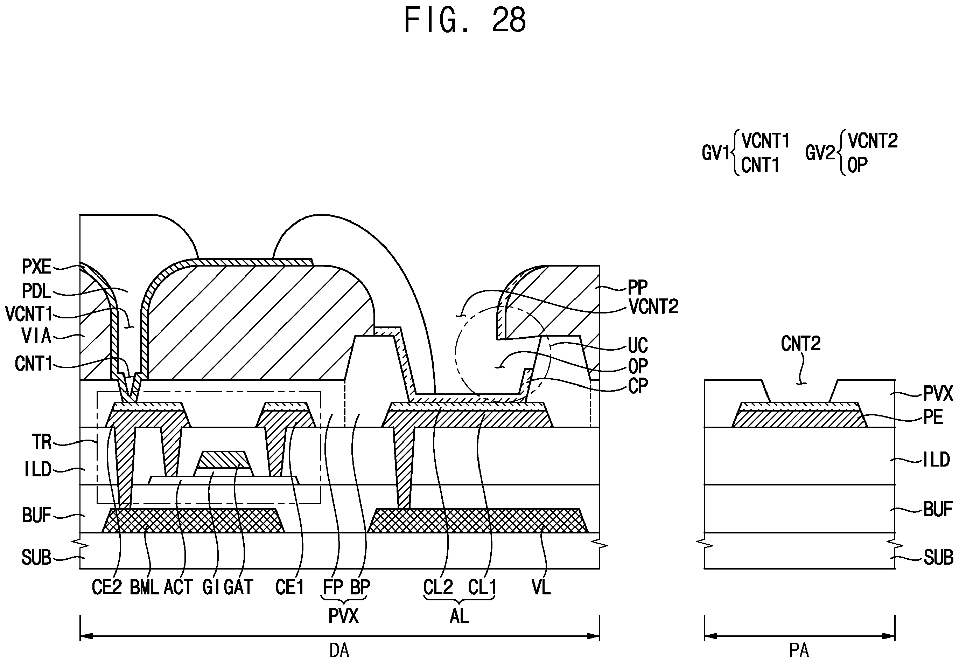

Referring to FIG. 28, the pixel defining layer PDL may be formed on the via insulating layer VIA. In more detail, the pixel defining layer PDL may cover at least a part of each of the pixel electrode PXE and the cover pattern CP, and may extend into the second groove GV2. For example, the pixel defining layer PDL may be formed using an organic material.

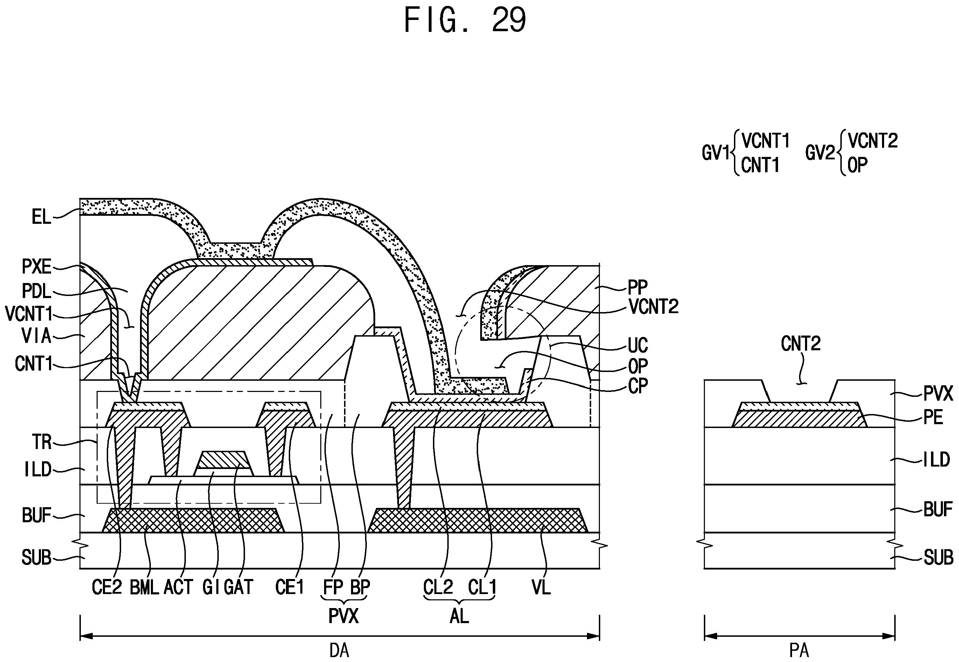

Referring to FIG. 29, the light emitting layer EL may be formed on the pixel defining layer PDL, the via insulating layer VIA, the pixel electrode PXE, and the cover pattern CP. The light emitting layer EL may be formed on the entire surface of the display area DA. The light emitting layer EL may be disconnected by the undercut shape UC. The light emitting layer EL may directly contact the upper surface of the cover pattern CP.

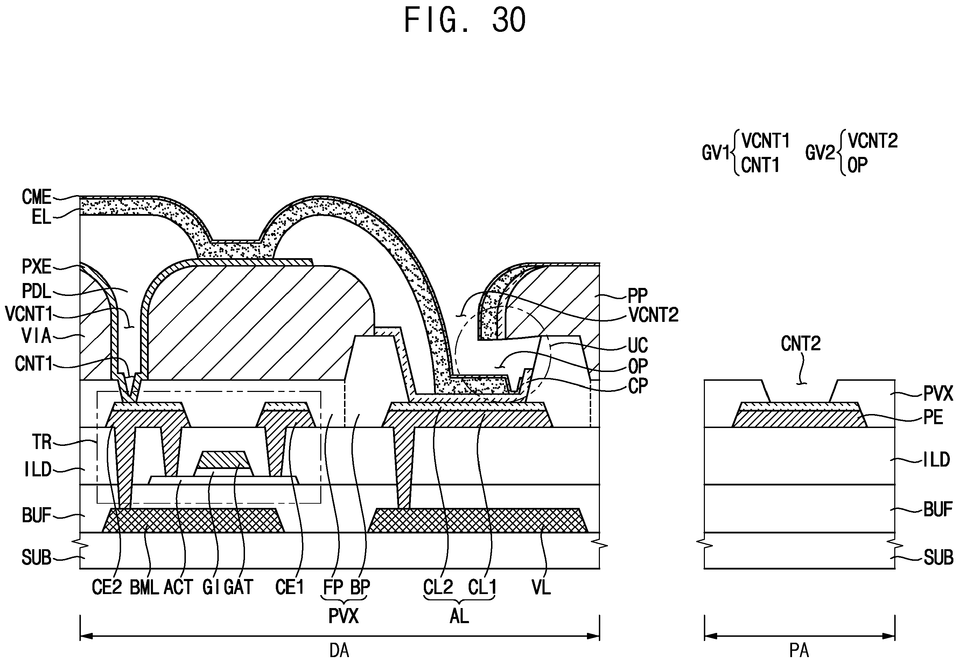

Referring to FIG. 30, the common electrode CME may be formed on the light emitting layer EL. The common electrode CME may be formed on the entire surface of the display area DA. The common electrode CME may be disconnected by the undercut shape UC. For example, the common electrode CME may directly contact a part of the cover pattern CP.

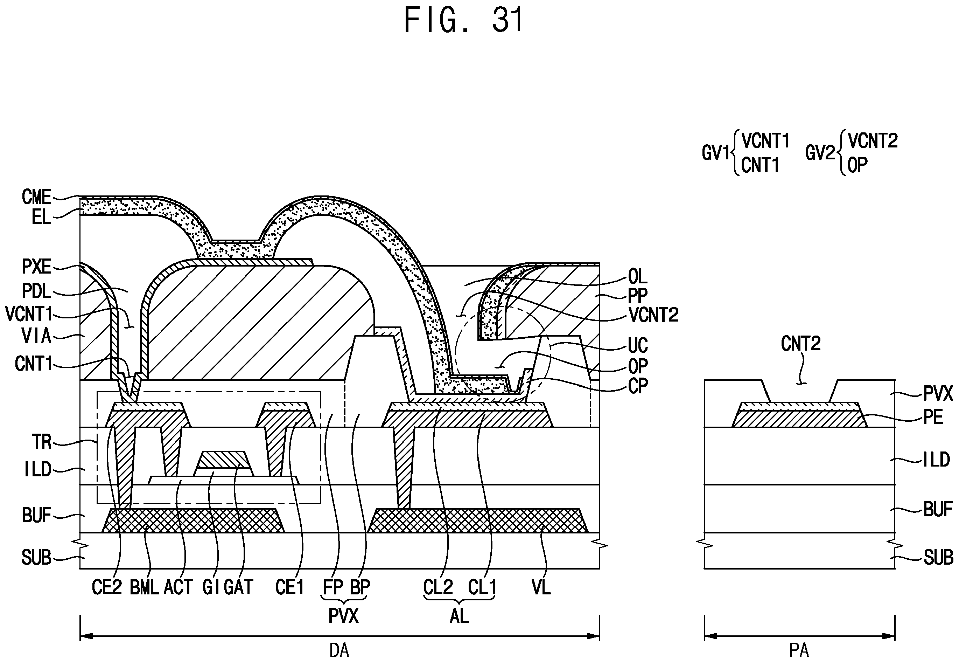

Referring to FIG. 31, the organic layer OL may fill the inside of the undercut shape UC. In more detail, the organic layer OL may fill the empty space of the second groove GV2.

Referring back to FIG. 25, the encapsulation layer ENC may be formed in the display area DA on the common electrode CME. The encapsulation layer ENC may include the first inorganic encapsulation layer EN1 formed on the common electrode CME, the organic encapsulation layer EN2 formed on the first inorganic encapsulation layer EN1, and the second inorganic encapsulation layer EN3 formed on the organic encapsulation layer EN2.

Accordingly, the display device 110 illustrated in FIGS. 25 and 26 may be manufactured.

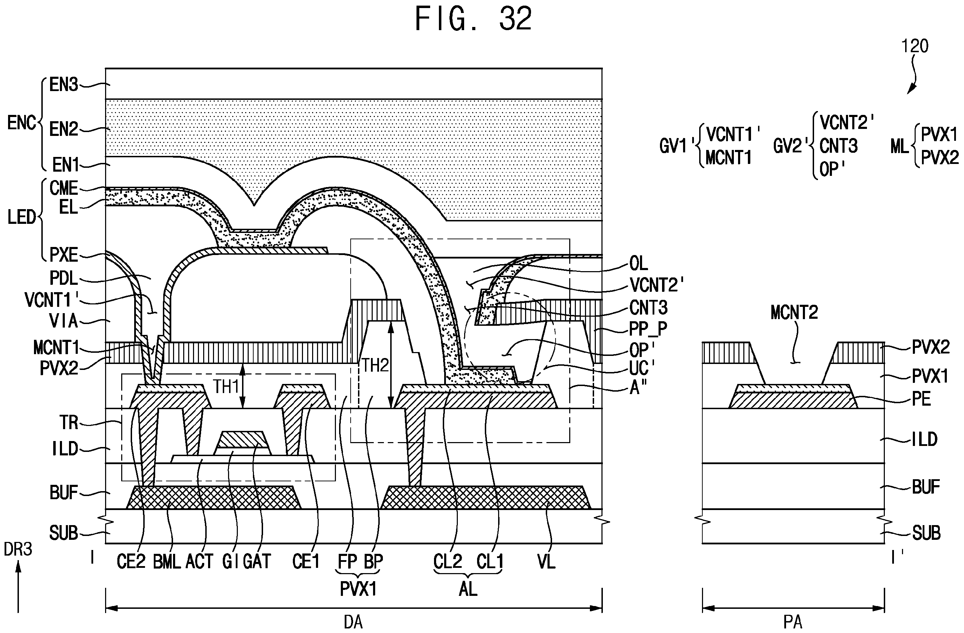

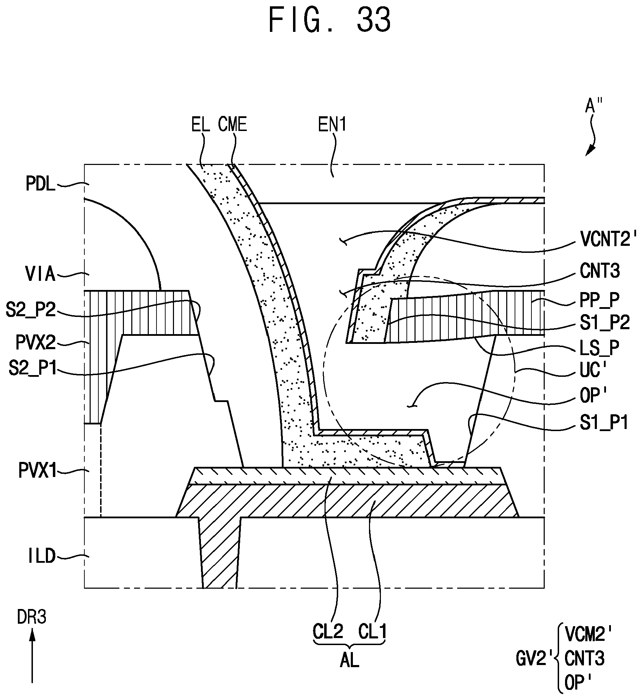

FIG. 32 is a cross-sectional view illustrating a display device according to another embodiment of the present disclosure. FIG. 33 is an enlarged cross-sectional view of the area A" of FIG. 32.

Referring to FIGS. 32 and 33, a display device 120 according to another embodiment of the present disclosure may include the substrate SUB, the lower metal layer BML, the power line VL, the buffer layer BUF, the gate insulating layer GI, the interlayer insulating layer ILD, the transistor TR, the pad electrode PE, the auxiliary power line AL, a first protective layer PVX1, a second protective layer PVX2, the via insulating layer VIA, the light emitting element LED, the pixel defining layer PDL, the organic layer OL, and the encapsulation layer ENC.

The display device 120 described in more detail hereinafter with reference to FIGS. 32 and 33 may be the same or substantially the same as (or similar to) the display device 100 described above with reference to FIGS. 4 and 5, except for the number of the protective layer and the protective layer defining the undercut shape. Hereinafter, redundant description thereof may not be repeated or may be simplified.

The first protective layer PVX1 may be disposed on the interlayer insulating layer ILD. The first protective layer PVX1 may be entirely disposed on the display area DA and the pad area PA. The first protective layer PVX1 may include an inorganic material, such as silicon oxide, silicon nitride, silicon oxynitride, and/or the like. These inorganic materials may be used alone or in any suitable combination with each other. The first protective layer PVX1 may have a single-layer structure or a multi-layered structure including a plurality of insulating layers.

In an embodiment, in the display area DA, a first contact hole exposing at least a part of an upper surface of the second electrode CE2 and an opening OP' exposing at least a part of an upper surface of the auxiliary power line AL may formed in the first protective layer PVX1. In addition, in the pad area PA, a second contact hole exposing at least a part of the upper surface of the pad electrode PE may be defined in the first protective layer PVX1.

In an embodiment, the first protective layer PVX1 may include a flat part FP and a bank part BP. The bank part BP may cover an edge of the auxiliary power line AL, and the flat part FP may be a remaining part of the first protective layer PVX1 except for the bank part BP.

A first thickness TH1 of the flat part FP may be different from a second thickness TH2 of the bank part BP. In an embodiment, the second thickness TH2 of the bank part BP may be thicker than the first thickness TH1 of the flat part FP.

The opening OP' of the first protective layer PVX1 may have a first side surface S1_P1 and a second side surface S2_P1. The first side surface S1_P1 and the second side surface S2_P1 may face each other. In an embodiment, the second side surface S2_P1 of the opening OP' may have a step.

The second protective layer PVX2 may be disposed on the first protective layer PVX1. The second protective layer PVX2 may be entirely disposed on the display area DA and the pad area PA. The second protective layer PVX2 may include an inorganic material such as silicon oxide, silicon nitride, silicon oxynitride, and the like. These may be used alone or in combination with each other. The second protective layer PVX2 may have a single-layer structure or a multi-layered structure including a plurality of insulating layers. The first protective layer PVX1 and the second protective layer PVX2 may constitute a multilayered layer (or film) ML.

In an embodiment, in the display area DA, a first contact hole exposing at least a part of the upper surface of the second electrode CE2 and a third contact hole CNT3 exposing at least a part of the auxiliary power line AL may be formed in the second protective layer PVX2. In addition, in the pad area PA, a second contact hole exposing at least a part of the upper surface of the pad electrode PE may be defined in the second protective layer PVX2.

The first contact holes of the first and second protective layers PVX1 and PVX2 may be connected to each other, and the second contact holes of the first and second protective layers PVX1 and PVX2 may be connected to each other. In other words, the first contact hole MCNT1 exposing at least a part of the upper surface of the second electrode CE2 in the display area DA and the second contact hole MCNT2 exposing at least a part of the upper surface of the pad electrode PE in the pad area PA may be defined in the multilayered layer ML of the protective layer including the first protective layer PVX1 and the second protective layer PVX2.

The third contact hole CNT3 of the second protective layer PVX2 may have a first side surface S1_P2 and a second side surface S2_P2. The first side surface S1_P2 and the second side surface S2_P2 may face each other. In an embodiment, the first side surface S1_P2 of the third contact hole CNT3 may protrude more toward the center of the third contact hole CNT3 than the first side surface S1_P1 of the opening OP'. A part of the second protective layer PVX2 adjacent to the first side surface S1_P2 of the third contact hole CNT3 may be defined as a protrusion PP_P. In other words, an end part of the second protective layer PVX2 may include the protrusion PP_P protruding toward the center of the third contact hole CNT3.

The first side surfaces S1_P1 and S1_P2 may all face the same direction, and the second side surfaces S2_P1 and S2_P2 may all face the same direction.

In an embodiment, the protrusion PP_P of the second protective layer PVX2 may constitute an undercut shape UC' together with the first side surface S1_P1 of the opening OP' of the first protective layer PVX1. In other words, the undercut shape UC' may be defined by the protrusion PP_P of the second protective layer PVX2 and the first side surface S1_P1 of the opening OP' of the first protective layer PVX1. The undercut shape UC' may partially overlap with the auxiliary power line AL.

In an embodiment, a lower surface LS_P of the protrusion PP_P of the second protective layer PVX2 that does not contact the first protective layer PVX1 may have a curved shape. For example, the lower surface LS_P of the protrusion PP_P may have a convex curved shape toward the auxiliary power line AL. In another example, the lower surface LS_P of the protrusion PP_P may have a concave curved shape toward the auxiliary power line AL.

The via insulating layer VIA may be disposed on the second protective layer PVX2. For example, the via insulating layer VIA may include an organic material. In the display area DA, a first via contact hole VCNT1' connected to the first contact hole MCNT1 and a second via contact hole VCNT2' connected to the third contact hole CNT3 may be defined in the via insulating layer VIA. Accordingly, the first contact hole MCNT1 and the first via contact hole VCNT1' may constitute a first groove GV1', and the opening OP', the third contact hole CNT3, and the second via contact hole VCNT2' may constitute a second groove GV2'. The first groove GV1 ' may expose at least a part of the upper surface of the second electrode CE2. The second groove GV2' may expose at least a part of the upper surface of the auxiliary power line AL.

The pixel defining layer PDL may be disposed on the via insulating layer VIA and the pixel electrode PXE. The pixel defining layer PDL may cover at least a part of the pixel electrode PXE, and may extend into the second groove GV2 '. In other words, the pixel defining layer PDL may cover the second side surface S2_P1 of the opening OP' and the second side surface S2_P2 of the third contact hole CNT3.

The light emitting layer EL may be disposed on the via insulating layer VIA, the pixel electrode PXE, the pixel defining layer PDL, and the auxiliary power line AL, and may be disconnected by the undercut shape UC'. The common electrode CME may be disposed on the light emitting layer EL, and may be disconnected by the undercut shape UC'. The common electrode CME may directly contact the auxiliary power line AL.

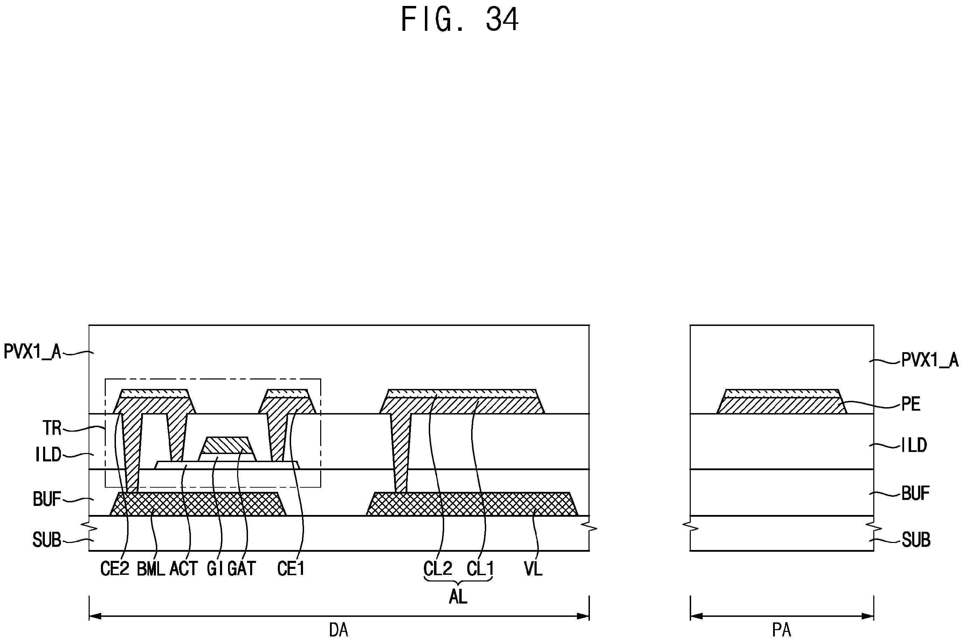

FIGS. 34 through 47 are cross-sectional views illustrating a method for manufacturing the display device of FIG. 32. Hereinafter, redundant description overlapping with that of the method for manufacturing the display device 100 described above with reference to FIGS. 6 through 24 may not be repeated or may be simplified.

Referring to FIG. 34, a first preliminary protective layer PVX1_A may be formed on the interlayer insulating layer ILD. The first preliminary protective layer PVX1_A may be entirely formed on the display area DA and the pad area PA. For example, the first preliminary protective layer PVX1_A may be formed using silicon oxide, silicon nitride, silicon oxynitride, and/or the like.

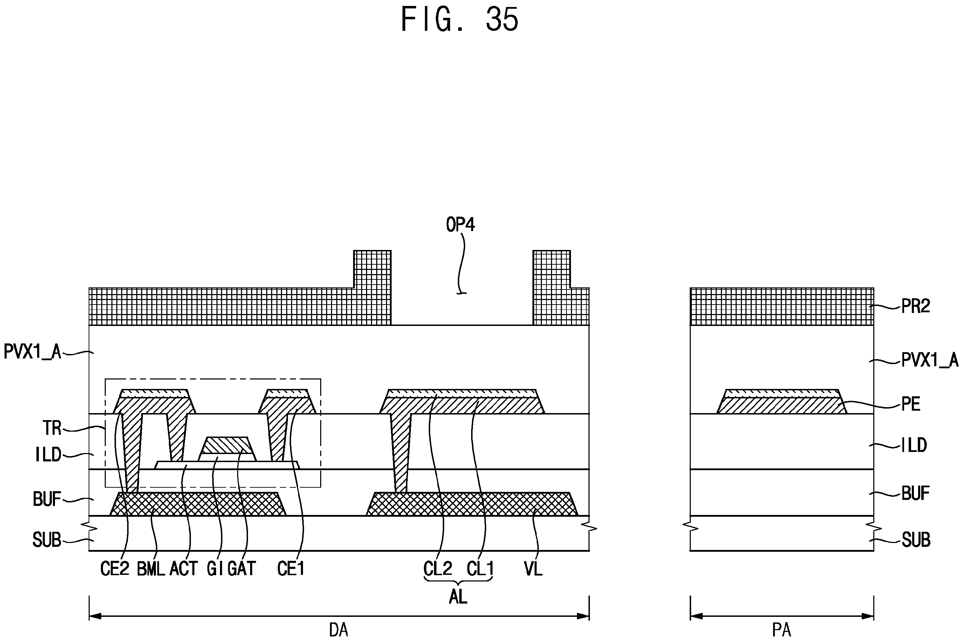

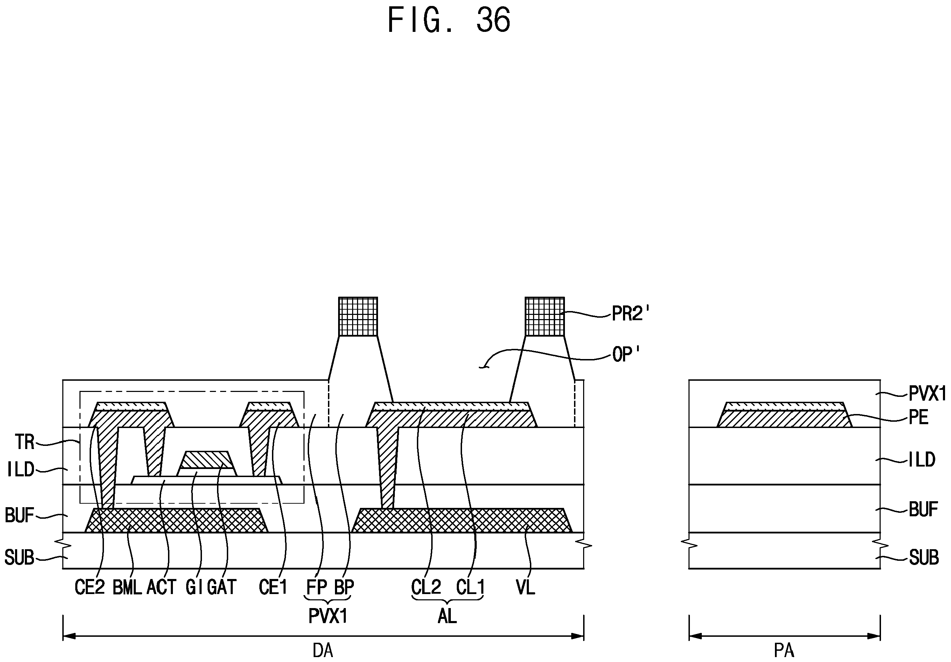

Referring to FIGS. 35 and 36, a second photosensitive organic layer PR2 may be formed on the first preliminary protective layer PVX1_A. For example, the second photosensitive organic layer PR2 may be formed using a photoresist. In an embodiment, the second photosensitive organic layer PR2 may be formed by exposing and developing the photoresist through a halftone mask. Accordingly, in the display area DA, a fourth opening OP4 exposing a part of an upper surface of the first preliminary protective layer PVX1_A may be formed in the second photosensitive organic layer PR2.

Through a first etching process, the opening OP' may be formed by removing a part of the first preliminary protective layer PVX1_A overlapping with the fourth opening OP4. In this case, the relatively thinner first part of the second photosensitive organic layer PR2 may be removed together, and a part of the relatively thicker second part of the second photosensitive organic layer PR2 may be removed. Accordingly, the first protective layer PVX1 including the flat part FP and the bank part BP and defining the opening OP' exposing at least a part of the upper surface of the auxiliary power line AL may be formed. The flat part FP may be formed by removing a part of the first preliminary protective layer PVX1_A corresponding to the first part of the second photosensitive organic layer PR2, and the bank part BP may be formed with the first preliminary protective layer PVX1_A corresponding to the second part of the second photosensitive organic layer PR2 remaining. In an embodiment, the first etching process may be a dry etching process.

After performing the first etching process, a second photosensitive organic pattern PR2' may formed by removing a part of the second part of the second photosensitive organic layer PR2. The second photosensitive organic pattern PR2' may be formed on the bank part BP of the second protective layer PVX2.

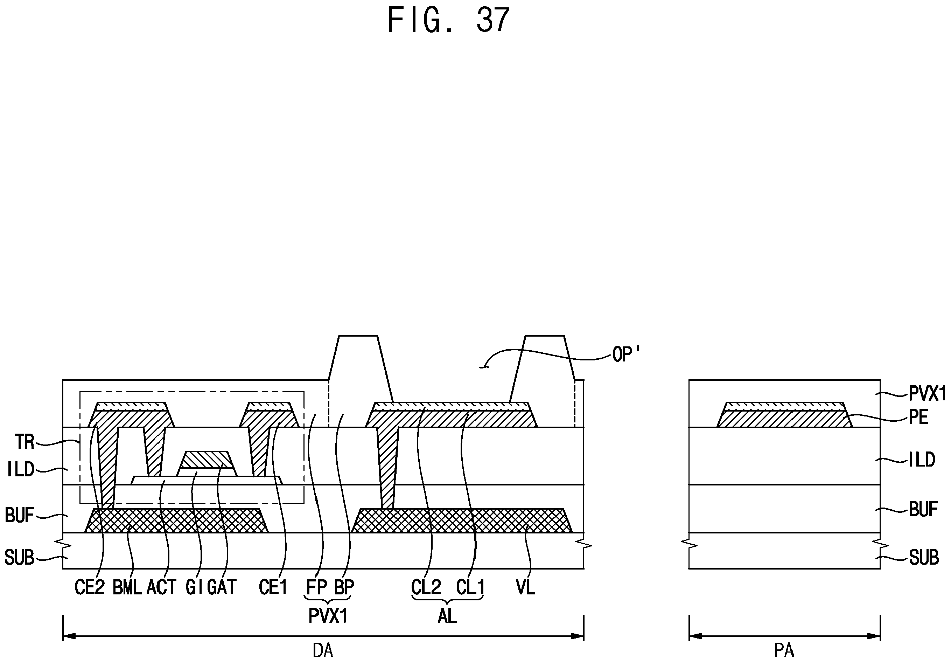

Referring to FIG. 37, the second photosensitive organic pattern PR2' may be removed. In an embodiment, the second photosensitive organic pattern PR2' may be removed through an ashing process.

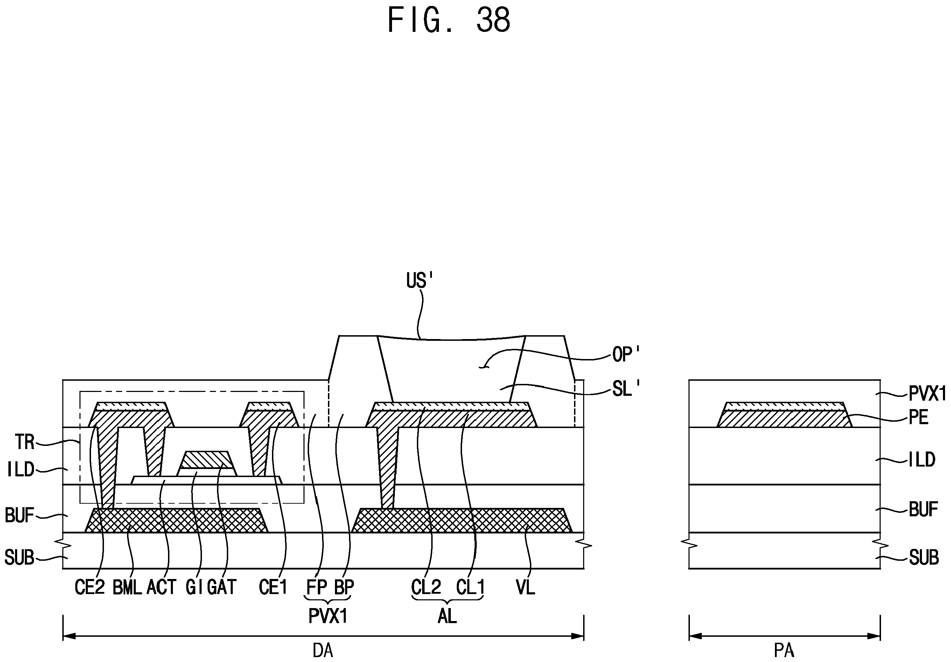

Referring to FIG. 38, in an embodiment, a sacrificial layer SL' may be filled inside of the opening OP' of the first protective layer PVX1. For example, the sacrificial layer SL' may be formed using an organic material.

In an embodiment, an ashing rate of the sacrificial layer SL' relative to a plasma gas used in an ashing process for removing the sacrificial layer SL' may be greater than an ashing rate of the second protective layer PVX2. In other words, the sacrificial layer SL' may be formed using an organic material having a higher ashing rate than that of the second protective layer PVX2.

In an embodiment, an upper surface US' of the sacrificial layer SL' may have a curved shape due to a meniscus phenomenon. For example, the upper surface US' of the sacrificial layer SL' may have a concave curved shape. As another example, the upper surface US' of the sacrificial layer SL' may have a convex curved shape.

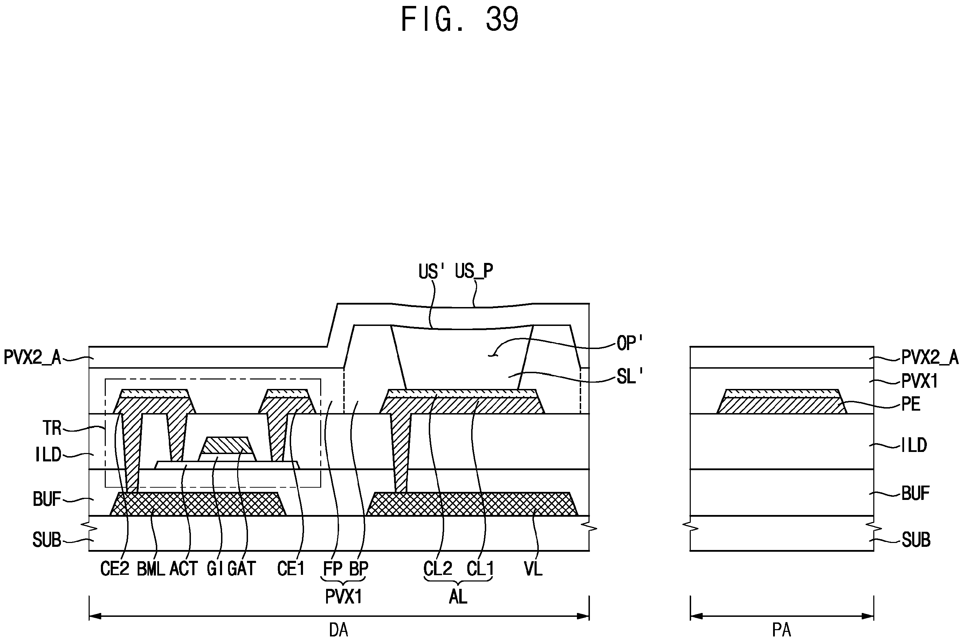

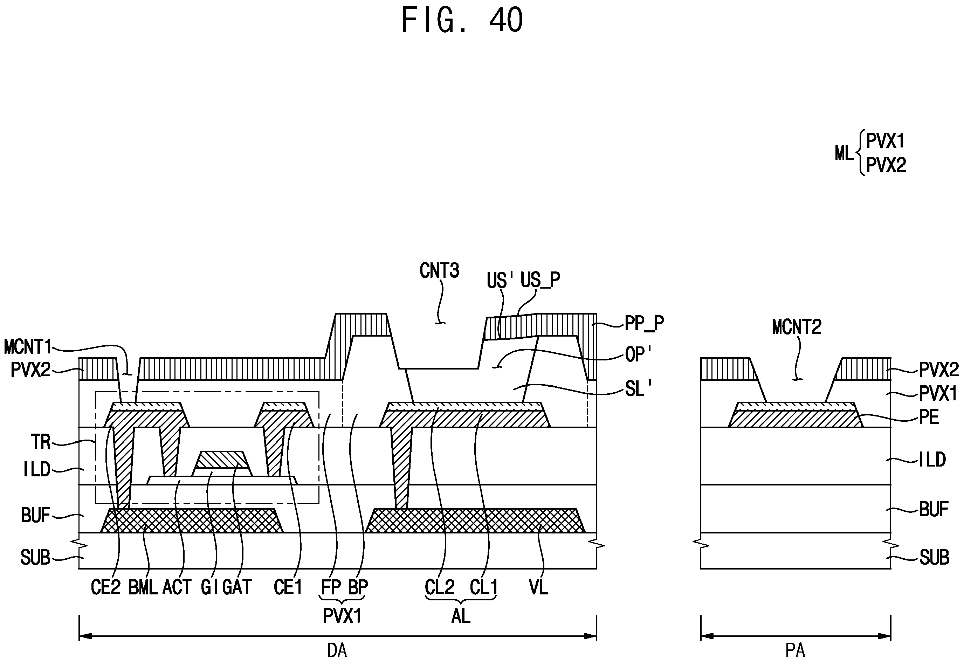

Referring to FIGS. 39 and 40, a second preliminary protective layer PVX2_A may be formed on the first protective layer PVX1 and the sacrificial layer SL'. The second preliminary protective layer PVX2_A may be entirely formed on the display area DA and the pad area PA. For example, the second preliminary protective layer PVX2_A may be formed using silicon oxide, silicon nitride, silicon oxynitride, and/or the like.

In the display area DA, the first contact hole MCNT1 exposing at least a part of the upper surface of the second electrode CE2 by removing a part of the first protective layer PVX1 and the second preliminary protective layer PVX2_A may be formed through a second etching process. In the pad area PA, the second contact hole MCNT2 exposing at least a part of the pad electrode PE by removing a part of the first protective layer PVX1 and the second preliminary protective layer PVX2_A may be formed through the second etching process. Accordingly, the second protective layer PVX2 may be formed on the first protective layer PVX1, and the first and second protective layers PVX1 and PVX2 may constitute the multilayered layer ML. The first contact hole MCNT1 and the second contact hole MCNT2 may be formed in the multilayered layer ML.

In an embodiment, a part of each of the second preliminary protective layer PVX2_A and the sacrificial layer SL' may be removed in the display area DA through the second etching process. The third contact hole CNT3 may be formed by removing a part of the second preliminary protective layer PVX2_A. In other words, the third contact hole CNT3 may be formed in the second protective layer PVX2. The third contact hole CNT3 may expose at least a part of the upper surface of the sacrificial layer SL'.

Through the second etching process, a part (e.g., only a part) of an upper part of the sacrificial layer SL' may be removed. In this case, even a part of one side surface of the first protective layer PVX1 may be removed. Accordingly, a step may be formed on the one side surface (i.e., the second side surface S1_P1 of the opening OP' in FIG. 32) of the first protective layer PVX1.

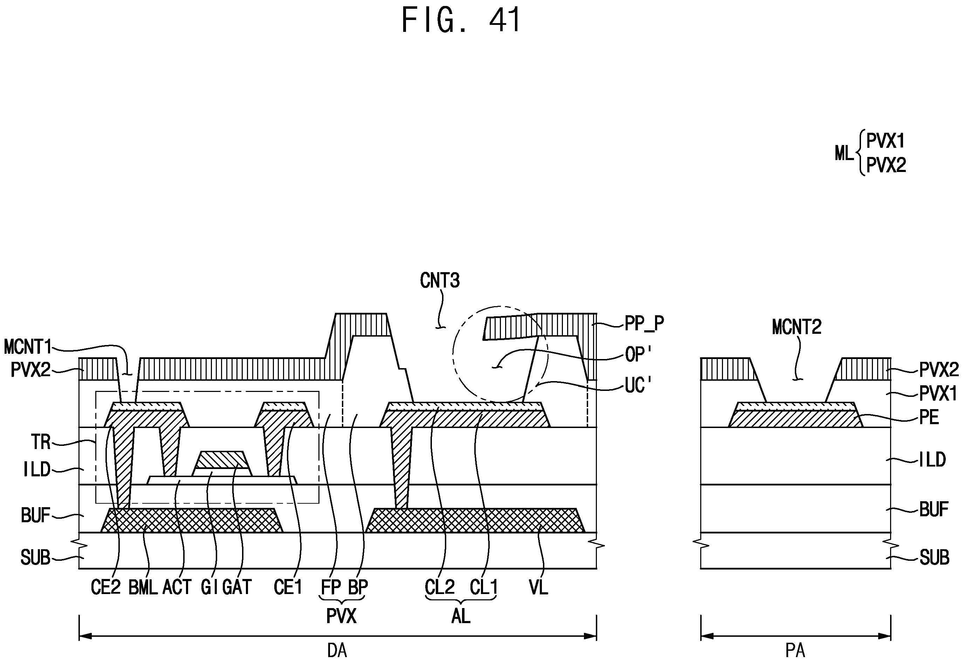

Referring to FIG. 41, the sacrificial layer SL' may be removed. In an embodiment, the sacrificial layer SL' may be removed through an ashing process. In this case, the second protective layer PVX2 may not be removed.

The opening OP' may have the first side surface S1_P1 and the second side surface S2_P1, and the third contact hole CNT3 may have the first side surface S1_P2 and the second side surface S2_P2 (e.g., see FIG. 33). As the sacrificial layer SL' is removed, a part of the second protective layer PVX2 may protrude toward the center of the third contact hole CNT3. The end part of the second protective layer PVX2 may include the protrusion PP_P protruding toward the center of the third contact hole CNT3. As the second protective layer PVX2 includes the protrusion PP_P, the protrusion PP_P of the second protective layer PVX2 may form the undercut shape UC' together with the first side surface S1_P1 of the opening OP'.

In an embodiment, as the upper surface US' of the sacrificial layer SL' has a curved shape, the lower surface LS' of the protrusion PP_P contacting the upper surface US' of the sacrificial layer SL' may also have a curved shape. For example, the lower surface LS' of the protrusion PP_P may have a convex curved shape toward the auxiliary power line AL.

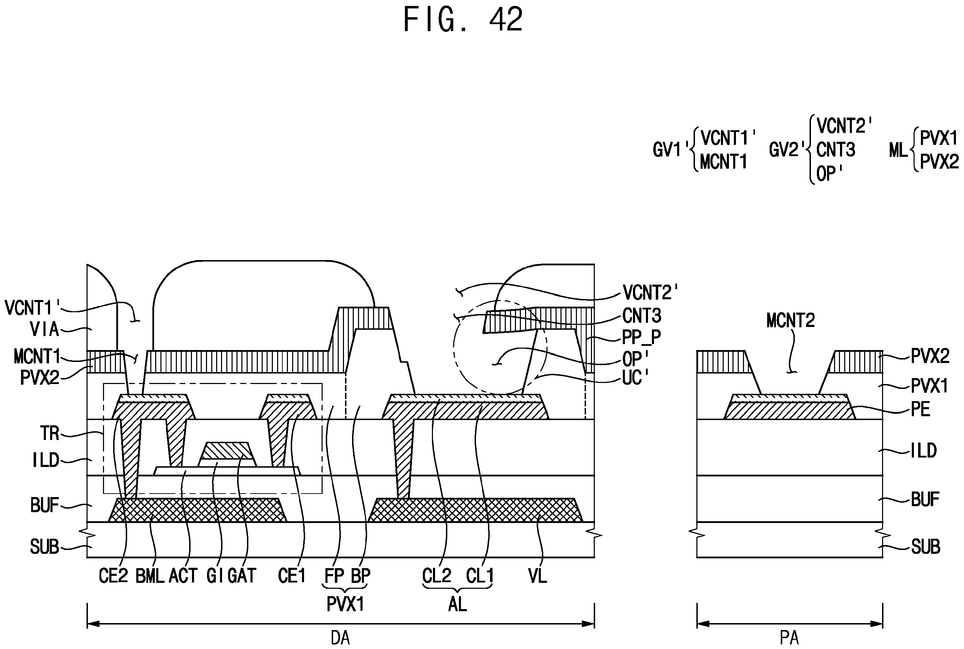

Referring to FIG. 42, the via insulating layer VIA may be formed in the display area DA on the second protective layer PVX2. The first via contact hole VCNT1' connected to the first contact hole MCNT1 and the second via contact hole VCNT2' connected to the third contact hole CNT3 may be formed in the via insulating layer VIA.

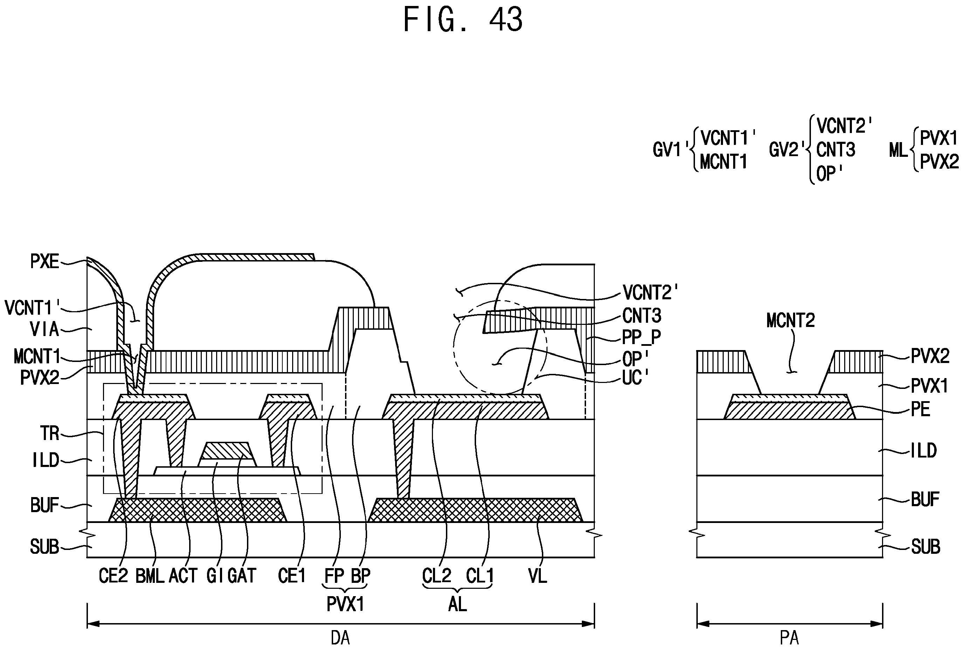

Referring to FIG. 43, the pixel electrode PXE may be formed on the via insulating layer VIA. The pixel electrode PXE may be connected to the second electrode CE2 through the first groove GV1'.

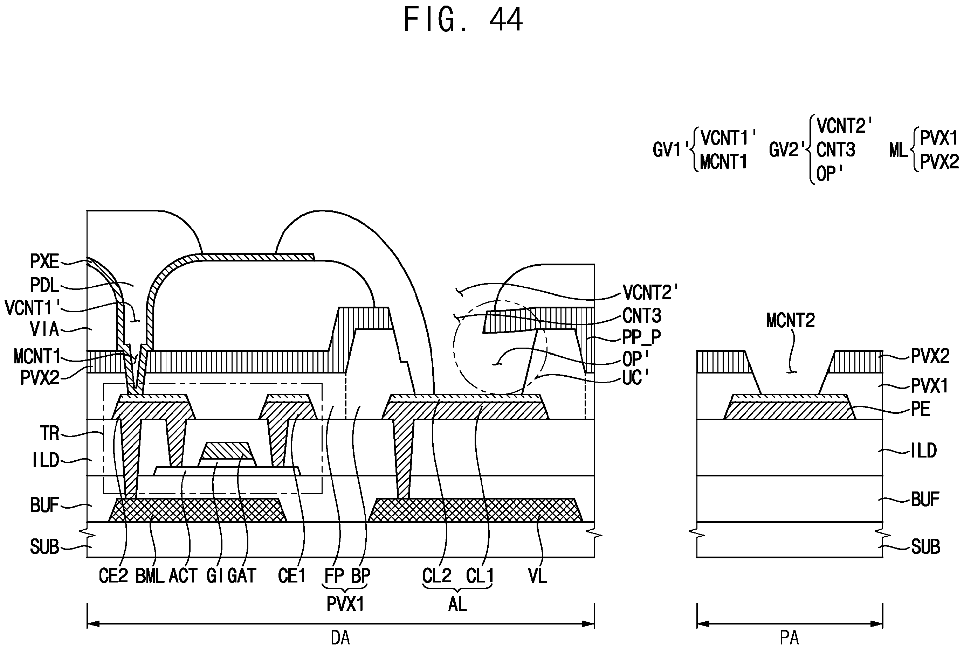

Referring to FIG. 44, the pixel defining layer PDL may be formed on the via insulating layer VIA. In more detail, the pixel defining layer PDL may be formed to cover at least a part of the pixel electrode PXE and extend to into the second groove GV2'.

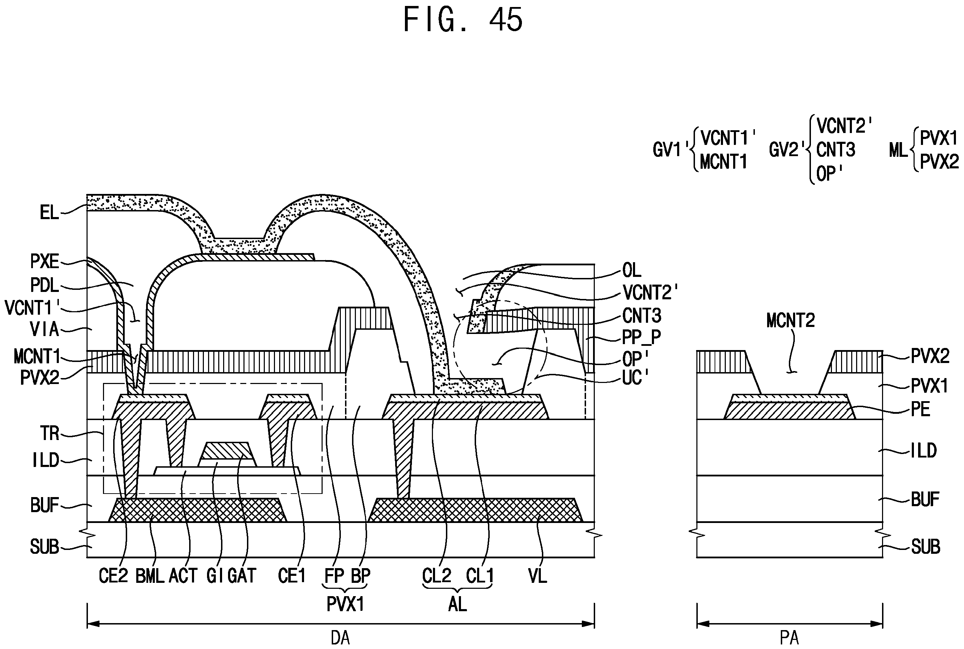

Referring to FIG. 45, the light emitting layer EL may be formed on the pixel defining layer PDL, the via insulating layer VIA, the pixel electrode PXE, and the auxiliary power line AL. The light emitting layer EL may be formed on the entire surface of the display area DA. The light emitting layer EL may be disconnected by the undercut shape UC.

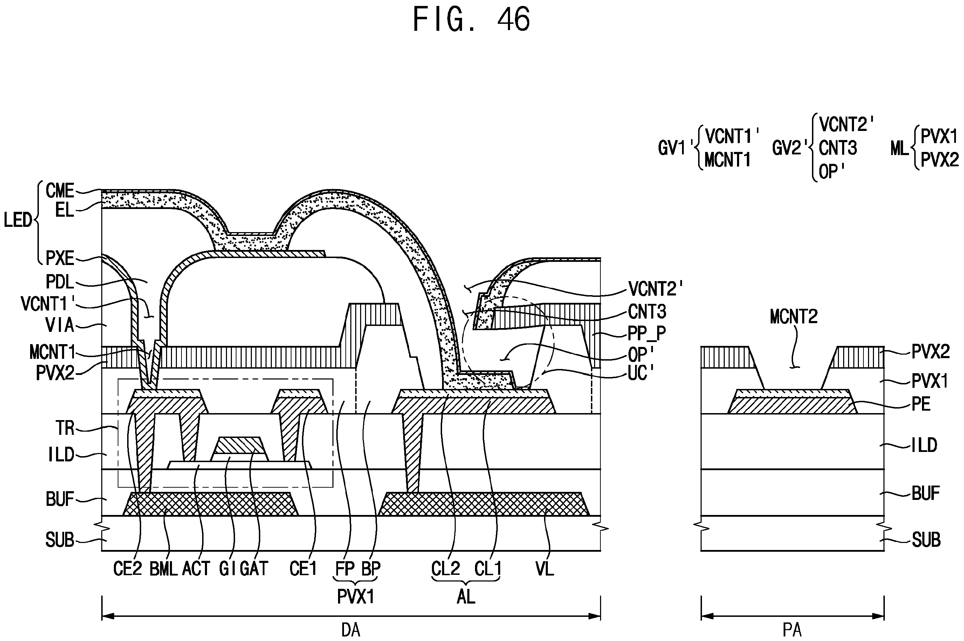

Referring to FIG. 46, the common electrode CME may be formed on the light emitting layer EL. The common electrode CME may be formed on the entire surface of the display area DA. The common electrode CME may be disconnected by the undercut shape UC. For example, the common electrode CME may directly contact a part of the upper surface of the auxiliary power line AL.

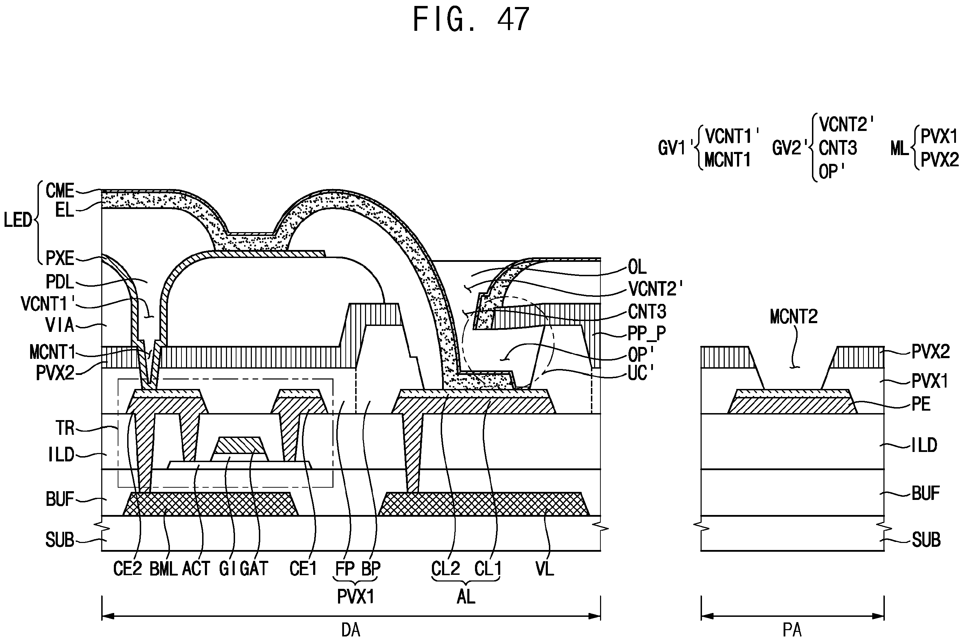

Referring to FIG. 47, the organic layer OL may fill the inside of the undercut shape UC. In more detail, the organic layer OL may fill an empty space of the second groove GV2'. In other words, the organic layer OL may fill the empty space between the auxiliary power line AL and the protrusion PP_P of the second protective layer PVX2.

Referring back to FIG. 32, the encapsulation layer ENC may be formed in the display area DA on the common electrode CME.

Accordingly, the display device 120 illustrated in FIGS. 32 and 33 may be manufactured.

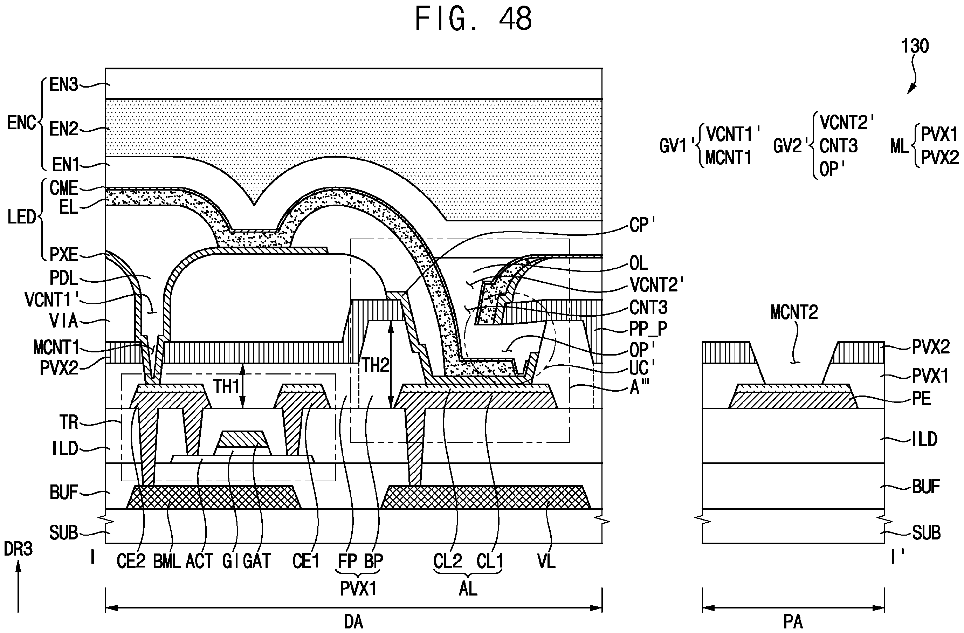

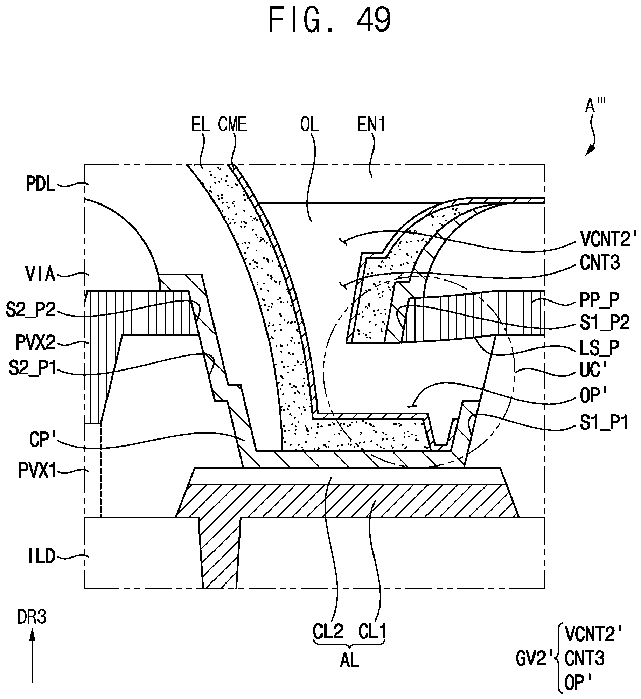

FIG. 48 is a cross-sectional view illustrating a display device according to another embodiment of the present disclosure. FIG. 49 is an enlarged cross-sectional view of the area A‴ of FIG. 48.

Referring to FIGS. 48 and 49, a display device 130 according to another embodiment of the present disclosure may include the substrate SUB, the lower metal layer BML, the power line VL, the buffer layer BUF, the gate insulating layer GI, the interlayer insulating layer ILD, the transistor TR, the pad electrode PE, the auxiliary power line AL, the first protective layer PVX1, the second protective layer PVX2, the via insulating layer VIA, the light emitting element LED, a cover pattern CP', the pixel defining layer PDL, the organic layer OL, and the encapsulation layer ENC. The display device 130 described in more detail hereinafter with reference to FIGS. 48 and 49 may be the same or substantially the same as (or similar to) the display device 120 described above with reference to FIGS. 32 and 33, except that the display device 130 may further include the cover pattern CP'. Accordingly, redundant description thereof may not be repeated or may be simplified.

In an embodiment, the cover pattern CP' may be disposed on the auxiliary power line AL and the via insulating layer VIA. In more detail, the cover pattern CP' may directly contact a part of the upper surface of the auxiliary power line AL. The cover pattern CP' may include the same material as that of the pixel electrode PXE. The cover pattern CP' may be disconnected by the protrusion PP_P of the second protective layer PVX2. In other words, the cover pattern CP' may be disconnected by the undercut shape UC'.

In an embodiment, the cover pattern CP' may extend to the second side surface S2_P1 of the opening OP' of the first protective layer PVX1 and the second side surface S2_P2 of the third contact hole CNT3 of the second protective layer PVX2. In addition, the cover pattern CP' may extend to at least a part of the first side surface S1_P1 of the opening OP' of the first protective layer PVX1.

The common electrode CME may be electrically connected to the auxiliary power line AL through the cover pattern CP'. In other words, the common electrode CME may not directly contact the auxiliary power line AL.

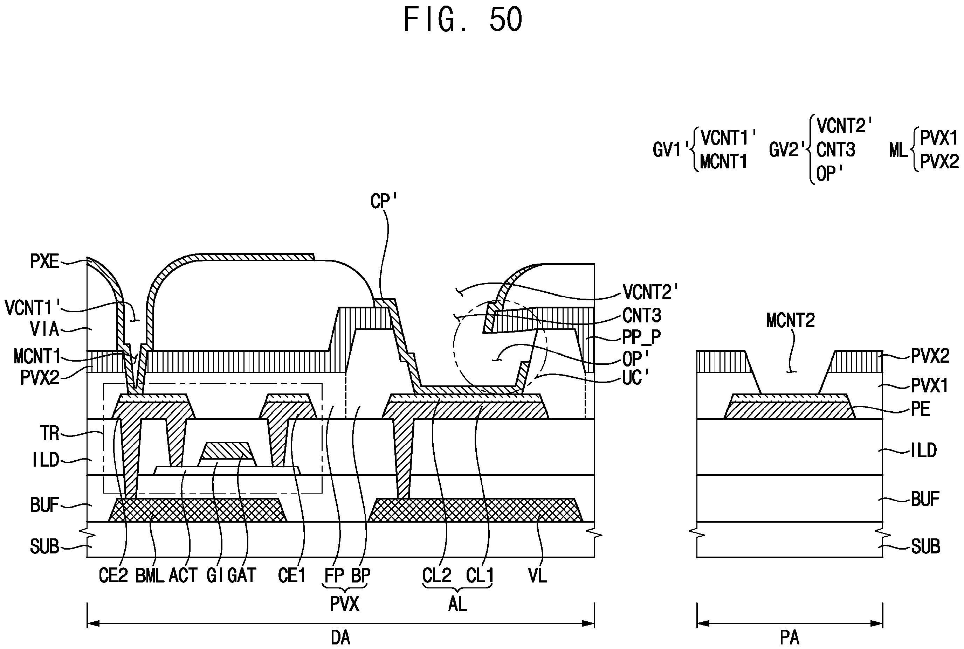

FIGS. 50, 51, and 52 are cross-sectional views illustrating a method for manufacturing the display device of FIG. 49.

Referring to FIG. 50, the pixel electrode PXE may be formed on the via insulating layer VIA. The pixel electrode PXE may be connected to the second electrode CE2 through the first groove GV1'.

The cover pattern CP' may be formed on the auxiliary power line AL and the via insulating layer VIA. The cover pattern CP' may be concurrently (e.g., simultaneously or substantially simultaneously) formed through the same process as that of the pixel electrode PXE. In other words, the cover pattern CP' may be formed using the same material as that of the pixel electrode PXE. The cover pattern CP' may be disconnected by the undercut shape UC'. In addition, the cover pattern CP' may directly contact the upper surface of the auxiliary power line AL.

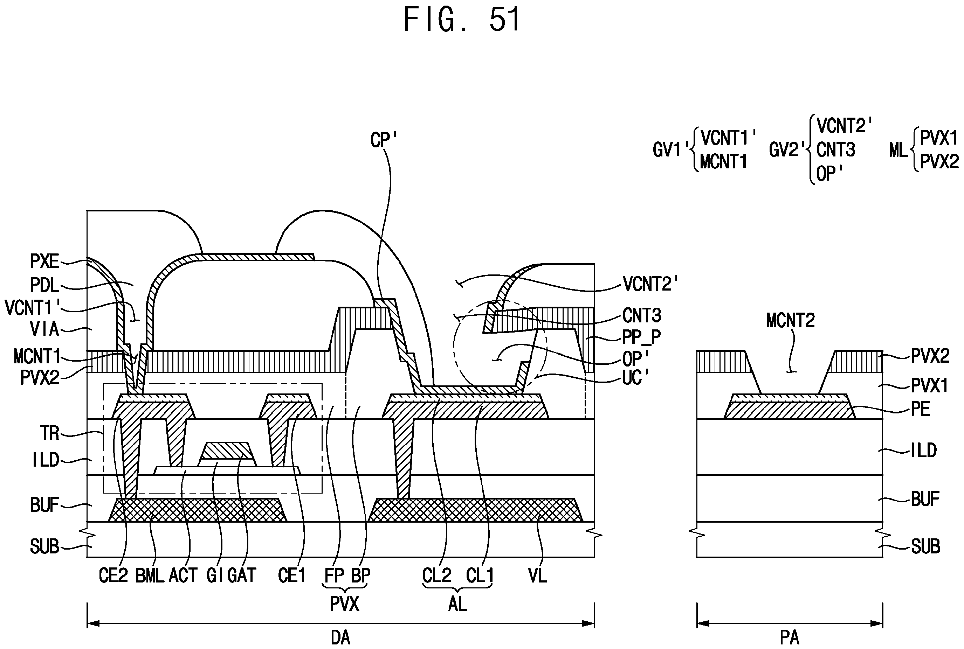

Referring to FIG. 51, the pixel defining layer PDL may be formed on the via insulating layer VIA. In more detail, the pixel defining layer PDL may cover at least a part of each of the pixel electrode PXE and the cover pattern CP', and may extend into the second groove GV2'.

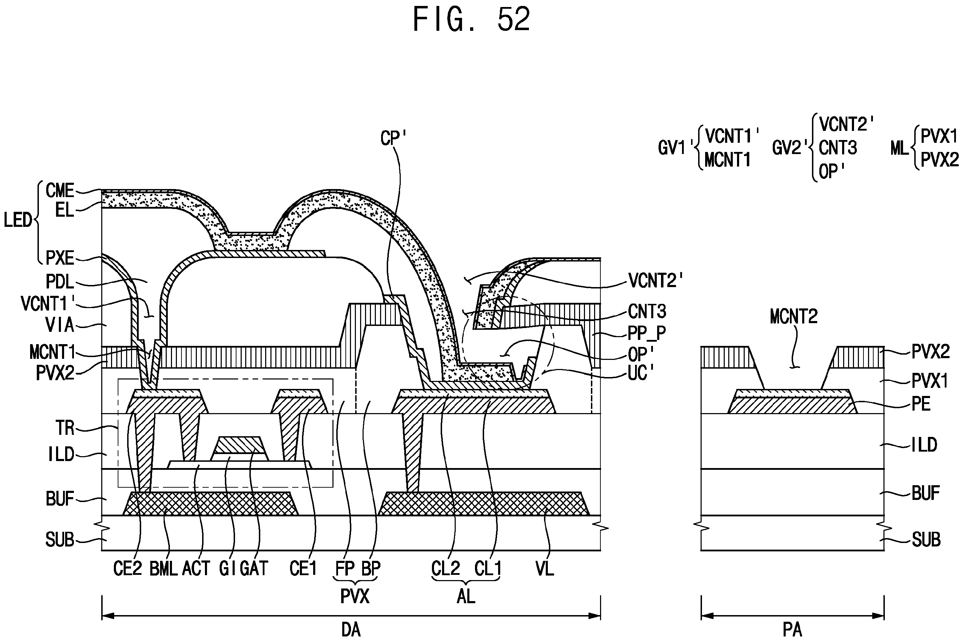

Referring to FIG. 52, the light emitting layer EL may be formed on the pixel defining layer PDL, the via insulating layer VIA, the pixel electrode PXE, and the cover pattern CP'. The light emitting layer EL may be formed on the entire surface of the display area DA. The light emitting layer EL may be disconnected by the undercut shape UC'. The light emitting layer EL may directly contact the upper surface of the cover pattern CP'.

The common electrode CME may be formed on the light emitting layer EL. The common electrode CME may be formed on the entire surface of the display area DA. The common electrode CME may be disconnected by the undercut shape UC'. For example, the common electrode CME may directly contact a part of the cover pattern CP'.

Referring back to FIG. 48, the organic layer OL may fill the inside of the undercut shape UC'. In more detail, the organic layer OL may fill the empty space of the second groove GV2'. The encapsulation layer ENC may be formed in the display area DA on the common electrode CME and the organic layer OL.

Accordingly, the display device 130 illustrated in FIGS. 48 and 49 may be manufactured.

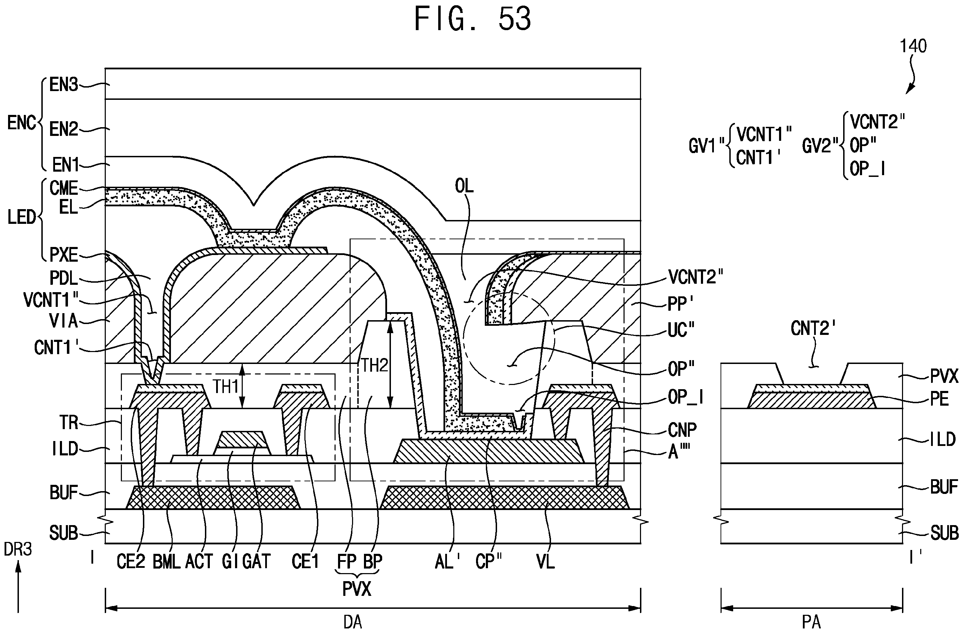

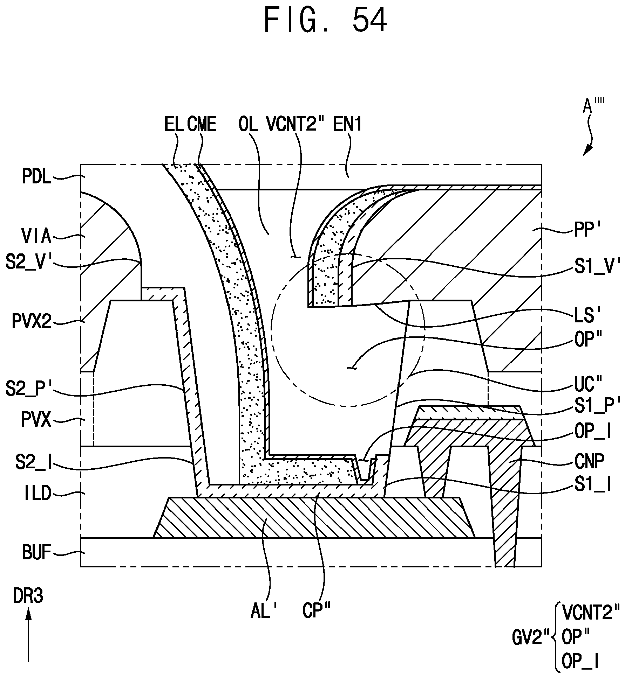

FIG. 53 is a cross-sectional view illustrating a display device according to another embodiment of the present disclosure. FIG. 54 is an enlarged cross-sectional view of the area Aʺʺ of FIG. 53.

Referring to FIGS. 53 and 54, a display device 140 according to another embodiment of the present disclosure may include the substrate SUB, the lower metal layer BML, the power line VL, the buffer layer BUF, the gate insulating layer GI, the interlayer insulating layer ILD, the transistor TR, an auxiliary power line AL', a connection pattern CNP, the pad electrode PE, the protective layer PVX, the via insulating layer VIA, the light emitting element LED, a cover pattern CP", the pixel defining layer PDL, the organic layer OL, and the encapsulation layer ENC. The display device 140 described in more detail hereinafter with reference to FIGS. 53 and 54 may be the same or substantially the same as (or similar to) the display device 100 described above with reference to FIGS. 4 and 5, except for the auxiliary power line AL', the connection pattern CNP, the interlayer insulating layer ILD, and the cover pattern C". Accordingly, redundant description thereof may not be repeated or may be simplified.

The auxiliary power line AL' may be disposed in the display area DA on the buffer layer BUF. The common voltage (e.g., the common voltage ELVSS of FIGS. 2 and 3) may be applied to the auxiliary power line AL' through the power line VL. The auxiliary power line AL' may include the same material as that of the gate electrode GAT.

The connection pattern CNP may be disposed in the display area DA on the interlayer insulating layer ILD. The connection pattern CNP may be connected to the power line VL through a contact hole penetrating the interlayer insulating layer ILD and the buffer layer BUF. In addition, the connection pattern CNP may be connected to the auxiliary power line AL' through a contact hole penetrating the interlayer insulating layer ILD. Accordingly, the power line VL and the auxiliary power line AL' may be electrically connected to each other through the connection pattern CNP. The connection pattern CNP may include the same material as that of the first and second electrodes CE1 and CE2, and may be disposed in the same layer as that of the first and second electrodes CE1 and CE2.

The interlayer insulating layer ILD may cover an edge of the auxiliary power line AL'. In an embodiment, an opening OP_I exposing at least a part of an upper surface of the auxiliary power line AL' may be defined in the interlayer insulating layer ILD. The opening OP_I of the interlayer insulating layer ILD may have a first side surface S1_I and a second side surface S2_I. The first side surface S1_I and the second side surface S2_I may face each other.

The protective layer PVX may be disposed on the interlayer insulating layer ILD. For example, the protective layer PVX may include an inorganic material, such as silicon oxide, silicon nitride, silicon oxynitride, and/or the like. These inorganic materials may be used alone or in any suitable combination with each other. The protective layer PVX may have a single-layer structure or a multi-layered structure including a plurality of insulating layers.

In an embodiment, in the display area DA, a first contact hole CNT1 ' exposing at least a part of the upper surface of the second electrode CE2 and an opening OP" exposing at least a part of the upper surface of the auxiliary power line AL' may be defined in the protective layer PVX. In addition, in the pad area PA, a second contact hole CNT2 ' exposing at least a part of an upper surface of the pad electrode PE may be defined in the protective layer PVX. The opening OP" of the protective layer PVX may be connected to the opening OP_I of the interlayer insulating layer ILD.

The opening OP" of the protective layer PVX may have a first side surface S1_P' and a second side surface S2_P'. The first side surface S1_P' and the second side surface S2_P' may face each other.

In an embodiment, the protective layer PVX may include a flat part FP and a bank part BP. The bank part BP may cover an edge of the auxiliary power line AL', and the flat part FP may be a remaining part of the protective layer PVX except for the bank part BP.

A first thickness TH1 of the flat part FP may be different from a second thickness TH2 of the bank part BP. In an embodiment, the second thickness TH2 of the bank part BP may be thicker than the first thickness TH1 of the flat part FP.

The via insulating layer VIA may be disposed in the display area DA on the protective layer PVX. The via insulating layer VIA may include an organic material. In an embodiment, in the display area DA, a first via contact hole VCNT1" connected to the first contact hole CNT1' and a second via contact hole VCNT2" connected to the opening OP" may be defined in the via insulating layer VIA. Accordingly, the first contact hole CNT1' and the first via contact hole VCNT1" may constitute a first groove GV1", and the openings OP_I and OP" and the second via contact hole VCNT2" may constitute a second groove GV2". The first groove GV1" may expose at least a part of the upper surface of the second electrode CE2. The second groove GV2" may expose at least a part of the upper surface of the auxiliary power line AL'.

The second via contact hole VCNT2" of the via insulating layer VIA may have a first side surface S1_V' and a second side surface S2_V'. The first side surface S1_V' and the second side surface S2_V' may face each other. In an embodiment, the first side surface S1_V' of the second via contact hole VCNT2" may protrude more toward the center of the second groove GV2" than the first side surfaces S1_I and S1_P' of the openings OP_I and OP".

A part of the via insulating layer VIA adjacent to the first side surface S1_V' of the second via contact hole VCNT2" may be defined as a protrusion PP'. In other words, the end part of the via insulating layer VIA may include the protrusion PP' protruding toward the center of the second via contact hole VCNT2".

The first side surfaces S1_I, S1_P', and S1_V' may all face the same direction, and the second side surfaces S2_I, S2_P', and S2_V' may all face the same direction.

In an embodiment, the protrusion PP' of the via insulating layer VIA may constitute an undercut shape UC" together with the first side surface S1_I of the opening OP_I of the interlayer insulating layer ILD and the first side surface S1_P' of the opening OP" of the protective layer PVX. In other words, the undercut shape UC" may be defined by the protrusion PP' of the via insulating layer VIA, the first side surface S1_I of the opening OP_I of the interlayer insulating layer ILD, and the first side surface S1_P' of the opening OP" of the protective layer PVX. The undercut shape UC" may partially overlap with the auxiliary power line AL'.

In an embodiment, the lower surface LS' of the protrusion PP' that does not contact the protective layer PVX may have a curved shape. For example, the lower surface LS' of the protrusion PP' may have a convex curved shape toward the auxiliary power line AL'. As another example, the lower surface LS' of the protrusion PP' may have a concave curved shape toward the auxiliary power line AL'.

In an embodiment, the cover pattern CP" may be disposed on the auxiliary power line AL' and the via insulating layer VIA. In more detail, the cover pattern CP" may directly contact a part of the upper surface of the auxiliary power line AL'. When the auxiliary power line AL' includes copper (Cu), the cover pattern CP" may prevent or substantially prevent the copper included in the auxiliary power line AL' from being oxidized.

The cover pattern CP" may include the same material as that of the pixel electrode PXE. The cover pattern CP" may be disconnected by the protrusion PP' of the via insulating layer VIA. In other words, the cover pattern CP" may be disconnected by the undercut shape UC".

In an embodiment, the cover pattern CP" may extend to the second side surface S2_I of the opening OP_I of the interlayer insulating layer ILD and the second side surface S2_P' of the opening OP" of the protective layer PVX. In addition, the cover pattern CP" may extend to at least a part of the first side surface S1_P' of the opening OP" of the protective layer PVX.

The common electrode CME may be electrically connected to the auxiliary power line AL' through the cover pattern CP". In other words, the common electrode CME may not directly contact the auxiliary power line AL'.

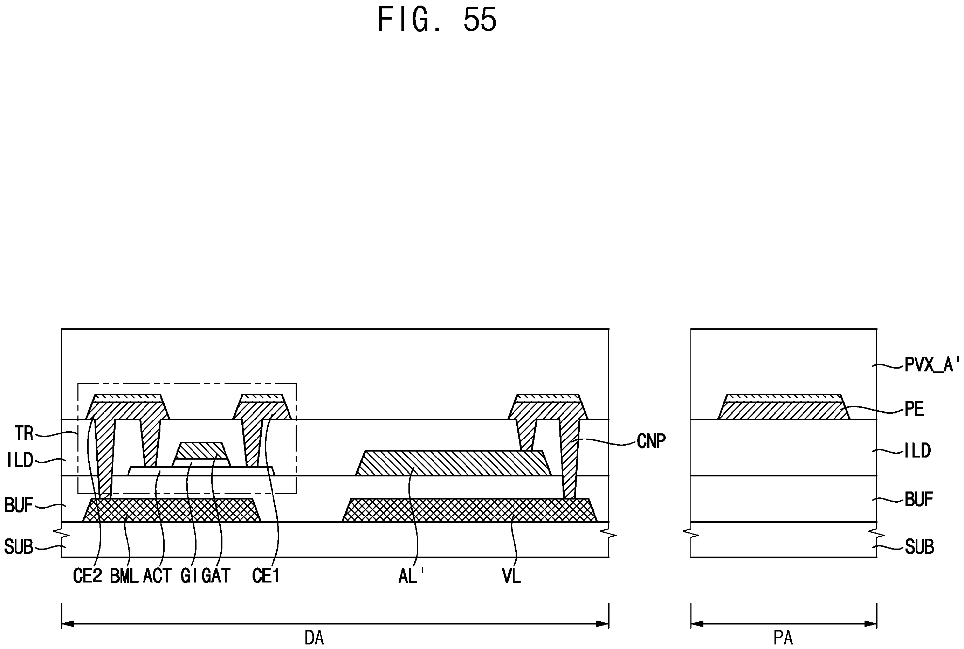

FIGS. 55 through 65 are cross-sectional views illustrating a method for manufacturing the display device of FIG. 53. Hereinafter, redundant description overlapping with the method for manufacturing the display device 100 described above with reference to FIGS. 6 through 24 may not be repeated or may be simplified.

Referring to FIG. 55, a preliminary protective layer PVX_A' may be formed on the interlayer insulating layer ILD. The preliminary protective layer PVX_A' may be entirely formed on the display area DA and the pad area PA. For example, the preliminary protective layer PVX_A' may be formed using silicon oxide, silicon nitride, silicon oxynitride, and/or the like.

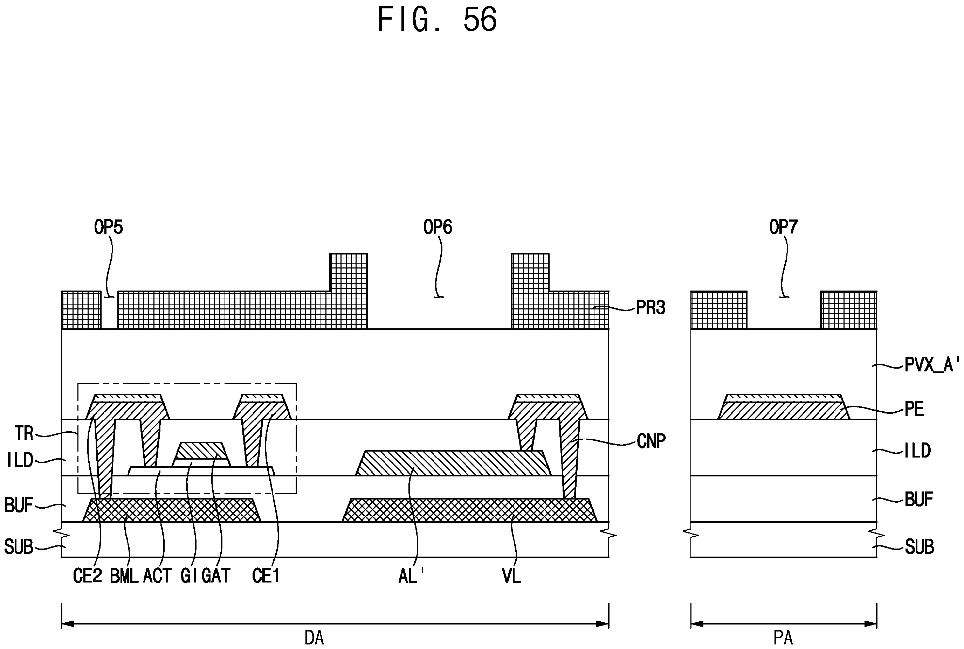

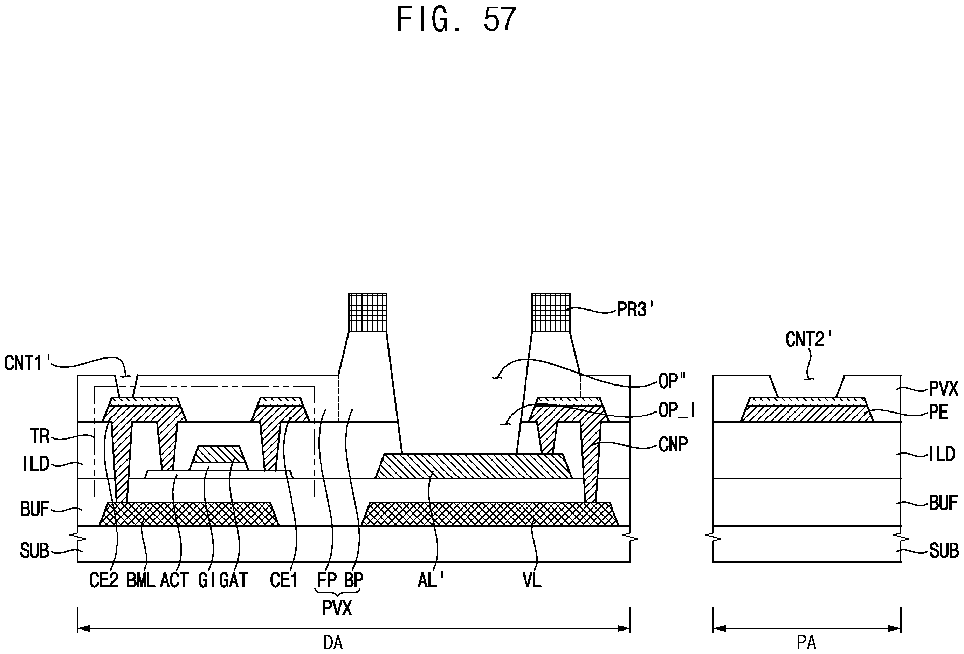

Referring to FIGS. 56 and 57, a third photosensitive organic layer PR3 may be formed on the preliminary protective layer PVX_A'. For example, the third photosensitive organic layer PR3 may be formed using a photoresist. In and embodiment, the third photosensitive organic layer PR3 may be formed by exposing and developing the photoresist through a halftone mask. Accordingly, in the display area DA, a fifth opening OP5 and a sixth opening OP6 exposing a part of an upper surface of the preliminary protective layer PVX_A' may be formed in the third photosensitive organic layer PR3. In addition, in the pad area PA, a seventh opening OP7 exposing a part of an upper surface of the preliminary protective layer PVX_A' may be formed in the third photosensitive organic layer PR3.

Through an etching process, the first contact hole CNT1' may formed by removing a part of the preliminary protective layer PVX_A' overlapping with the fifth opening OP5, the openings OP_I and OP" may formed by removing a part of the preliminary protective layer PVX_A' overlapping with the sixth opening OP6, and the second contact hole CNT2' may be formed by removing a part of the preliminary protective layer PVX_A' overlapping with the seventh opening OP7. In this case, the relatively thinner first part of the third photosensitive organic layer PR3 may be removed together, and a part of the relatively thicker second part of the third photosensitive organic layer PR3 may be removed. Accordingly, the protective layer PVX including the flat part FP and the bank part BP, and defining the first contact hole CNT1', the opening OP", and the second contact hole CNT'2' may be formed. In addition, the opening OP_I may be formed in the interlayer insulating layer ILD. The flat part FP may be formed by removing a part of the preliminary protective layer PVX_A' corresponding to the first part of the third photosensitive organic layer PR3, and the bank part BP may be formed with the preliminary protective layer PVX_A' corresponding to the second part of the third photosensitive organic layer PR3 remaining. In an embodiment, the etching process may be a dry etching process.

After performing the etching process, a third photosensitive organic pattern PR3' may be formed by removing a part of the second part of the third photosensitive organic layer PR3. The third photosensitive organic pattern PR3' may be formed on the bank part BP of the protective layer PVX.

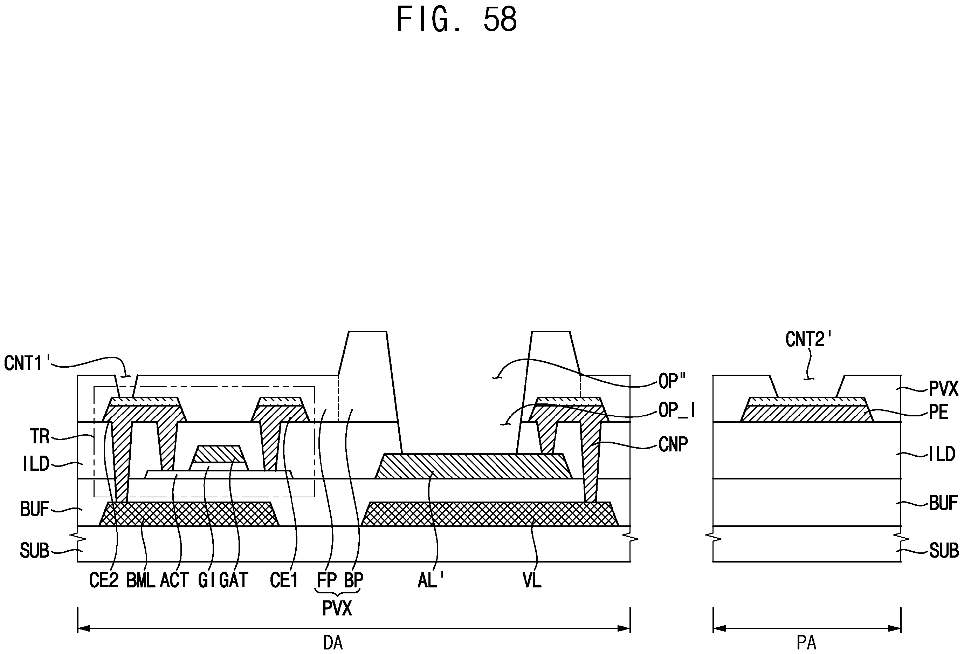

Referring to FIG. 58, the third photosensitive organic pattern PR3' may be removed. In an embodiment, the third photosensitive organic pattern PR3' may be removed through an ashing process.

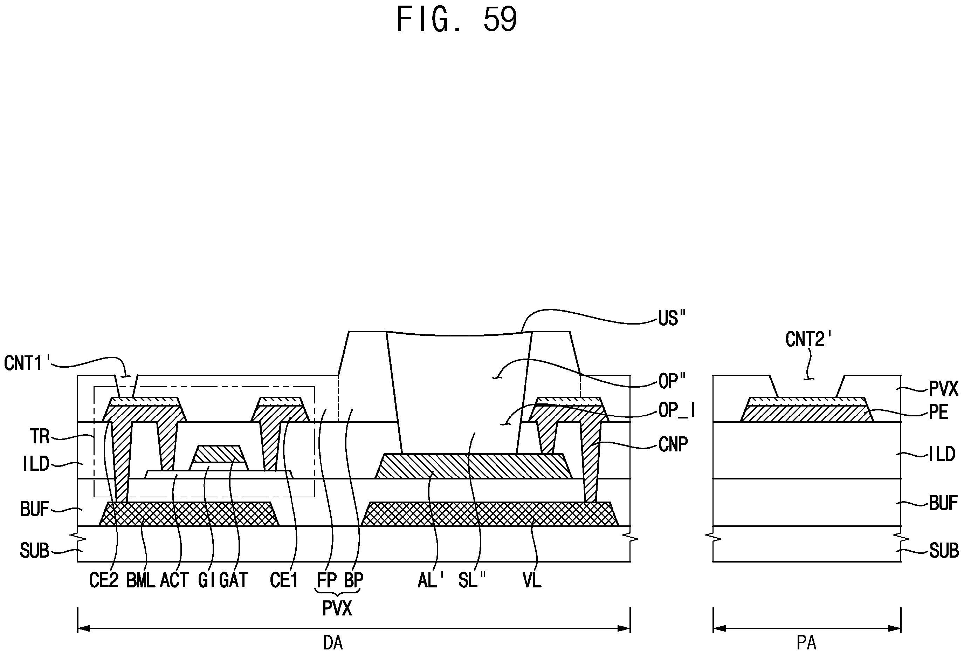

Referring to FIG. 59, in an embodiment, the sacrificial layer SL" may fill the opening OP_I of the interlayer insulating layer ILD and the opening OP" of the protective layer PVX. For example, the sacrificial layer SL" may be formed using an organic material.

In an embodiment, an ashing rate of the sacrificial layer SL" relative to a plasma gas used in an ashing process for removing the sacrificial layer SL" may be greater than an ashing rate of the via insulating layer VIA. In other words, the sacrificial layer SL" may be formed using an organic material having a higher ashing rate than that of the via insulating layer VIA.

In an embodiment, an upper surface US" of the sacrificial layer SL" may have a curved shape due to a meniscus phenomenon. For example, the upper surface US" of the sacrificial layer SL" may have a concave curved shape.

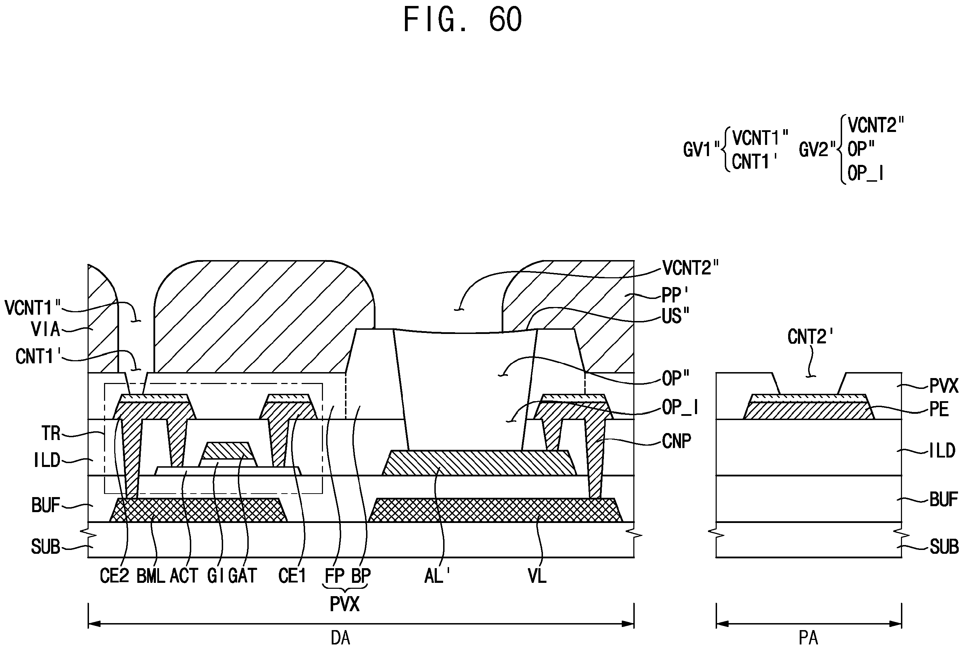

Referring to FIG. 60, the via insulating layer VIA may be formed in the display area DA on the protective layer PVX. The first via contact hole VCNT1" connected to the first contact hole CNT1' and the second via contact hole VCNT2" connected to the opening OP" may be formed in the via insulating layer VIA. The second via contact hole VCNT2" may expose at least a part of the upper surface US" of the sacrificial layer SL".

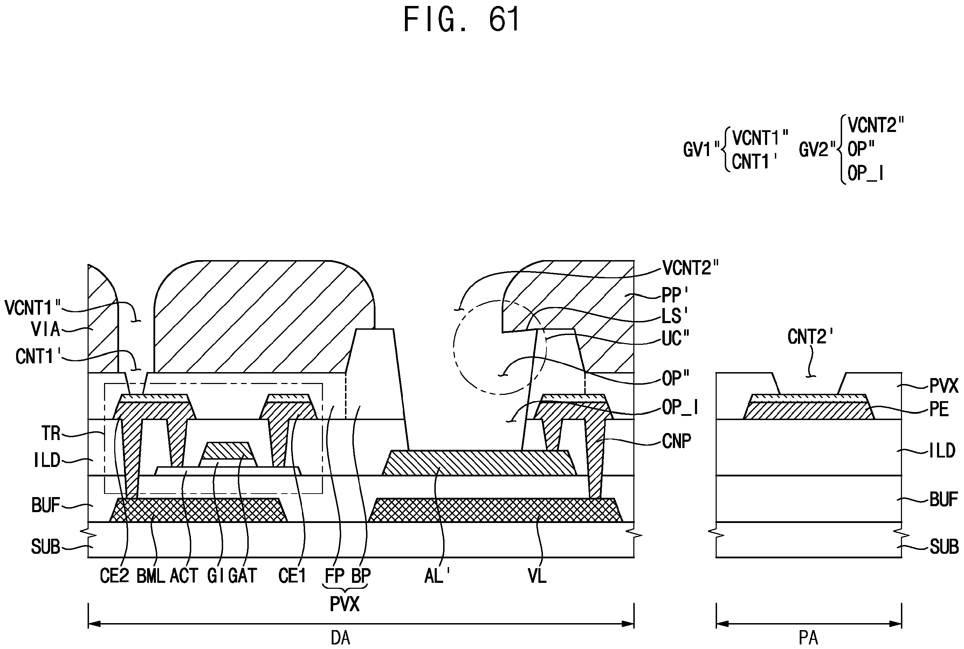

Referring to FIG. 61, the sacrificial layer SL" may be removed. In an embodiment, the sacrificial layer SL" may be removed through the ashing process. In this case, the via insulating layer VIA may not be removed.

The opening OP_I may have the first side surface S1_I and the second side surface S2_I, the opening OP" may have the first side surface S1_P' and the second side surface S2_P', and the second via contact hole VCNT2 " may have the first side surface S1_V' and the second side surface S2_V' (e.g., see FIG. 54). As the sacrificial layer SL" is removed, a part of the via insulating layer VIA may protrude toward the center of the second via contact hole VCNT2". The end part of the via insulating layer VIA may include the protrusion PP' protruding toward the center of the second via contact hole VCNT2". As the via insulating layer VIA includes the protrusion PP', the protrusion PP' of the via insulating layer VIA may form the undercut shape UC" together with the first side surfaces S1_I and S1_P' of the openings OP_I and OP'.

The first via contact hole VCNT1 " may be connected to the first contact hole CNT1 ' to form the first groove GV1", and the second via contact hole VCNT2" may be connected the openings OP_I and OP" to form the second groove GV2".

In an embodiment, as the upper surface US" of the sacrificial layer SL" has a curved shape, the lower surface LS' of the protrusion PP' contacting the upper surface US" of the sacrificial layer SL" may also have a curved shape. For example, the lower surface LS' of the protrusion PP' may have a convex curved shape toward the auxiliary power line AL'.

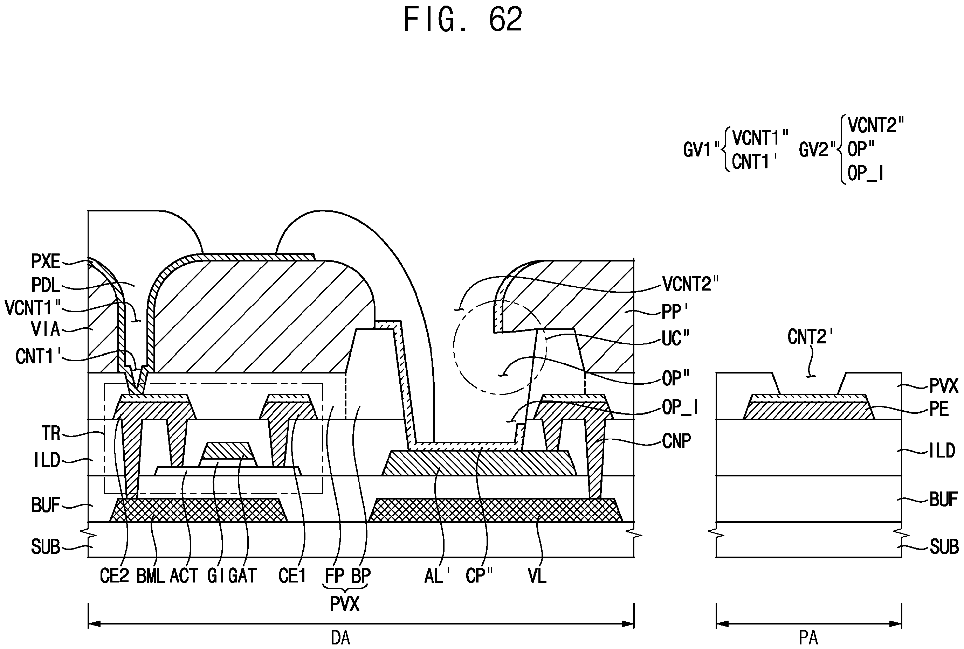

Referring to FIG. 62, the pixel electrode PXE may be formed on the insulating layer VIA. The pixel electrode PXE may be connected to the second electrode CE2 through the first groove GV1".

The cover pattern CP" may be formed on the auxiliary power line AL' and the via insulating layer VIA. The cover pattern CP" may be concurrently (e.g., simultaneously or substantially simultaneously) formed through the same process as that of the pixel electrode PXE. The cover pattern CP" may be disconnected by the undercut shape UC". In addition, the cover pattern CP" may directly contact the upper surface of the auxiliary power line AL.

The pixel defining layer PDL may be formed on the via insulating layer VIA and the cover pattern CP". In more detail, the pixel defining layer PDL may cover at least a part of each of the pixel electrode PXE and the cover pattern CP", and may extend into the second groove GV2".

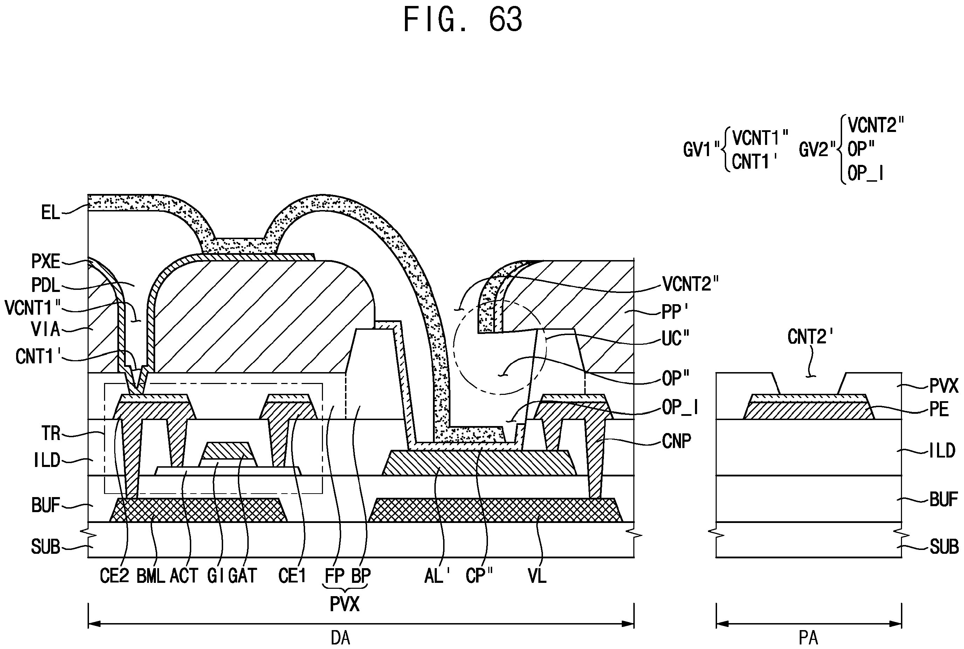

Referring to FIG. 63, the light emitting layer EL may be formed on the pixel defining layer PDL, the via insulating layer VIA, the pixel electrode PXE, the cover pattern CP", and the auxiliary power line AL'. The light emitting layer EL may be disconnected by the undercut shape UC".

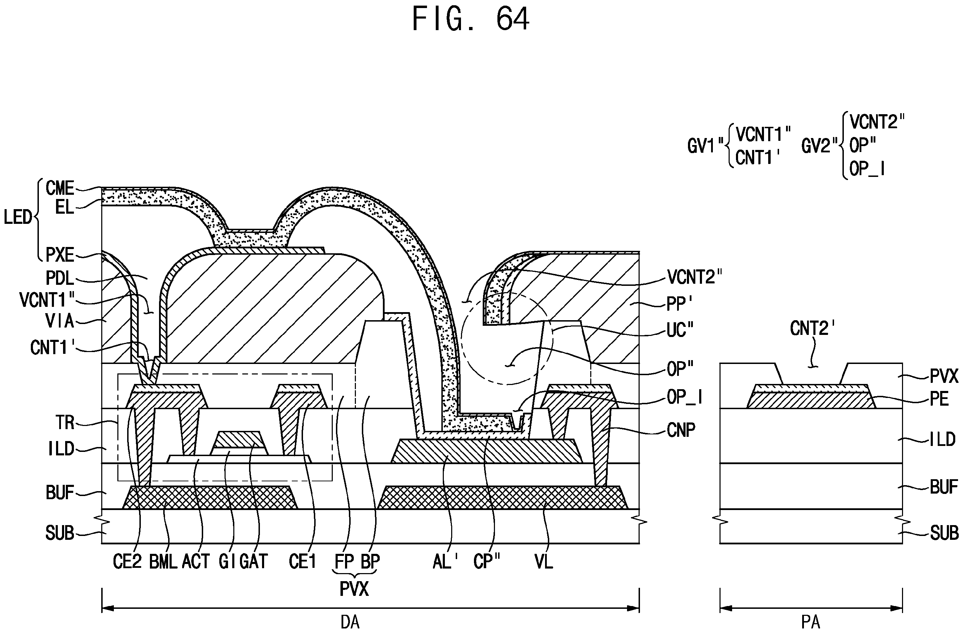

Referring to FIG. 64, the common electrode CME may be formed on the light emitting layer EL. The common electrode CME may be disconnected by the undercut shape UC". For example, the common electrode CME may directly contact a part of the cover pattern CP".

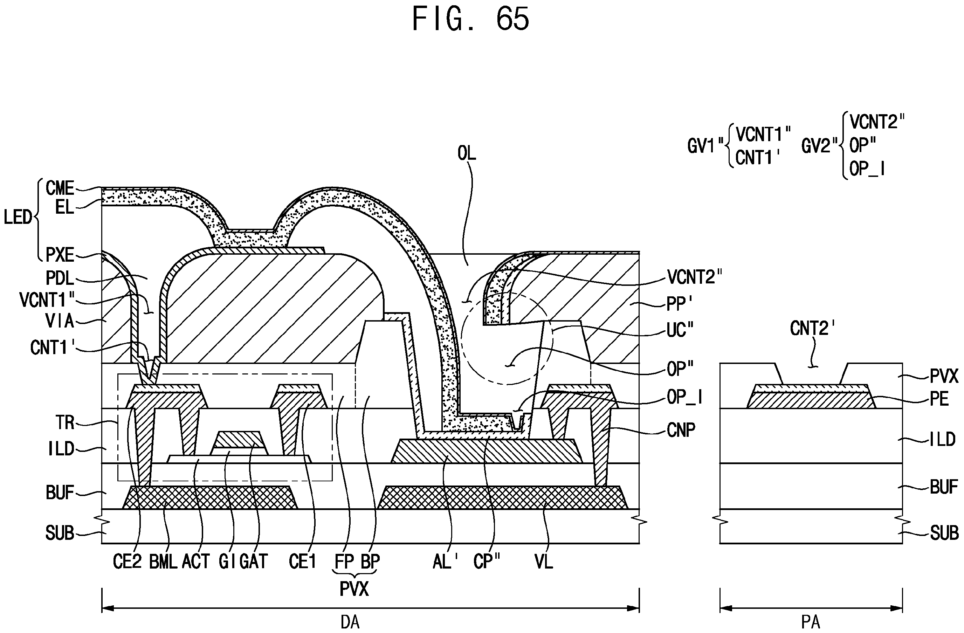

Referring to FIG. 65, the organic layer OL may be filled in the inside of the undercut shape UC". In more detail, the organic layer OL may fill the empty space of the second groove GV2".

Referring back to FIG. 53, the encapsulation layer ENC may be formed in the display area DA on the common electrode CME.

Accordingly, the display device 140 illustrated in FIGS. 53 and 54 may be manufactured.

Referring again to FIGS. 4 to 65, the display devices 100, 110, 120, 130, and 140 according to one or more embodiments of the present disclosure may include the auxiliary power line disposed in a display area on a substrate, an inorganic layer (e.g., the protective layer PVX of FIG. 2 or the first protective layer PVX1 of FIG. 32) disposed on the substrate and defining an opening exposing at least a part of an upper surface of the auxiliary power line, an insulating layer (e.g., the via insulating layer VIA of FIG. 2 or the second protective layer PVX2 of FIG. 32) disposed in the display area on the inorganic layer, defining a contact hole (e.g., the second via contact hole VCNT2 of the FIG. 2 or the third contact hole of FIG. 32) connected to the opening, an end part of the insulating layer including a protrusion protruding toward a center of the contact hole, and a common electrode disposed on the insulating layer and electrically connected to the auxiliary power line. The insulating layer may include an inorganic material or an organic material. The protrusion of the insulating layer may define an undercut shape with one side of the opening. The common electrode may be disconnected by the undercut shape, and electrically connected to the auxiliary power line. Accordingly, a voltage drop of the common voltage provided to the common electrode may be prevented or substantially prevented.

One or more embodiments of the present disclosure may be applied to various suitable display devices. For example, one or more embodiments of the present disclosure may be applicable to various suitable display devices, such as display devices for vehicles, ships, aircrafts, or portable communication devices, display devices for exhibition or information transmission, medical display devices, and the like.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

## Claims

1. A display device comprising:
an auxiliary power line (AL) in a display area on a substrate;
a protective layer (PVX) disposed on the substrate and having an opening exposing at least a part of an upper surface of the auxiliary power line;
a via insulating layer (VIA) in the display area on the protective layer, the via insulating layer having a via contact hole (VCNT2) connected to the opening (OP), and an end part of the via insulating layer (VIA) including a protrusion (PP) protruding toward a center of the via contact hole; and
a common electrode (CME) disposed on the via insulating layer (VIA) and electrically connected to the auxiliary power line (AL).

2. The display device of claim 1, wherein the protrusion (PP) of the via insulating layer (VIA) defines an undercut shape together with a first side surface of the opening (OP) of the protective layer (PVX).

3. The display device of claim 1 or 2, further comprising:
a pixel defining layer disposed on the via insulating layer (VIA),
the pixel defining layer extending into the opening (OP) of the protective layer (PVX) and covering a second side surface of the opening facing the first side surface, and/or wherein the protective layer (PVX) comprises an inorganic material, and
the via insulating layer (VIA) comprises an organic material.

4. The display device of claim 1, wherein the common electrode (CME) is disconnected by the protrusion (PP).

5. The display device of any of the preceding claims, wherein the protective layer (PVX) comprises:
a bank part (BP) covering an edge of the auxiliary power line (AL) and having a second thickness; and
a flat part (BP) located except for the bank part of the protective layer (PVX) and having a first thickness less than the second thickness, and/or
wherein a lower surface of the protrusion (PP) that does not contact the protective layer (PVX) has a curved shape.

6. The display device of any of the preceding claims, further comprising:
a light emitting layer on the via insulating layer (VIA) and the auxiliary power line (AL),
wherein the light emitting layer is disconnected by the protrusion (PP), and/or wherein the common electrode (CME) covers a side surface of the light emitting layer.

7. The display device of any of the preceding claims, wherein the common electrode (CME) directly contacts a part of the upper surface of the auxiliary power line (AL), and/or further comprising:
an organic layer (OL) filling an empty space between the auxiliary power line (AL) and the protrusion (PP).

8. The display device of any of the preceding claims, further comprising:
a lower metal layer (BML) in the display area on the substrate;
an active pattern (ACT) on the lower metal layer;
a gate electrode (GAT) on the active pattern;
a first electrode (CE1) connected to the active pattern;
a second electrode (CE2) in the same layer as that of the first electrode, and connected to the active pattern and the lower metal layer; and
a pixel electrode (PXE) connected to the second electrode.

9. The display device of claim 8, wherein the auxiliary power line (AL) comprises the same material as that of the first electrode (CE1) and the second electrode (CE2), or
wherein the auxiliary power line (AL) comprises the same material as that of the gate electrode (GAT).

10. The display device of claim 8 or 9, further comprising:
an interlayer insulating layer (ILD) between the substrate and the protective layer, the interlayer insulating layer (ILD) covering an edge of the auxiliary power line (AL) and having an opening exposing at least a part of the upper surface of the auxiliary power line.

11. The display device of any of claims 8 to 10, wherein the opening of the interlayer insulating layer (ILD) and the opening of the protective layer (PVX) are connected to each other, and
wherein the protrusion (PP) of the via insulating layer (VIA) defines an undercut shape together with a first side surface of the opening of the interlayer insulating layer (VIA) and a first side surface of the opening (OP) of the protective layer (PVX), and/or
wherein the protrusion (PP) of the via insulating layer (VIA) defines an undercut shape together with a first side surface of the opening of the interlayer insulating layer and a first side surface of the opening of the protective layer (PVX).

12. The display device of any of claims 8 to 11, further comprising:
a cover pattern (CP) on the auxiliary power line (AL), the cover pattern being disconnected by the protrusion (PP) of the protective layer, and comprising the same material as that of the pixel electrode, and/or wherein the common electrode (CME) is configured to be electrically connected to the auxiliary power line through the cover pattern (CP).

13. A display device comprising:
an auxiliary power line (AL) in a display area on a substrate;
a first protective layer (PVX1) disposed on the substrate, and having an opening (OP') exposing at least a part of an upper surface of the auxiliary power line;
a second protective layer (PVX2) on the first protective layer, the second protective layer (PVX2) having a contact hole (CNT3) connected to the opening (OP'), and an end part of the second protective layer (PVX2) including a protrusion (PP_P) protruding toward a center of the contact hole;
a via insulating layer (VIA) in the display area on the second protective layer (PVX2); and
a common electrode (CME) disposed on the via insulating layer (VIA), and electrically connected to the auxiliary power line (AL).

14. The display device of claim 13, wherein the protrusion (PP_P) of the second protective layer (PVX2) defines an undercut shape together with a first side surface of the opening (OP') of the first protective layer (PVX1), and/or wherein the first and second protective layers (PVX1, PVX2) comprise an inorganic material, and the via insulating layer (VIA) comprises an organic material.

15. The display device of claim 13 or 14, further comprising:
a pixel defining layer (PDL) disposed on the via insulating layer (VIA), the pixel defining layer (PDL) extending into the opening (OP') of the first protective layer (PVX1), and covering a second side surface of the opening (OP') facing the first side surface, and/or
wherein the second side surface of the opening (OP') has a step.

16. The display device of any of claims 13 to 15, wherein the common electrode (CME) is disconnected by the protrusion (PP_P), and directly contacts a part of the upper surface of the auxiliary power line (AL).

17. The display device of any of claims 13 to 16, further comprising:
an organic layer (OL) filling an empty space between the auxiliary power line (AL) and the protrusion (PP_P) of the second protective layer (PVX2), and/or wherein a lower surface of the protrusion (PP_P) that does not contact the first protective layer (PVX1) has a curved shape.

18. The display device of any of claims 13 to 17, further comprising:
a transistor (TR) in the display area on the substrate;
a pixel electrode (PXE) electrically connected to the transistor; and
a cover pattern (CP') on the auxiliary power line (AL), the cover pattern (CP') being disconnected by the protrusion (PP_P) of the second protective layer (PVX2), and comprising the same material as that of the pixel electrode (PXE), and/or wherein the common electrode (CME) is configured to be electrically connected to the auxiliary power line (AL) through the cover pattern (CP').

19. A method for manufacturing a display device, the method comprising:
forming an auxiliary power line (AL) in a display area on a substrate;
forming a protective layer having an opening exposing at least a part of an upper surface of the auxiliary power line on the substrate;
forming a sacrificial layer filing the opening;
forming a via insulating layer (VIA) having a via contact hole exposing at least a part of an upper surface of the sacrificial layer in the display area on the protective layer and the sacrificial layer, the via contact hole of the via insulating layer being connected to the opening;
removing the sacrificial layer to form a protrusion (PP) from a part of the via insulating layer (VIA) that protrudes toward a center of the via contact hole; and
forming a common electrode (CME) electrically connected to the auxiliary power line (AL) on the via insulating layer.

20. The method of claim 19, wherein the forming of the protective layer comprises:
forming a preliminary protective layer on the substrate;
forming a photosensitive organic layer on the preliminary protective layer by exposing and developing a photoresist through a halftone mask; and
forming the opening of the protective layer by removing a part of the preliminary protective layer that does not overlap with the photosensitive organic layer through a dry etching process.

21. The method of claim 19 or 20, wherein the protective layer is formed using an inorganic material, and the via insulating layer is formed using an organic material, and/or wherein the sacrificial layer is formed using an organic material.

22. The method of any of claims 19 to 21, wherein, in the removing of the sacrificial layer, the sacrificial layer is removed through an ashing process, and
wherein an ashing rate of the sacrificial layer relative to a plasma gas used in the ashing process is greater than an ashing rate of the via insulating layer (VIA), and/or wherein the upper surface of the sacrificial layer has a curved shape.

23. The method of any of claims 19 to 22, further comprising:
forming a light emitting layer on the auxiliary power line (AL) to be disconnected by the protrusion (PP) before the forming of the common electrode (CME),
wherein a first angle at which the light emitting layer is deposited is greater than a second angle at which the common electrode is deposited, and/or further comprising:
forming a transistor in the display area on the substrate before the forming of the protective layer;
forming a pixel electrode electrically connected to the transistor after the forming of the via insulating layer (VIA); and
forming a cover pattern on the auxiliary power line (AL) to be disconnected by the protrusion (PP),
wherein the cover pattern is formed through the same process as that of the pixel electrode.
